# EUROPEAN PATENT APPLICATION

(11) **EP 4 790 760 A1**
(43) Date of publication of application: **12.08.2026**
(21) Application number: 26156929.7
(22) Date of filing: 06.02.2026
(51) Int. Cl.: H01M 4/136, H01M 4/36, H01M 4/58, G01R 31/367, G01R 31/374, G01R 31/3842, G01R 31/392

(54) **SOC/SOH ESTIMATION OF LMFP CELL**

(30) Priority: 07.02.2025 US 202563755871 P; 07.02.2025 US 202563755883 P; 30.07.2025 US 202563854273 P
(71) Applicant: Cummins, Inc., Columbus, Indiana 47201 (US)
(72) Inventor: Chen, Jie, Carmel, 46074 (US); Miranda, Delton, Bushey, WD23 2FH (GB); Li, Jie, Columbus, 47201 (US); Patel, Arunkumar, London, HA8 6BU (GB); Forgie, John, Milton Keynes, MK13 8PE (GB); Song, Yuying, Greenwood, 46143 (US); Zhang, Ruigang, Bargersville, 46106 (US); Holcomb, Brian Alan, Whiteland, 46184 (US); Manchanda, Nitisha, 452016 Indore (IN)
(74) Representative: Cleveland Scott York

(57) **Abstract**

Systems and methods are disclosed for estimating state parameters of lithium manganese iron phosphate (LMFP) battery cells with improved accuracy and robustness. Per-cell estimation of state of charge (SOC) and state of health (SOH) is performed using electrical measurements including voltage, current, and temperature. In example implementations, shifts in characteristic voltage transition regions associated with manganese- and iron-based redox reactions are monitored to infer degradation during normal operation. Mechanical swelling force of the battery cell is measured using one or more pressure sensors, providing a physical indicator correlated with SOC and long-term lithium inventory loss, particularly in voltage-flat operating regions. Direct current internal resistance values obtained from controlled current pulses may further enhance estimation accuracy. These complementary estimation techniques may be implemented individually or in combination within a battery management system to improve diagnostics, adaptive control, and lifecycle management of LMFP battery cells in electrified vehicle and energy storage applications.

## Description

### CROSS REFERENCE TO RELATED APPLICATIONS

This application claims priority under 35 U.S.C. § 119(e) and the Paris Convention to U.S. Provisional Patent Application No. 63/755,871, filed on February 7, 2025, titled "Lithium Manganese Iron Phosphate (LMFP) Battery System for Heavy Duty Applications", to U.S. Provisional Patent Application No. 63/755,883, filed on February 7, 2025, titled "Lithium Manganese Iron Phosphate (LMFP) Battery System for Heavy Duty Applications", and to U.S. Provisional Patent Application No. 63/854,273, filed June 30, 2025, titled "SOC/SOH Estimation of LMFP".

### TECHNICAL FIELD

The present disclosure relates generally to Lithium Manganese Iron Phosphate (LMFP) cells, and more particularly to state of health, state of charge, state of power, and/or state of energy estimations of LMFP cells.

### BACKGROUND

The adoption of EVs has significantly increased, driven by the need for sustainable transportation. Lithium-ion batteries (LIBs) dominate the EV market due to their high energy density and efficiency. However, existing LIB chemistries, such as Lithium Nickel Manganese Cobalt Oxide (NMC) and Lithium Iron Phosphate (LFP), face challenges in balancing cost, thermal stability, energy density, and sustainability.

LMFP batteries offer a promising solution by combining the inherent thermal stability of LFP with the enhanced energy density imparted by manganese doping. Information about certain battery models and their resistance - collectively referred to as battery state parameters - is relevant to users. These parameters include the state of charge (SOC), state of health (SOH), state of power (SOP), and state of energy (SOE). Despite these advantages, integration into EV systems has been limited by challenges in estimating battery state parameters (SOX) to a high degree of accuracy and robustness.

### SUMMARY

A first aspect of this disclosure provides a novel SOX estimation system for each cell in LMFP battery management systems (BMS). The estimation algorithm uses the cell's voltage, current, and temperature to output a single cell SOC using coulomb counting or an adaptive bar delta Kalman filter. The algorithm provides an estimate for SOH based on the SOC estimation, and the SOC and SOH closed loop estimation can be performed either in joint or co-estimation. The system further includes recalibration systems to correct the SOC and/or SOH value(s). This aspect provides an estimation for every single cell, increasing the accuracy and robustness of the design.

A X1 aspect of this disclosure provides an advanced SOC/SOH estimation method called adaptive bar delta Kalman filter method. The adaptive bar delta Kalman filter first calculate the avgeage condition, i.e. SOC and states, of all cells in the pack and then estimates individual cell SOC based on the differences based on cell voltages. The method has a variable measurement and process noise covariance depending on the chemistry OCV curve, battery model error and it can be a function of SOC, voltage, Crate, SOH, and temperature. The adaptive covariance with the bar delta Kalman filter increases the accuracy and robustness and reduces the computational cost of the system.

A X2 aspect of this disclosure provides an optimized SOC recalibration methodology as enhanced top of charge (TOC) recalibration method. This method is depends on charging end condition such as voltage, temperature, and Crate to recalibration SOC. This methodology provides a comprehensive method to reset SOC value at any value to be near 100%, i.e. 95 to 100%, to increase the reliability and robustness.

A X3 aspect of this disclosure provides a novel SOC/SOH recalibration method called recursive Throughput-OCV recalibration. The method uses a recursive method to estimate SOC and SOH value depends on the relationship of OCV, throughput in coulomb counting, and capacity changes with SOH. This method established a comprehensive solution to capture the coupled SOC-SOH relationship with OCV shifting to increase the BMS accuracy and robustness.

A second aspect of this disclosure provides a rapid SOH estimation system of LMFP cells via monitoring voltage shifts. The method provides an estimation for SOH by fixing a voltage amount and measuring the SOC%. Using a reverse linear relationship between SOC% and SOH at a given voltage, SOH can be estimated. This method of estimating SOH results in higher accuracy and reliability in battery modeling, especially in SOH diagnostics, where current diagnostic methods are compromised significantly as the LMFP cells age.

A third aspect of this disclosure provides a SOC and/or SOH estimation system of LMFP cells via measurement of a battery swelling force. The system includes one or more pressure sensor sheet(s) positioned on or between a single cell to measure real-time swelling force of the battery. The battery swelling force provides a method to monitor SOC of the LMFP. Additionally, the changes in swelling force over time provide a method to estimate cell SOH. This estimation method avoids the conventional reliance on voltage monitoring, which has been proven difficult due to the regions of relatively constant open circuit voltage, such as across the Mn redox phase.

A fourth aspect of this disclosure provides a SOC estimation system of LMFP cells by measuring direct current internal resistance (DCIR). The method provides an estimation for SOC by varying pulse intensities or durations to yield different internal DCIR measurements. This method addresses challenges in prior methods using OCV for SOH estimations, especially in the high SOC range where the OCV curve in the manganese region of the LMFP plateaus.

### BRIEF DESCRIPTION OF THE DRAWINGS

The drawings described below illustrate various exemplary system architectures, process flows, measurement configurations, and data representations supporting the first (X1, X2), second, and third aspects of the present disclosure. These figures are provided for clarity and instructional purposes and are not intended to limit the scope of the claimed invention.
Figure 1 illustrates a high-level system architecture for estimating SOX parameters on a per-cell basis within an Li ion-based battery pack.
Figures 2A-B are block diagrams depicting the closed-loop estimation process for determining SOC and SOH for each individual cell.
Figure 3 presents a flowchart for implementing adaptive bar-delta Kalman filtering to estimate SOC for each Li ion battery cell.
Figure 4 presents a flowchart illustrating an enhanced top-of-charge (TOC) recalibration method using a lookup table based on voltage, current, temperature, and SOH.
Figure 5 presents a flowchart describing a recursive Throughput-OCV recalibration method that accounts for specific changes in the OCV curve over time.
Figure 6 is a schematic diagram of an integrated data-driven recalibration framework combining Python, Simulink, and embedded code for real-time SOC and SOH estimation.
Figure 7A is a block diagram illustrating an example battery management system architecture for an LMFP battery, including sensing interfaces configured to receive electrical, thermal, and mechanical signals from one or more battery cells.
Figure 7B is a block diagram illustrating an example processing and estimation architecture of the battery management system of FIG. 7A, configured to derive battery state parameters including state of charge and state of health based on the received signals.
Figure 8 presents a flowchart outlining the process for estimating and updating SOH in real time using voltage transition shift measurements.
Figures 9A and 9B illustrate the voltage shift for a SOC-OCV curve estimation method.
Figure 10 is a diagram illustrating the shortcomings of using voltage monitoring to estimate SOC in LMFP cells.

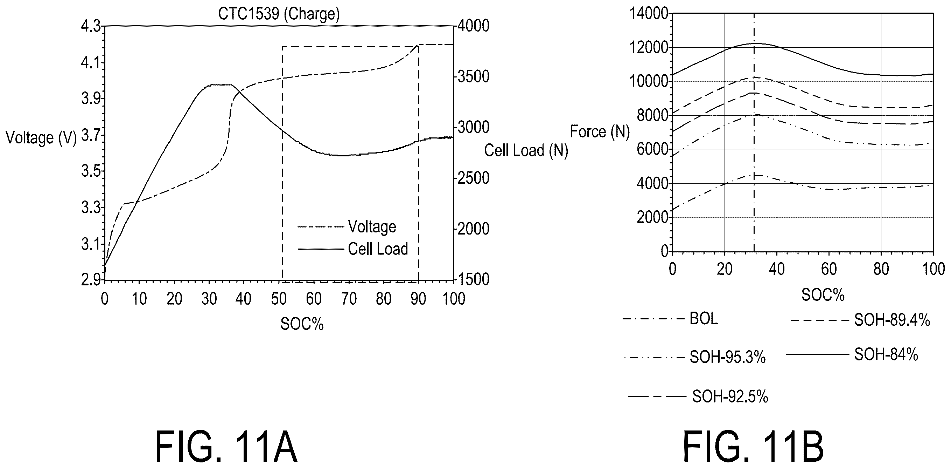

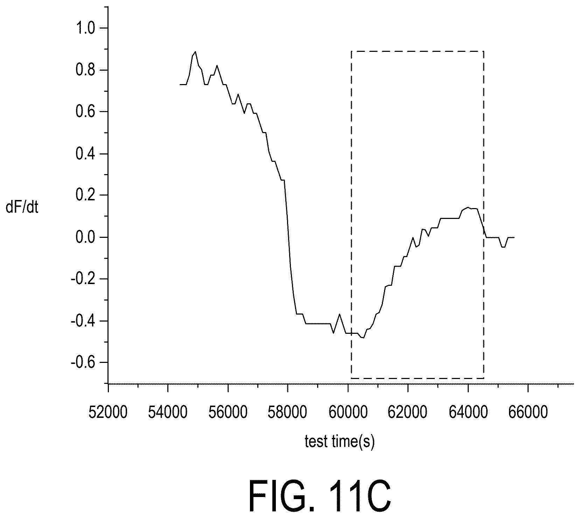

Figures 11A-C are three charts that show the absolute swelling force during a full charge/discharge cycle, the force trend during charging, and the derivative of force over time. Figure 11A (left) presents swelling force (cell load) and voltage as functions of SOC during the charge phase of a separate LMFP cycle. Figure 11B (middle) presents swelling force (cell load) as a function of SOC with overlaying curves to define the relationship during different stages of the battery's life. Figure 11C plots the first derivative of swelling force with respect to time (dF/dt) across the charge-discharge cycle, with test time on the x-axis and dF/dt (in Newtons per second) on the y-axis.
Figure 12A is a diagram with a chart showing how swelling force changes with aging and how this trend can support SOH estimation.
Figure 12B is an illustration of the battery cells/pack with pressure sensor sheets.
Figures 13A-C are three charts that illustrate how swelling force features-such as peak force, baseline force, and rate of change-can be tracked over time to estimate SOH. Figure 13A(left) shows the full-cycle swelling force profile of a fresh LMFP cell, plotted against state of charge (SOC). Figure 13B (middle) presents the same swelling force profile recorded after the cell has undergone substantial aging, such as 1000 charge-discharge cycles. Figure 13C(right) synthesizes these observations by plotting extracted swelling force features
Figure 14 presents a flowchart outlining the process for estimating SOH using swelling force measurements and their deviation from baseline trends.
Figures 15A-C are three charts showing how DCIR varies with pulse intensity and duration, supporting SOC estimation in LMFP cells.
Figure 16A is a graph of changes in pulse intensity of the DCIR over time used to estimate the SOC by analyzing DCIR changes over time.
Figure 16B is a a flowchart describing the process of estimating SOC by analyzing DCIR changes over time during controlled pulse durations.
Figure 17A is a diagram illustrating the DCIR change with different pulse duration.
Figure 17B is a diagram illustrating a method for estimating the SOC in LMFP battery cells by monitoring the shift in the voltage transition region during charging.
Figure 18A-D is a diagram showing discharge curves of lithium manganese iron phosphate (LMFP) cells having different manganese-to-iron (Mn:Fe) ratios, illustrating distinct voltage plateaus associated with manganese-dominant and iron-dominant phases during discharge.
Figure 19A is a diagram illustrating material-level and electrode-level mixing configurations for lithium manganese iron phosphate (LMFP) cathode materials.
Figure 19B is a diagram illustrating a cell-level configuration in which LMFP battery cells having different manganese-to-iron ratios are assembled into a battery pack.
Figure 20A is a diagram illustrating a first portion of a process for forming a blended LMFP cathode material.
Figure 20B is a diagram illustrating a second portion of the process for forming a battery cell using the blended LMFP cathode material.
Figure 20C is a diagram illustrating integration of the battery cell formed using the blended LMFP cathode material into a battery pack.
Figures 21A-C are graphs showing several discharge curves for an aged LMFP battery. Figures 21A-B illustrate a first portion of a lithium-ion recovery process for an aged LMFP battery cell. Figure 21C iillustrates a second portion of the lithium-ion recovery process for the aged LMFP battery cell.
Figure 22 is a flowchart illustrating an example control logic for initiating and executing a lithium inventory recovery operation for an LMFP battery cell.
Figure 23A is a flow chart of a Li-ion recovery process for aged batteries according to principles of the present disclosure.
Figure 23B is a graph of the results of the recovery process of Figure 23A.
Figure 24A is a diagram illustrating an example arrangement of pressure sensors relative to an LMFP battery cell for detecting cell swelling during operation.
Figure 24B is a diagram illustrating an example signal output generated by the pressure sensors of Figure 24A as a function of battery operating conditions.
Figure 25 is a flowchart of a method for effective battery recovery.
Figure 26 is a schematic diagram of an electrified vehicle.

### DETAILED DESCRIPTION

As introduction, this disclosure provides a consolidated description of multiple complementary systems and methods for estimating battery state parameters in lithium manganese iron phosphate (LMFP) battery cells and battery packs. In particular, four distinct but related aspects are described: (i) a system and methodology for accurately estimating one or more state parameters, such as state of charge (SOC) and state of health (SOH), for each single cell based on voltage, current, and temperature data; (X1) adaptive bar-delta Kalman filter SOX estimation method;(X2) enhanced SOC recalibration method based on top of charge; (X3) recursive throughput-OCV recalibration for SOX estimation; (ii) a rapid SOH estimation approach that monitors voltage shifts within transition regions of LMFP cells to reliably infer SOH using a predetermined relationship with SOC; (iii) an estimation technique that utilizes real-time measurement of cell swelling force via pressure sensors to determine SOC and/or SOH, which is especially effective in regions of constant open circuit voltage; and (iv) a diagnostic method that estimates SOC by applying multiple current pulses with varying magnitudes and durations and calculating the direct current internal resistance (DCIR) response, particularly enhancing SOC accuracy in flat-voltage regions such as the manganese plateau.

These aspects address different technical challenges encountered in LMFP battery management and may be practiced independently or in any combination. One skilled in the art will appreciate that integrating two or more of these aspects can enhance the overall accuracy, robustness, and diagnostic capability of battery management systems without departing from the scope of this disclosure.

Following this overview, it is helpful to explain the context of key battery state parameters that underpin these aspects of the disclosure.

SOC is a fundamental parameter representing the remaining capacity of a battery relative to its total usable capacity. It is typically expressed as a percentage and provides an estimate of how much charge is available to deliver energy to the load before the battery needs to be recharged. Accurate SOC estimation is crucial for optimizing energy usage, avoiding overcharge or deep discharge, and ensuring safe and efficient operation of electric vehicles and other battery-powered systems. Conventional SOC estimation methods commonly rely on coulomb counting, which integrates current over time, and/or on correlating measured cell voltages with known open circuit voltage (OCV) curves. However, for chemistries such as LMFP with a flat OCV plateau, these conventional methods can lose precision in certain SOC ranges, motivating the need for additional or alternative physical indicators.

State of Energy (SOE) is a related but distinct parameter that quantifies the total usable energy remaining in the battery, typically expressed as a percentage of the maximum energy capacity. Unlike SOC, which is based on charge (ampere-hours), SOE accounts for both the available charge and the voltage at which that charge can be delivered, thus reflecting the actual deliverable energy. Accurate SOE estimation is important for applications that rely on precise predictions of remaining driving range, backup power duration, or system runtime. SOE typically depends on SOC, cell voltage, and dynamic load conditions, and may also be influenced by temperature and degradation effects.

SOH describes the overall condition and remaining useful life of a battery cell or pack relative to its original, as-new performance. SOH typically considers factors such as capacity fade, internal resistance increase, and physical degradation that develop over repeated charge-discharge cycles. Accurate SOH estimation enables predictive maintenance, warranty tracking, and informed decisions on battery replacement. It is inherently more complex than SOC estimation because it requires models or physical indicators that correlate operational data with aging effects that evolve slowly and may depend on varied usage and environmental conditions.

State of Power (SOP) indicates the maximum power that a battery can safely deliver or absorb at any given time, subject to constraints on voltage, current, and temperature. SOP estimation is essential for managing peak power demands, such as rapid acceleration in electric vehicles or grid stabilization during high transient loads. SOP dynamically depends on SOC and SOH, as power capability generally decreases when the battery is deeply discharged, highly charged, aged, or operating under unfavorable thermal conditions.

Modern battery management systems (BMS) rely on accurate estimation of SOC, SOE, SOH, SOP, and related parameters to optimize performance, maximize usable capacity, protect against unsafe conditions, and prolong battery life. The complementary systems and methods described in this disclosure address the specific technical challenges of LMFP battery chemistry by augmenting conventional electrical estimation with novel physical indicators - such as transition region voltage shifts and swelling force measurements - to deliver more reliable, robust, and cross-validated state estimates under diverse operating conditions.

The systems and methods described in this disclosure address the unique technical challenges of LMFP batteries by supplementing conventional estimation techniques with novel physical signals such as voltage transition shifts and swelling force measurements, thereby improving estimation accuracy and resilience under diverse operating conditions.

### Lithium-Based Batteries and LMFP Chemistry

Lithium-based rechargeable batteries are the leading energy storage technology for a wide range of applications, including portable electronics, electric vehicles, stationary energy storage, and grid integration. Their success stems from a combination of high energy density, good cycle life, and ongoing cost reductions driven by material and manufacturing improvements. Common lithium-ion chemistries include lithium cobalt oxide (LCO), lithium nickel manganese cobalt oxide (NMC), lithium iron phosphate (LFP), and more recent high-nickel or silicon-enhanced variants. Each chemistry balances factors such as energy density, cost, thermal stability, and service life. Among these, LFP has become increasingly popular due to its excellent safety profile, robust thermal performance, long cycle life, and cost competitiveness, though its energy density is somewhat lower than nickel-rich chemistries.

Lithium manganese iron phosphate (LMFP) builds upon the proven LFP framework by partially substituting manganese into the iron phosphate structure. This modification raises the operating voltage, thereby improving energy density while retaining the inherent safety and longevity benefits of LFP. As a result, LMFP is an attractive next-generation cathode material for large-scale electric vehicles and stationary storage applications where higher energy density is needed without compromising safety.

However, practical deployment of LMFP chemistry in real-world battery systems poses several notable challenges. First, (i) LMFP cells exhibit a relatively flat OCV region near the manganese redox plateau, which limits the effectiveness of conventional OCV-based methodsfor determining SOC and can lead to estimation inaccuracies in critical operating ranges. Second, (ii) LMFP cells have a complex degradation profile characterized by a two-phase voltage behavior and a gradual shift in the charge-discharge curve as the cell ages, making accurate estimation of the SOH more difficult and demanding more advanced models or physical monitoring. Third, (iii) because LMFP is a newer chemistry compared to well-established systems like NMC and LFP, there is a relative lack of historical operational data, which constrains the development and training of data-driven diagnostic algorithms. Fourth, (iv) BMD designed for other chemistries often needs significant adaptation to address LMFP's unique voltage behavior and aging characteristics while still ensuring safe, efficient, and reliable operation.

Overcoming these challenges requires the development of enhanced estimation techniques and innovative physical sensing methods to supplement traditional electrical measurements. The systems and methods disclosed herein address these issues directly by introducing complementary solutions such as monitoring voltage transition shifts and capturing real-time swelling force signals, thereby improving the accuracy, robustness, and overall diagnostic performance of LMFP battery management under practical operating conditions.

The entirety of the following co-pending and commonly assigned United States provisional patent applications may be used to further illustrate and support the technical context and exemplary implementations of LMFP systems and methods described herein, as if fully set forth herein: U.S. Provisional Patent Application No. 63/755,871, filed on February 7, 2025, titled "Lithium Manganese Iron Phosphate (LMFP) Battery System for Heavy Duty Applications" (Attorney Docket No. CI-24-1118-01-US), and U.S. Provisional Patent Application No. 63/755,883, filed on February 7, 2025, also titled "Lithium Manganese Iron Phosphate (LMFP) Battery System for Heavy Duty Applications" (Attorney Docket No. CI-24-1119-01-US). These disclosures provide additional technical background, supporting data, detailed material compositions, cell and pack architectures, thermal management schemes, and related control strategies that complement the battery state estimation techniques described in this application. The referenced materials above may be combined with the features disclosed herein to define further embodiments within the scope of the claimed invention.

### FIRST ASPECT OF THE DISCLOSURE

The present disclosure describes a system architecture and associated methodology for estimating battery state parameters for each individual cell within an LMFP battery pack. The disclosed approach enables real-time, high-accuracy estimation of multiple states of interest, collectively referred to as SOX, including but not limited to SOC and SOH.

Accurate SOX estimation for LMFP cells is technically challenging due to the unique electrochemical behavior of LMFP chemistry. Specifically, the OCV profile exhibits relatively flat regions interspersed with a transition region characterized by a rapid voltage drop. This makes traditional model-based or OCV-based estimation methods unreliable under certain operating conditions. Furthermore, conventional battery management system (BMS) algorithms often provide only aggregate SOX estimates at the module or pack level, resulting in limited control granularity and reduced accuracy for balancing and diagnostics.

To overcome these limitations, the disclosed system (X1) implements one dedicated estimation algorithm covered each single cell. This algorithm module processes cell-specific measurements including cell voltage, current, and temperature. These input signals are acquired via standard cell monitoring circuits integrated within the BMS.

The estimation of SOC for each cell is performed using a hybrid approach that can be configured to employ coulomb counting, an adaptive bar-delta Kalman filter, or other suitable model-based or data-driven methods.

In certain embodiments, the adaptive bar-delta Kalman filter features a self-adjusting process and measurement noise covariance. These covariance parameters can be adaptively tuned as a function of the cell's SOC, voltage, and temperature to compensate for nonlinearities and modeling uncertainties. This enables robust SOC estimation in all SOC ranges and reduced the computational cost significantly.

The estimated SOC serves as an input for the estimation of SOH for each cell and vice versa. The SOC and SOH estimation can be executed in either a joint-estimation framework, where both states are estimated simultaneously within a common estimation matrix and synchronized time step, or a co-estimation framework, where SOC and SOH are estimated using separate matrices and, optionally, asynchronous time steps. The selection between joint or co-estimation modes may be based on computational resource constraints, desired estimation accuracy, and the specific deployment context.

To further enhance estimation accuracy over time, the system integrates multiple recalibration mechanisms. These methods provide corrected state-of-charge (SOC) and/or state-of-health (SOH) values that feed back into the main estimation algorithm, helping to minimize drift caused by sensor errors, model deviations, or cell aging effects. Examples of effective recalibration techniques include OCV-SOC recalibration, which uses stabilized rest voltage measurements to realign SOC estimates, and Top of Charge (TOC) recalibration, which resets SOC when a cell reaches predefined charge termination conditions such as specific voltage, current, or temperature thresholds. Conventional TOC method have to reset to 100% based on the predefined conditions. our enhanced TOC can reset the SOC in the range between 95 to 100% SOC based on voltage, current, and temperature. Additional methods like Incremental Capacity Analysis (ICA) and Differential Voltage Analysis (DVA) compare changes in capacity and voltage gradients to refine SOC or SOH estimates. Throughput-OCV recalibration employs recursive throughput tracking to estimate SOH directly from observed capacity fade relative to expected OCV behavior. Conventional Throughput-OCV recalibration could not capture the OCV shift due to SOH change, and then cannot be used to estimate both SOC or SOH. Electrochemical Impedance Spectroscopy (EIS) recalibration involves periodic impedance measurements to update resistance models that affect SOX estimates. Finally, data-driven recalibration uses machine learning or deep learning models trained offline and deployed on the battery management system (BMS) control unit to improve state estimates based on historical and real-time operating data.

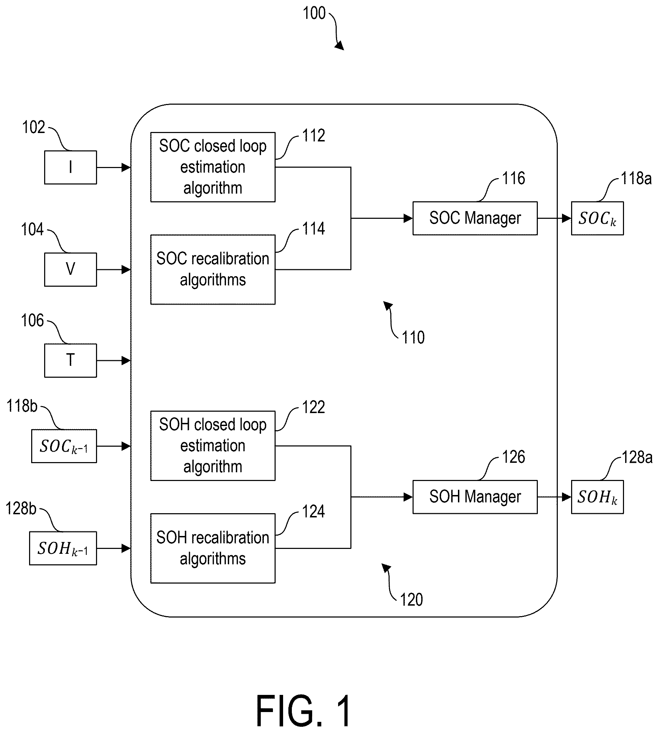

Figure 1 is a schematic diagram illustrating a co-estimation framework for independently determining the state of charge (SOC) and state of health (SOH) for each single cell of a lithium manganese iron phosphate (LMFP) battery cell system 100. In this context, *co-estimation* refers to the estimation of SOC and SOH using distinct computational matrices that may operate on separate time steps and estimation schedules. This is in contrast to *joint-estimation,* where both states are calculated simultaneously within a unified matrix and synchronized time frame.

As shown in the schematic, real-time measurements of current (I) 102, voltage (V) 104, and temperature (T) 106 are provided as input signals to two main estimation paths: one for SOC 110 and one for SOH 120. These physical measurements support the closed-loop estimation of each state as well as periodic recalibration.

For the SOC estimation path 110, the SOC closed-loop estimation algorithm 112 processes the input signals 102, 104, 106, along with the prior time step's SOC estimate (SOCₖ₋₁) 118b and prior SOH estimate (SOHₖ₋₁) 128b, to compute a new SOC value. This preliminary estimate is then passed to a SOC Manager 116, which applies corrections provided by a set of SOC recalibration algorithms. These recalibration methods may include techniques such as coulomb counting resets at top-of-charge, voltage-based corrections, or swelling force-derived adjustments. The final output from the SOC Manager 116 is the updated SOC estimate (SOCₖ) 118a.

Simultaneously, the SOH estimation path 120 uses the prior SOH estimate (SOHₖ₋₁) 128b in combination with the same measurement inputs (I, V, T) 102, 104, 106 to generate an updated SOH value 128b. The SOH closed-loop estimation algorithm 122 processes these inputs to detect aging-related features, such as shifts in voltage transition behavior, force profile changes, or capacity degradation. This estimate is refined through a SOH Manager 126, which integrates inputs from SOH recalibration algorithms 124. These may include aging-based models, swelling-force deviation tracking, or transition voltage mapping calibrated to known degradation trends. The result is a revised SOH estimate (SOHₖ) 128a representing the updated health of the cell.

This co-estimation framework offers key advantages for LMFP chemistries, where SOC estimation may require fast response to dynamic loads, while SOH evolves more gradually over extended usage. By separating the estimation logic and allowing each path to operate independently, the system provides enhanced flexibility, adaptability to diverse use conditions, and improved long-term estimation robustness. Figure 1 thus establishes a modular estimation architecture designed to support high-fidelity, real-time monitoring of LMFP cell performance across its lifecycle.

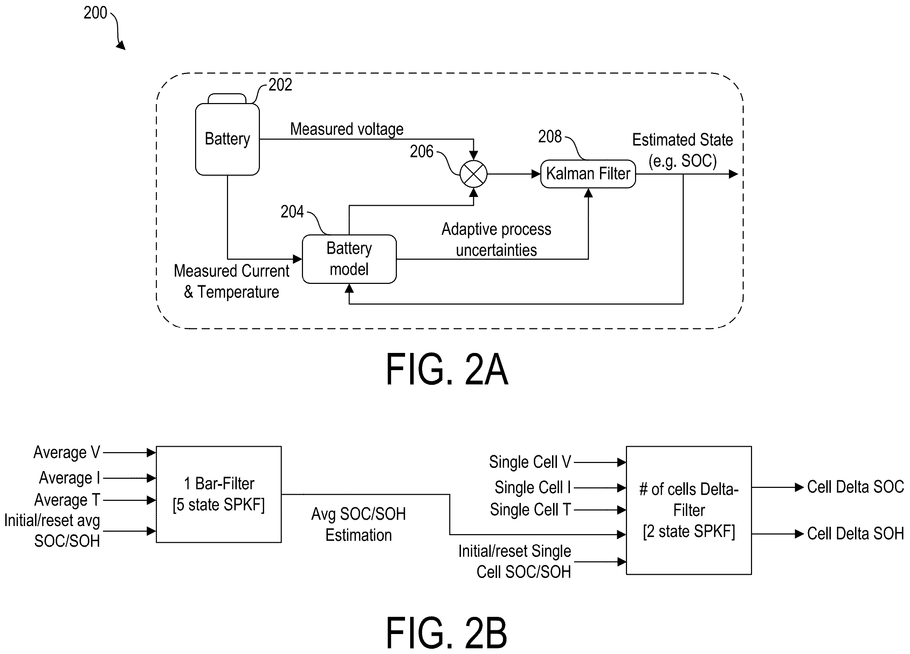

Figure 2A (as block 200) is a block diagram of general Kalman filer loop using measurements data include current, voltage, and temperature, real-time estimation logic, and integrated recalibration mechanisms (X1 aspect). This is used in both bar-filer and Delta filer as shown in Figure 2B.

Figure 2B is a block diagram depicting a closed-loop framework 200 for estimating the state of charge (SOC) and state of health (SOH) of individual LMFP battery cells using cell-level measurements, real-time estimation logic, and integrated recalibration mechanisms. The architecture shown in the diagram supports continuous, high-fidelity state tracking by combining model-based estimation with context-sensitive recalibration, forming a feedback loop that actively compensates for measurement noise, model error, and electrochemical aging.

At the left of the diagram, the system begins with sensor data acquisition, where each monitored battery cell 202 provides real-time electrical signals including cell voltage, current, and temperature. These primary signals serve as inputs to both estimation and recalibration modules. The cell voltage reflects the terminal potential; (i) current is typically bidirectional and sampled at high frequency; and (ii) temperature is measured either via thermistors embedded near the cell or estimated from thermal models. However, in bar filter, the input is the averaged cell voltage, current, and temperature with initial avg SOC and initial avg SOH value.

The sensor data is routed to a state estimator 204, which computes the average estimate of SOC/SOH using one or more model-based algorithms, for example a battery model. These may include Kalman filtering, which model system dynamics and adjust estimator gains based on process and measurement noise covariance; (iii) equivalent circuit models (ECM) that simulate voltage response under dynamic loading using resistive-capacitive elements; (iv) observer-based methods, such as Luenberger or sliding mode observers; and (v) machine learning models, optionally used in parallel, that infer SOC from raw sensor data patterns learned from prior labeled datasets. The state estimator may then send estimated average states to the recalibration evaluation block 206.

The estimated average states are output to a downstream control system, i.e. delta filer, which follow the same Kalman filter block 200, which estimate the individual SOX based on measured voltage, current, and temperature of each cell in the pack. This determination may be based on the following: (i) operating conditions (e.g., the battery is at rest, or a TOC event is detected); (ii) estimator uncertainty (e.g., divergence in predicted vs. measured voltage); (iii) accumulated estimator drift (e.g., based on coulomb count integration error); and (iv) error thresholds (e.g., deviation beyond tolerance from expected trends).

If recalibration criteria are satisfied (in the first aspect), the system activates a recalibration module 114 and 124. This module may contain several distinct pathways, each suited to different operating scenarios: (i) open-circuit voltage (OCV) recalibration, using rest-period voltage to reset SOC via a pre-characterized OCV-SOC curve; (ii) top-of-charge (TOC) recalibration, resetting SOC when termination voltage, current, and temperature match known TOC profiles; (iii) throughput-OCV recalibration, which corrects SOC based on the difference between expected and actual voltage given throughput since last calibration; (iv) incremental capacity analysis (ICA) or differential voltage analysis (DVA), detecting subtle voltage slope changes to recalibrate SOH; (v) impedance-based correction, incorporating real or simulated impedance spectra to refine model parameters; and (vi) data-driven recalibration, in which pretrained machine learning models identify and correct state estimates using force, voltage, or historical trends.

The system supports continuous operation, with the estimation-recalibration loop executing cyclically or asynchronously in real time.

The final SOC and SOH outputs are then reported to the battery control unit (BCU) for use in (i) charge/discharge scheduling, (ii) cell balancing, (iii) fault detection, and (iv) power prediction. The system supports continuous operation, with the estimation-recalibration loop executing cyclically or asynchronously in real time.

The block diagram also includes data logging and model refinement components, enabling the system to update its (i) OCV-SOC curves, (ii) capacity models, or (iii) calibration datasets over the cell's lifespan. This adaptability ensures long-term estimator reliability even in the presence of aging, thermal cycling, and cell-to-cell variability.

By tightly integrating real-time sensing, model-based estimation, conditional recalibration, and adaptive control, the architecture in Figure 2 provides a robust and scalable platform for SOC and SOH tracking at the individual cell level in LMFP battery systems-addressing the known limitations of voltage flatness, aging-driven capacity loss, and model uncertainty that characterize this chemistry.

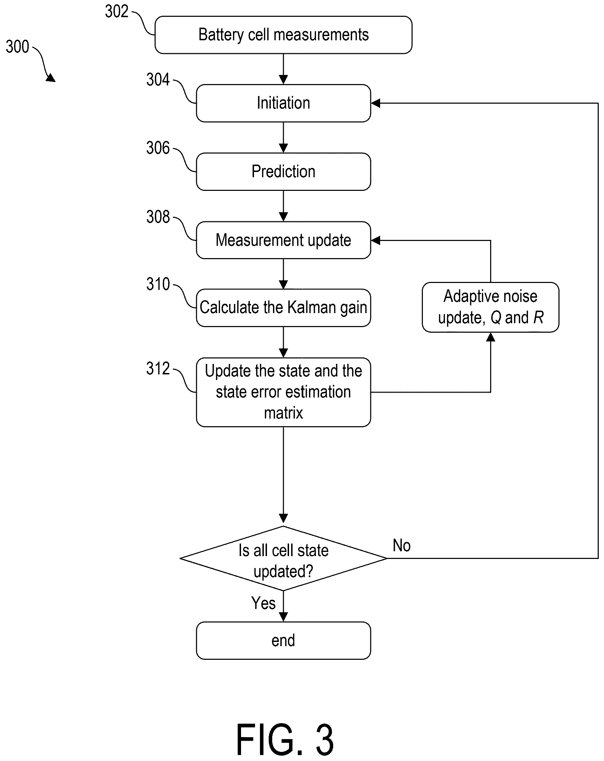

Figure 3 is a flowchart depicting the operation of an adaptive bar-delta Kalman filter-based estimation method 300 for determining the state of charge (SOC) of LMFP battery cells. This flowchart is for X1 aspect that showing how the measurement noise covariance Q and process noise covariance R to be adapted inside the kalman filter process. This estimator architecture is tailored for chemistries such as LMFP, where the flat open-circuit voltage (OCV) profile and nonlinear electrochemical dynamics challenge traditional filtering approaches. The use of a bar-delta Kalman filter enables real-time SOC estimation while adaptively tuning the estimator's response to changing system dynamics, measurement noise, and model deviation.

The flow begins with real-time acquisition of battery cell measurements 302 to initialize Kalman filter internal parameters such as measurement noise covariance Q and process noise covariance R and initial states, specifically voltage, current, and temperature. These signals are acquired from the cell monitoring unit and form the raw input data for the estimator. This flow is to initialize Kalman filter internal parameters such as measurement noise covariance Q and process noise covariance R and initial states

The process 300 (X1 aspect) proceeds to an initialization block 304, where the filter state vector (x) is set for the i th cell, and i=1 for the first cell. The state vector typically includes the SOC, and optionally other latent internal states, such as hysteresis, internal resistance, or diffusion-related parameters. The initialization step also defines the initial error covariance matrix and sets the initial process and measurement noise covariance parameters, denoted as Q and R, respectively. Further the number of cells (i) may be set during the initialization block 304.

Next, the estimator performs a prediction step 306, in which the state estimate is projected forward using a dynamic model of the battery. The prediction steps includes generating sigma points, time updates with adaptive noise covariance update, and update the sigma points based on new Q and R. This model may take the form of an equivalent circuit (e.g., Thevenin or dual polarization model), a reduced-order electrochemical model, or a physics-informed neural net. The predicted state and error covariance matrix are propagated forward using system dynamics and expected inputs (e.g., applied current, temperature influence). The method 300 may further generate Sigma points.

Following the prediction 306, the measurement update phase 308 is executed. In this step, the system compares the predicted measurement (e.g., terminal voltage) with the actual observed measurement. The residual, or innovation, is calculated as the difference between the measured and predicted voltage. The prediction update phase 308 may include a time update, a sigma points generation update, and an adaptive noise convariance update.

The Kalman gain 310 is then computed using the predicted error covariance and the measurement model. At this point, a adaptive mechanism is applied. This mechanism dynamically adjusts the process noise (Q) and measurement noise (R) covariance matrices based on the characteristics of the residual signal. For example, if the residuals are large and persistent, the measurement noise R may be increased to reduce the influence of unreliable sensor data. Conversely, if the model shows consistent underperformance, Q may be increased to allow the estimator to track unmodeled dynamics. This adaptive mechanism prevents filter divergence and improves stability across both flat and sloped regions of the OCV curve, which is particularly important in LMFP systems where the voltage change per unit SOC may be near zero over wide intervals.

With the Kalman gain adjusted, the estimator proceeds with the correction step 312, in which the predicted SOC is updated using the residual (innovation) and gain. The error covariance matrix is also updated to reflect reduced uncertainty after correction.

Finally, if the cell state is updated, process 300 for that particular cell reaches an end and the corrected SOC estimate is output to downstream control layers and logged for trend analysis. Process 300 is repeated for each cell. After all the cells have been updated, process 300 may end. If the cell state is not updated, the system loops back to the initiation block 304 to start the process again. Alternatively or additionally, regardless of the cell state being updated, the system may loop back to the next measurement cycle, forming a continuous, closed-loop estimation routine.

The adaptive filtering method 300 may also be described according to Figure 3B.

This flowchart demonstrates a robust, adaptive filtering method that incorporates real-time electrical signals and dynamically tunes its model parameter-all within a single SOC estimation loop. In the context of LMFP cells, where estimation noise, voltage plateaus, and aging behavior introduce significant complexity, the adaptive bar-delta Kalman filter offers resilient and high-precision state tracking with minimal reliance on frequent rest periods or fixed model assumptions.

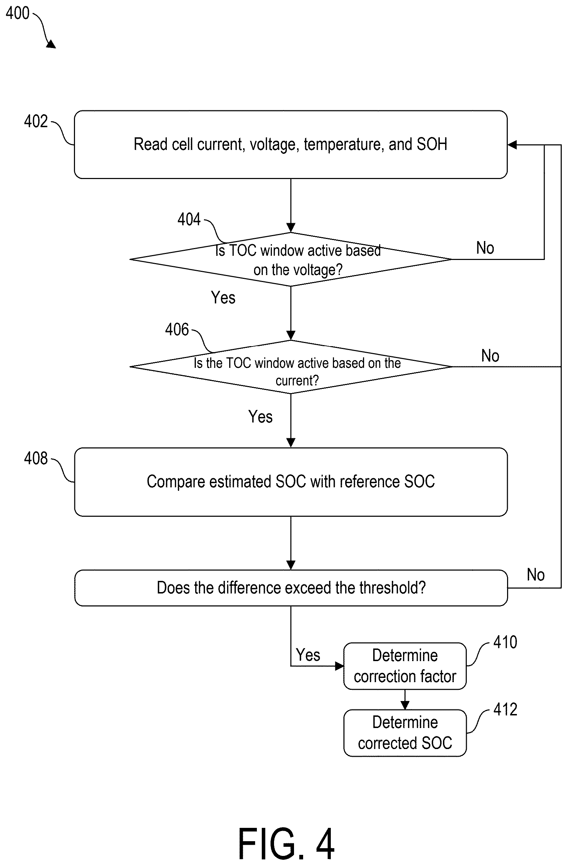

Figure 4 is a flowchart outlining an enhanced Top-of-Charge (TOC) recalibration method 400 (X2 aspect) for updating the state of charge (SOC) in LMFP battery cells. This method 400 expands upon conventional TOC recalibration by introducing a multidimensional, context-aware approach that improves reliability and accuracy across temperature, aging, and chemistries with complex plateau dynamics-such as LMFP, which exhibits subtle charge termination behavior and nonlinear voltage profiles.

The process begins with continuous monitoring of cell-level signals 402, specifically voltage, current, temperature, and an estimate of SOH. These values are sampled throughout the charge cycle and evaluated in real time. The system uses this data to determine whether the conditions are in the TOC window based on a voltage threshold 404 and current threshold 406-that is, whether the cell has reached a nearly full charged condition (i.e. SOC > 95%) suitable for recalibrating the SOC. If the voltage is greater than a threshold voltage, the system may then determine if the current is smaller than a threshold current. If both conditions are met, the method 400 may proceed to block 408 to estimate the SOC from a LUT based on the voltage current, temperature, and SOH, discussed further below.

In traditional TOC methods, a fixed voltage (e.g., 3.9 V) and tapering current threshold (e.g., C/20) are used as the sole indicators of charge completion. However, this method is prone to error in LMFP systems due to thermal sensitivity, aging-induced redox shifts, and variation in plateau lengths. To overcome these limitations, the flowchart introduces a multi-parameter TOC lookup table that evaluates TOC validity based on a combination of the following: (i) final charge voltage, (ii) tapering current value, (iii) measured cell temperature, and (iv) estimated SOH.

This lookup table is empirically calibrated to reflect how the cell's near full-charge signature evolves over its lifecycle. For example, a new cell at 25 °C may reach 100% SOC at 3.92 V with a C/30 taper, while an aged cell at 45 °C may show 100% SOC charge at 3.88 V with a different taper profile. The TOC window is declared valid only when the live measurements fall within the expected multi-dimensional bounds defined in this reference.

Once a valid TOC event is detected, the system retrieves the corresponding SOC reference value from the lookup table 408. This value represents the true SOC associated with the present charge termination condition, accounting for temperature and SOH.

The system then compares the estimated SOC from the existing estimator (e.g., Kalman filter, coulomb counter) with the reference SOC at step 408. If the difference exceeds a correction threshold, a correction factor is calculated at step 410. This factor may be applied in different ways depending on the estimation architecture: (i) direct reset of SOC to the reference value; or (ii) partial blending of estimated and reference SOC using a weighting coefficient.

The correction factor may then be used to determine a corrected SOC in step 412. State re-initialization of a model-based filter using the recalibrated SOC as the new initial condition. The corrected SOC is then output to the battery management system (BMS), where it can be used for power control, balancing, and state reporting. Additionally, the recalibration event is logged, and the SOC correction magnitude may be analyzed over time to detect increasing estimator drift or cell abnormality.

If the difference between the estimated SOC and the reference SOC does not exceed a correction threshold in step 406, the system may proceed back to monitoring cell-level signals 402-due to, for example, the taper current not falling within range or the voltage plateau not fully completing-the system bypasses the correction and continues standard SOC estimation.

This enhanced TOC recalibration strategy is especially well-suited to LMFP cells, where conventional charge endpoint detection is unreliable due to a wide and compressible Mn redox plateau. By referencing actual aging- and temperature-adaptive calibration data, the system ensures consistent SOC alignment across cell conditions and use scenarios.

Figure 4, therefore, provides a structured and intelligent recalibration mechanism that stabilizes SOC tracking and reduces long-term drift using charging behavior already intrinsic to the system's operation.

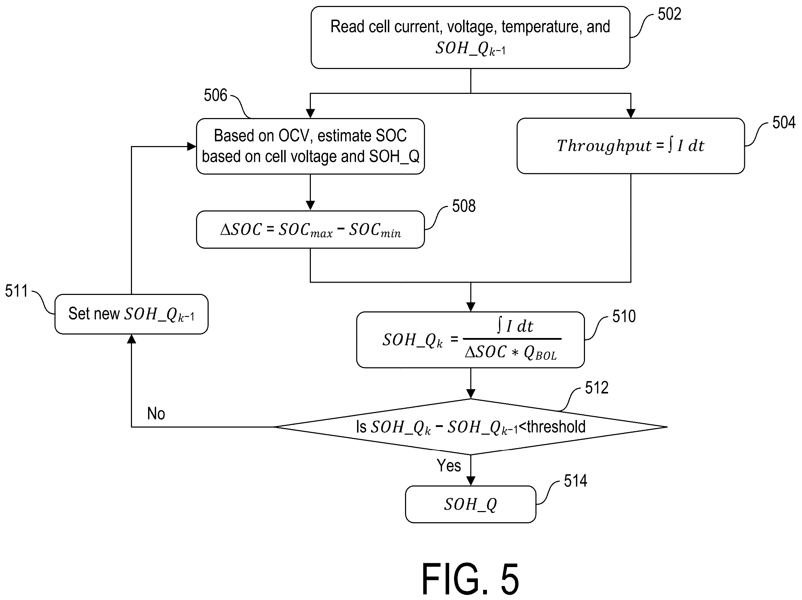

Figure 5 presents a flowchart detailing a recursive Throughput-OCV recalibration method 500 for updating both state of charge (SOC) and state of health (SOH) in LMFP battery cells. Unlike conventional throughput methods, which assume a static open-circuit voltage (OCV) curve and apply corrections based only on capacity flow, this approach incorporates an evolving OCV-SOC relationship tied to SOH, making it more accurate for chemistries such as LMFP where the redox profile shifts with aging.

The process begins with collection of cell-level measurement data (box 502), including voltage, current, temperature, and capacity (SOH_Qₖ₋₁) during operation-typically under quasi-static conditions such as slow charging or discharging, or during brief rest intervals. The system also tracks accumulated charge throughput (Ah-in or Ah-out) (box 504) since the last known reference point.

From this data, the algorithm computes an initial SOC estimate (box 506) by applying the observed voltage to an OCV-SOC mapping. However, unlike conventional approaches that use a fixed OCV curve, this mapping is parameterized by SOH, particularly SOH_Q, which reflects relative capacity retention. For example, an aged cell with reduced usable capacity will reach a given voltage at a different SOC than a new cell. The OCV curve shifts leftward or compresses with cycling, and the mapping dynamically accounts for that deformation.

After estimating SOC from the voltage and SOH_Q (box 506), the system checks whether conditions for recalibration are valid. These may include: (i) sufficiently slow current (to minimize IR drop and enable accurate voltage interpretation), (ii) stable temperature (to ensure the OCV-SOC relationship remains accurate), (ii) cell resting or operating within an identifiable voltage segment. If these conditions are met, the system proceeds to compare SOC predicted from voltage with the SOC calculated from throughput (box 508), i.e., how much charge has passed into or out of the cell since a prior reference point (e.g., last TOC). A discrepancy between these two SOC values indicates estimator drift, capacity loss, or changes in OCV behavior.

The system then solves for a new SOH_Q value that reconciles the observed voltage with the throughput-inferred SOC. This is done recursively: the algorithm adjusts SOH_Q, re-evaluates the OCV-SOC mapping, and repeats until the SOC values converge within a defined tolerance. In effect, it finds the SOH_Q value that would make the present voltage match the throughput-based SOC under the correct OCV profile.

For example, at box 510, a SOH_Qₖ value is calculated by dividing the throughput by the change in SOH (box 508) multiplied by the beginning-of-life capacity of the battery (Q_{BOL}). The calculated SOH_Qₖ value from box 510 is compared to the measured SOH_Qₖ₋₁ value from box 502 at box 512, and then the difference between the SOH_Qₖ value and the SOH_Qₖ₋₁ value is compared to a threshold difference - also at box 512. If the difference between the SOH_Qₖ value and the SOH_Qₖ₋₁ value is equal to or greater than the threshold, a new SOH_Qₖ₋₁ value is set at box 511 and the method continues again at box 506. If the difference between the SOH_Qₖ value and the SOH_Qₖ₋₁ value is less than the threshold value, then it is determined that the SOH_Qₖ value is the correct SOH_Q value at box 514.

Once the corrected SOH_Q is determined, it is fed back into the system's internal models: (i) the updated OCV-SOC curve is applied to future voltage-based SOC estimates; (ii) the SOH_Q value may be passed to higher-level health tracking functions; (iii) the SOC state vector in any active estimator (e.g., Kalman filter or observer) is optionally reset or realigned. If recalibration conditions are not satisfied, the system defaults to ongoing SOC estimation using its current parameters, and monitoring continues.

This recursive throughput-OCV recalibration method is uniquely suited to LMFP cells, whose charge curve evolves noticeably with age due to changes in lithium inventory and loss of iron redox capacity. This method also applies to other chemistries at low SOC area. Static OCV maps become inaccurate over time, leading to SOC error accumulation. By continuously adjusting the OCV map based on throughput, voltage, and inferred SOH, the method ensures robust SOC and SOH tracking without requiring deep discharge cycles or controlled rest states.

Figure 5 therefore defines a dynamic recalibration approach that simultaneously updates SOC and SOH using only standard operating data, maintaining accuracy in the presence of aging and electrochemical nonlinearity.

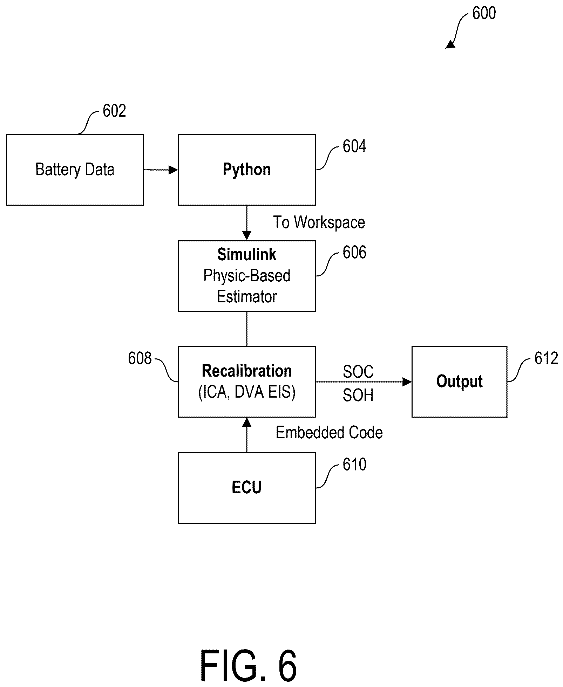

Figure 6 is a schematic diagram depicting an integrated data-driven recalibration framework 600 for enhancing the estimation of state of charge (SOC) and state of health (SOH) in LMFP battery cells. This hybrid architecture supplements conventional estimation algorithms with machine learning-based corrections, enabling adaptive, real-time recalibration that responds to complex battery behaviors-particularly in LMFP chemistries characterized by flat voltage profiles, plateau shifts, and aging-induced nonlinearities.

The architecture begins with a data acquisition layer 602, which collects real-time sensor signals from each monitored cell ("battery data"). These inputs include the following: (i) voltage, representing the terminal potential of the cell; (ii) current, measured bidirectionally for charge/discharge tracking; (iii) temperature, affecting both cell dynamics and estimator performance; and (iv) optionally, additional physical signals such as swelling force, impedance, or DCIR, where available.

These inputs are fed in parallel to two estimation engines. The first is a conventional estimator, based on physics-informed models 604, 606-such as coulomb counting, Kalman filtering, or equivalent circuit modeling. These estimation engines may use programming language, such as Python, or graphical programming environments for modeling, such as Simulink to create machine learning SOC and SOH data. This estimator produces a baseline SOC (and potentially SOH) estimate based on known relationships between input signals and internal battery states. The second is a data-driven correction model, trained using machine learning (ML) or deep learning (DL) techniques on labeled battery datasets. This model processes the same raw signals (and possibly historical states) to predict either (i) an absolute corrected SOC or SOH estimate, or (ii) a residual error between the conventional estimate and the true value.

The outputs of both pathways converge at a fusion block 608, where the baseline and ML-predicted values are combined. The baseline and ML-predicted values are used to create recalibrated SOC and SOH estimates. The fusion method may be implemented in several ways: (i) a weighted average, using confidence metrics based on signal quality or region-specific estimator reliability; (ii) a gating function, choosing between baseline and ML output depending on conditions (e.g., voltage plateau, fast transients); or (iii) a Kalman-style update where the ML prediction adjusts the baseline estimate like a correction term. The fusion block 608 may also collect data from an electronic computer unit 310 to create the recalibrated SOC and SOH estimates.

The fused SOC and SOH estimates are then output to the battery management system (BMS) 612, where they inform (i) charge control, (ii) power allocation, (iii) thermal regulation, (iv) balancing, and (v) degradation tracking. These outputs may also be logged for trend analysis or further model training.

In parallel, the system includes a recalibration feedback path, where discrepancies between predicted and actual measurements (e.g., voltage error, capacity fade indicators) are analyzed. These discrepancies may (i) trigger adaptive retraining of the ML model or (ii) be used to reweight model components in future estimation cycles.

The architecture supports a wide range of ML/DL implementations, including (i) shallow models (e.g., support vector regression, gradient boosting) for fast, interpretable predictions; (ii) deep neural networks, including recurrent or convolutional architectures, for capturing long-term temporal trends or spatial patterns; and (iii) hybrid physics-ML models, in which physical constraints guide or bound ML predictions.

This data-driven recalibration framework is particularly valuable for LMFP cells, where (i) traditional voltage-based estimation fails in the Mn plateau due to flatness; (ii) aging shifts OCV curves and redox efficiency; and (iii) mechanical effects (e.g., swelling force) and dynamic impedance vary nonlinearly with cycling.

By unifying physics-based estimation with empirical data modeling, Figure 6 enables robust, context-aware SOC and SOH estimation across a wide range of conditions-including dynamic loads, degraded cells, and temperature extremes-without requiring full-cycle test routines or long rest periods.

### SECOND ASPECT OF THE DISCLOSURE

The second aspect of this disclosure relates to a method for rapidly estimating the SOH of LMFP battery cells by monitoring characteristic shifts in the charge-discharge voltage curve during cell aging. As LMFP cells undergo repeated cycling, the transition region between the manganese (Mn) and iron (Fe) redox plateaus gradually shifts toward a lower SOC due to lithium inventory loss and associated aging mechanisms. This shift alters the shape of the voltage curve in a predictable manner and can significantly impact the accuracy of conventional battery models used for SOH diagnostics and battery management system (BMS) control strategies.

In this second aspect, the disclosed method leverages this inherent voltage transition shift as a reliable physical indicator to supplement or validate existing SOH estimation techniques, including those based on electrical models or data-driven approaches. By correlating the SOC at a defined voltage point within the transition region - for example, around 3.70 V during charging - with the actual SOH, the system can provide an independent, physics-based estimation of cell health. Experimental results have shown a strong linear relationship between the SOC at the specified transition voltage and the measured SOH, enabling precise monitoring with minimal computational overhead.

This approach enhances the robustness and accuracy of SOH/SOC estimation across varying operating conditions and mitigates potential drawbacks associated with machine learning models, such as the need for extensive training data and the risk of model drift. Furthermore, integrating this method into the BMS allows real-time cross-validation with other estimation signals, contributing to more reliable control decisions and extending the usable life of the battery system.

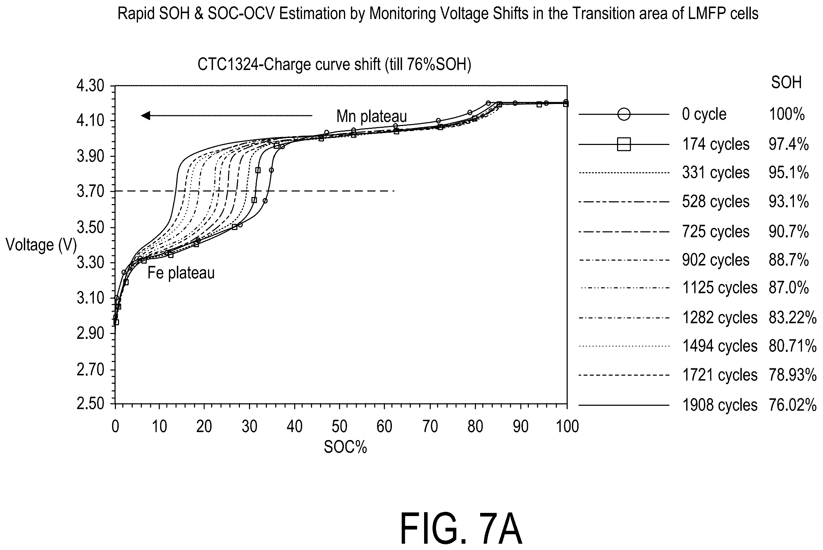

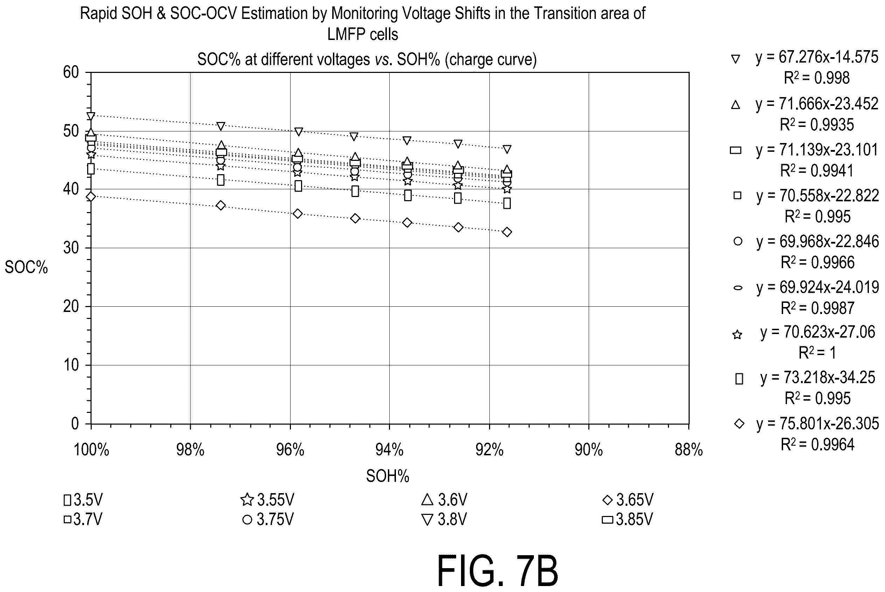

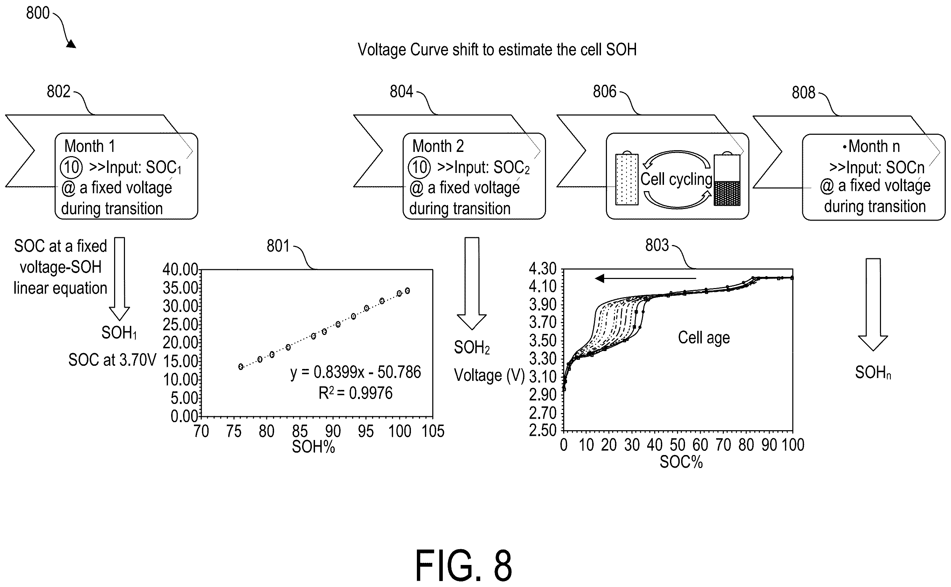

Figures 7A, 7B, and 8 relate to the second aspect of the disclosure, which focuses on estimating the state of health (SOH) in LMFP battery cells using data-driven signatures derived from normal charging behavior. Figures 7A and 7B introduce the core principle underlying this method: the SOC at a fixed voltage within the Fe-Mn transition region shifts predictably with aging, providing a reliable, non-invasive metric for tracking SOH. Figure 8 then operationalizes this principle by presenting a flowchart for real-time SOH estimation based on detecting this transition point during standard constant-current charging. Together, these figures define a practical and efficient SOH estimation technique that leverages the electrochemical characteristics of LMFP chemistry and can be embedded in everyday battery management routines without requiring disruptive testing procedures.

Figures 7A and 7B illustrate a diagram containing two charts - Chart 7A and Chart 7B on the left and right, respectively -- that illustrate how the voltage transition region in the LMFP cell charge curve shifts with aging, and how this phenomenon can be used to estimate the state of health (SOH) of the battery. This method leverages the predictable electrochemical evolution of the charge profile-specifically, the redox activity of iron (Fe) and manganese (Mn)-to provide a non-invasive, data-driven SOH metric that is particularly well-suited to LMFP chemistries as the cell ages

Chart 7A(left) presents a series of voltage-versus-capacity (or SOC) curves recorded for a single LMFP cell at multiple stages of its life at a given temperature (e.g., 25°C). Each curve represents the cell's voltage response at a different point in its lifecycle: fresh, moderately aged, and heavily aged. In LMFP chemistries, the charge curve includes a transition region between two plateaus-corresponding to Fe and Mn redox couples-where the voltage slope is steep and responsive to lithium intercalation dynamics. These charge curves clearly display the characteristic two-plateau structure of LMFP: (i) the Fe plateau at lower voltages (approximately 3.4-3.6 V), associated with the Fe²⁺/Fe³⁺ redox couple; and (ii) the Mn plateau at higher voltages (approximately 3.6-4.0 V), corresponding to the Mn²⁺/Mn³⁺/Mn⁴⁺ activity.

Between these two regions lies a transition zone, typically centered around 3.65-3.75 V, where the voltage rises steeply over a narrow SOC range. As the cell ages, the relative length and slope of these plateaus change in several ways: (i) the Fe plateau shortens, indicating loss of lithium inventory or iron-based capacity; (ii) the Mn plateau lengthens, reflecting dominant contribution from the more stable manganese redox region; and (iii) the transition point shifts to a lower SOC, as less charge is stored before the cell reaches a given voltage in the transition region.

This transition point shift is clearly visible in the curves: for a fixed voltage such as 3.70 V, a fresh cell might reach this voltage at 50% SOC, while an aged cell might reach it at 45% SOC or lower. This leftward shift is attributed to electrochemical imbalances, loss of active material in the Fe region, and lithium inventory depletion-all of which are aging signatures unique to the LMFP system. This movement occurs consistently across the cell's lifetime; therefore, fixing the voltage serves as a reliable method that forms the core of the transition-based SOH estimation method.

Chart 7B (right) plots various SOC curves corresponding to fixed transition voltages (e.g., 3.5 V, 3.7 V, 3.85 V) and given temperature (e.g., 25°C) against the independently measured SOH of the cell. In each case, the result is a strong, typically linear or monotonic inverse correlation: as SOH decreases, the SOC at the fixed voltage drops proportionally. The trend line may be modeled using (i) linear regression or (ii) fitted to a polynomial, depending on calibration results. In one example, a coefficient of determination (R-squared) exceeds 0.99 (i.e., with the fixed voltages shown, the coefficient of determination ranges from 0.9935 to 1), demonstrating a strong relationship between the data with a reverse linear relationship regression model. For example, at a fixed voltage of 3.55 V, the R-squared value is 0.9987. Therefore, representing the relationship between SOH and SOC at the fixed voltage using such a model serves as a reliable approach. This consistent, monotonic relationship allows the BMS to use the SOC value-measured when the voltage crosses the defined threshold-as a proxy for SOH.

This method allows the system to infer SOH by recording only two real-time values during charging: (i) the moment the cell voltage reaches the defined transition point, and (ii) the corresponding SOC value, estimated via coulomb counting or a dynamic model.

Because this strategy does not require rest periods, full-cycle testing, or high-resolution differential capacity analysis, it is especially advantageous for in-field deployment. It is also chemistry-specific, relying on the unique dual-plateau behavior of LMFP to extract an SOH signature not available in other chemistries like LFP or NMC.

By tracking the progressive shift in the transition region of the charge curve, Figures 7A and 7B demonstrate a lightweight, repeatable, and scalable method for SOH estimation that directly reflects internal redox activity and aging-induced structural change at a given voltage and temperature for various fixed voltages.

Figure 8 is a flowchart outlining an operational method 800 for estimating the state of health (SOH) of an LMFP battery cell based on the voltage transition shift that occurs during charging. This method implements, in real time, the principle introduced in Figures 7A and 7B-namely, that the SOC at a fixed voltage within the Fe-Mn transition region correlates reliably with cell aging. The process enables precise, low-overhead SOH tracking using only standard onboard measurements.

The process begins with the activation of the transition-SOH estimation module 804, which may run in parallel with ongoing SOC estimation and battery control routines. The system continuously monitors the cell voltage during a normal constant-current charging cycle 806.

When the voltage crosses a predefined threshold-for example, 3.70 V, selected to lie within the steep transition zone between the iron and manganese redox plateaus-the system immediately records the current SOC estimate. This SOC may be derived from coulomb counting or from a model-based estimator, such as a Kalman filter.

Next, the system checks whether the SOC-at-transition measurement conditions are valid. These conditions may include the following: (i) charging under constant current, to reduce complexity; (ii) temperature within calibrated bounds, to minimize thermal influence on redox potential; (iii) no recent disturbances or large estimation errors; and (iv) acceptable confidence in the underlying SOC estimate.

If all criteria are satisfied, the recorded SOC is passed to a pre-calibrated mapping function or lookup table that correlates SOC at the transition voltage to SOH, for example, graph 801. This function is typically derived from experimental data across a fleet of cells tested to known capacity-retention endpoints (e.g., 100%, 90%, 80%, etc.) using a similar method, e.g., at box 802. It may be implemented as (i) a linear regression model, (ii) a polynomial or piecewise-linear fit, or (iii) a table interpolated over temperature and C-rate ranges.

The output of this function is an updated SOH estimate, reflecting the current health of the cell as inferred from the shape and shift of its charge curve.

This SOH value is then used in several ways: (i) it is reported to the battery management system (BMS), where it can influence charging limits, balancing, derating, or diagnostics; (ii) it is logged for long-term aging analysis; and (iii) it may be fused with other SOH indicators, such as capacity fade from throughput, DCIR growth, or swelling-force deviations.

If the initial validation fails-for example, if the transition voltage is reached during a nonstandard load or at an invalid temperature-the update is skipped, and the system continues tracking until the next eligible event.

This method is non-intrusive (i.e., requires no interruption to charge operation) and is uniquely effective in LMFP cells, where the mid-voltage transition is chemically sensitive to aging (see, e.g., graph 803). It is particularly valuable because the manganese plateau exhibits a flat voltage response, making conventional voltage-based SOH estimation unreliable in at least that region.

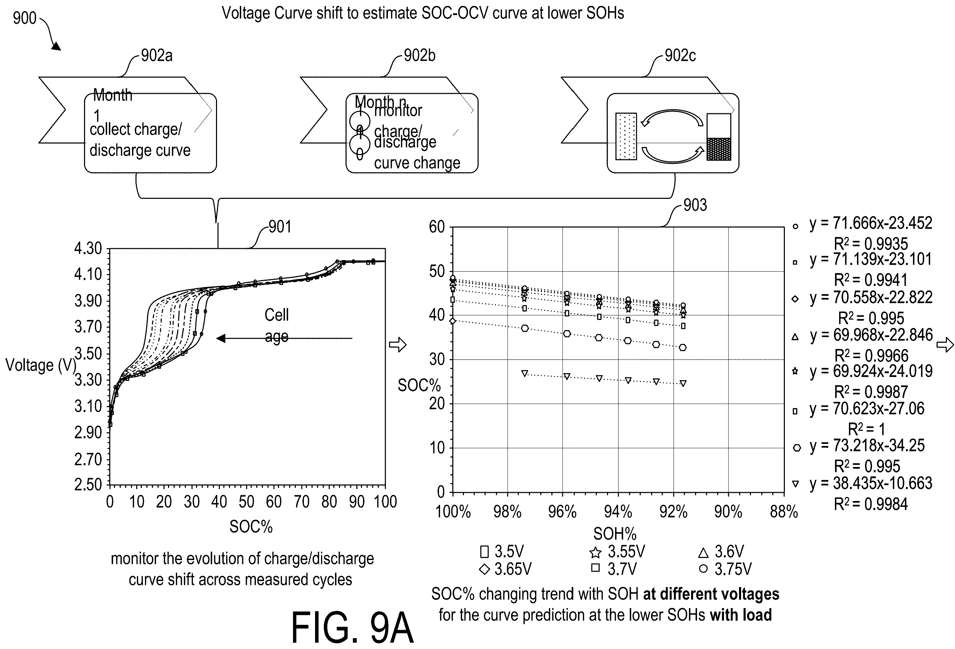

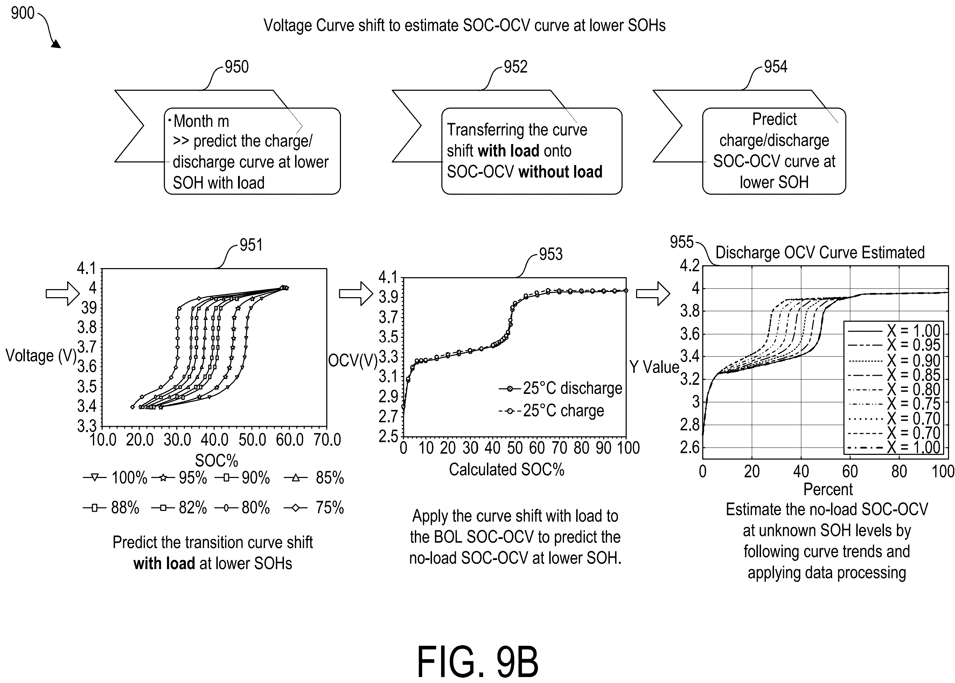

Figures 9A and 9B demonstrate a flowchart outlining a method for estimating the SOC-OVC in LMFP battery cells by monitoring the shift in the voltage transition region during charging. A linear relationship between SOC and SOH can be obtained at different voltages with load, which can be used as reference for the voltage curve prediction and SOC estimation at different SOH values, specifically at lower SOH values. Furthermore, the curve shift degree observed during the charge curve with load could be potentially used to adjust the OCV-SOC relation during the transition area with the age of cells.

As shown, the process 900 starts by monitoring the evolution of the charge/discharge curve shift across measured cycles at boxes 902a, 902b, 902c, establishing a SOC% curve based on SOH% at different voltages (see graphs 901, 903). This data is used to predict the transition curve at lower SOHs with a load (box 950, graph 951). From there, the curve shift with load is transferred onto an SOC-OCV curve without a load (box 952, graph 953). This is executed by applying the curve shift with the load to the beginning-of-life SOC-OCV curve to predict the no-load SOC-OCV curve at a lower SOH. Once the curve is transferred from with a load to without a load, the curve trends can be followed and - using data processing - the no-load SOC-OCV can be estimated at unknown SOH levels (box 954, graph 955). This function is particularly valuable for LMFP cells, where the SOC-OCV relationship shifts significantly as the cells age-posing a major challenge for accurate SOC estimation. Incorporating this method helps address that variability and improves the reliability of the estimation over the cell's lifecycle.

By embedding a fast and robust diagnostic into a normal charging event, Figure 8 and 9's flowchart formalizes a novel SOH estimation technique that captures a key signature of structural degradation in LMFP chemistry and applies it in real time with minimal computational or measurement overhead. Together, Figures 7A, 7B, 8, and 9 demonstrate how the disclosed approach integrates the measurable electrochemical evolution of an LMFP cell into a simple, robust, and cost-effective estimation technique within a battery management system.

This method is particularly advantageous for LMFP systems because it avoids reliance on rest conditions or impedance spectroscopy, both of which are either slow or hardware-intensive. Instead, by monitoring natural charging behavior and identifying when the cell voltage crosses the transition value, the system can record the corresponding SOC and compute SOH via a pre-calibrated mapping.

The voltage transition method is robust to minor variations in temperature and C-rate, and it can be made more accurate by applying correction factors for these influences or by embedding the correlation into a multi-variable regression or machine learning model. Additionally, the technique can be fused with swelling force or DCIR-based diagnostics to create a redundant, multimodal SOH estimation framework.

Figures 7A-B, therefore, provide visual and analytical evidence for using the voltage transition shift as a reliable and computationally efficient method to estimate both SOC and SOH in LMFP cells over time.

Figure 8 presents a flowchart outlining a method for estimating the state of health (SOH) in LMFP battery cells by monitoring the shift in the voltage transition region during charging. This operational process formalizes the principle demonstrated in Figures 7A-B, integrating it into a repeatable and automated SOH estimation path that can be embedded within a battery management system (BMS). Figures 9A and 9B present a method for estimating the SOC in LMFP battery cells by monitoring the shift in the voltage transition region during charging. A linear relationship between SOC and SOH can be obtained at different voltages with load, which can be used as reference for the voltage curve prediction and SOC estimation at different SOH. Furthermore, the curve shift degree observed during the charge curve with load could be potentially used to adjust the OCV-SOC relation during the transition area with the age of cells.

The flowchart begins with the real-time monitoring of cell voltage and SOC during a standard constant-current charge cycle. SOC may be estimated through coulomb counting or model-based filtering. The system continuously checks whether the voltage has reached a predefined transition threshold-typically located at the midpoint between the iron and manganese redox plateaus. This voltage value is selected empirically (e.g., 3.70 V) based on calibration for the specific LMFP cell type.

Once the cell voltage reaches the transition threshold, the system captures the current SOC estimate and records it as the transition SOC value. This moment is critical: the SOC at the transition voltage provides a direct indication of how the charge curve has shifted due to cell aging.

The system then accesses a calibrated lookup table or function that maps transition SOC values to SOH. This function may be linear or nonlinear and is typically derived from laboratory testing across cells of known health states. For example, if a cell reaches 3.70 V at 50% SOC when new, and at 43% SOC after aging, the correlation between SOC at transition and SOH can be modeled with high confidence.

Using this correlation, the system computes the updated SOH value, which reflects the present capacity retention or active lithium content of the cell. This updated SOH may then be output to the system controller and used for power management, cell balancing, or degradation tracking.

Following the estimation, the system logs the SOC-voltage transition pair and associated SOH for historical trend analysis. This data may be used to detect accelerated degradation, cross-check other SOH estimates (e.g., from impedance or force-based methods), or update the correlation function if necessary.

If no valid transition voltage is detected-such as during incomplete charge cycles or atypical current profiles-the system bypasses the update and waits for the next qualified charging event. Optional safeguards may also be applied, such as temperature filtering or rate filtering, to ensure consistency and reduce estimation noise.

This voltage transition-based SOH estimation strategy offers high temporal resolution and low computational complexity. It is especially well-suited to LMFP chemistries, where voltage shifts in the transition region are pronounced and reliably correlated with electrochemical aging.

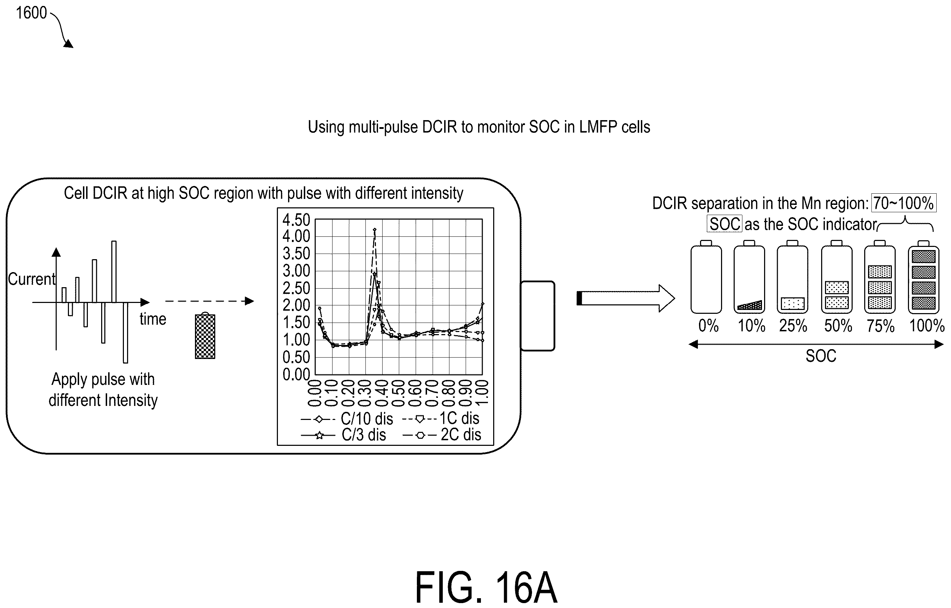

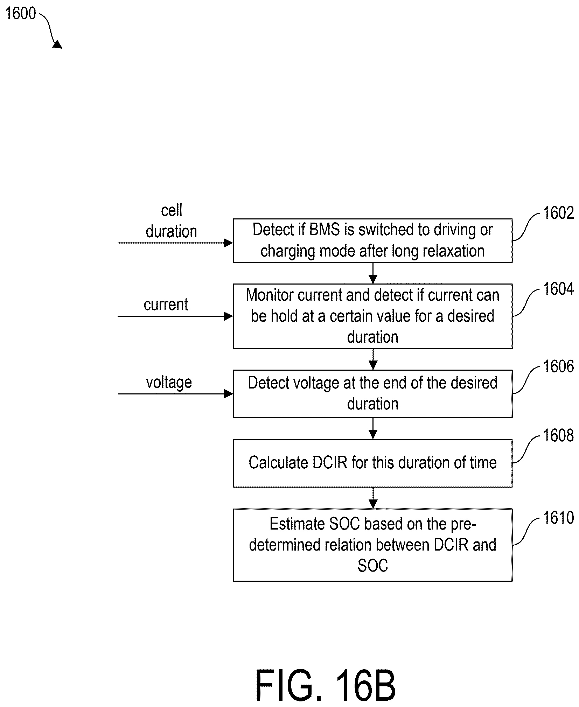

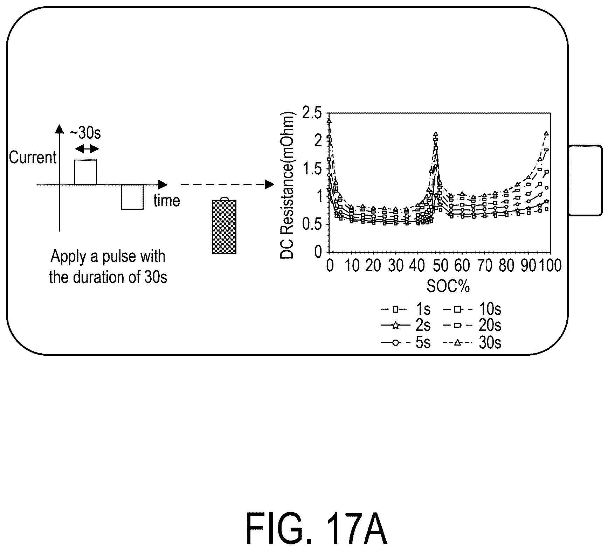

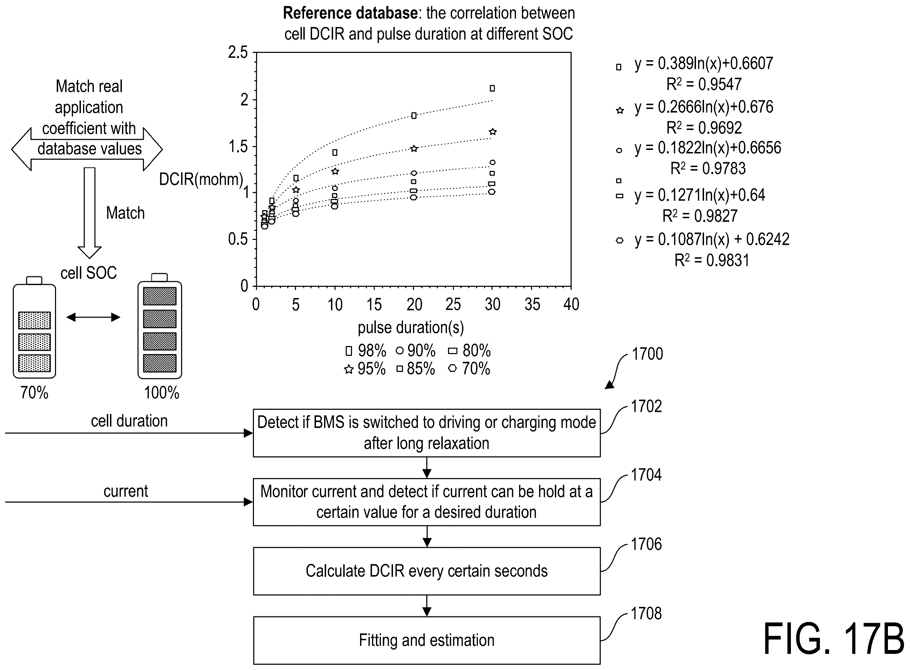

Figure 16 thus establishes a robust, voltage-driven flow for periodically recalibrating SOH during normal charge events, improving both short-term accuracy and long-term degradation tracking without requiring specialized hardware or rest periods. Figures 17A and 17B estimate a robust, curve shift driven flow for predict the SOC at unknown SOH, which can be used a additional information for the SOC estimation with the conventional methods and potentially can be used to predict the SOC-OCV at different SOHs.

Additionally, the system and method illustrated these figures build upon and integrate seamlessly with the first aspect of the disclosure, which establishes a framework for estimating key state parameters-such as SOC and SOH-on a per-cell basis within an LMFP battery pack. In that first aspect, real-time measurements of voltage, current, and temperature are combined with model-based estimation and periodic recalibration to maintain accuracy over time, even in the presence of sensor drift or modeling error.

The transition region-based SOH estimation introduced in the second aspect provides a complementary mechanism within this broader architecture. It uses the same SOC values derived from current integration and voltage monitoring-already computed as part of the first aspect's estimation process-as the basis for identifying aging-related shifts in the voltage transition zone. Because it relies solely on standard cell-level measurements, the method can be implemented without additional sensors or redundant hardware.

In a fully integrated setup, the per-cell estimation module monitors voltage and current to calculate SOC continuously. When the voltage reaches a predefined threshold in the transition region of the charge curve, the system captures the corresponding SOC and uses a calibrated correlation to estimate SOH. This result can then be compared against the SOH output from the primary model-based estimator. If the two values agree within a defined margin, the system confirms the consistency of both estimation methods. If not, it may trigger recalibration routines or flag potential issues such as sensor anomalies, irregular degradation, or atypical cell behavior.

This dual-layered approach strengthens the resilience of the estimation system by providing an independent, electrochemically grounded reference that can validate or correct the outputs of the primary model. In doing so, it mitigates the risk of long-term drift or misestimation, especially in cases where aging effects are not fully captured in the original estimation parameters.

Moreover, the integration of both aspects enhances operational capabilities, enabling more accurate cell balancing, adaptive charge control, and predictive maintenance. Verified per-cell SOH estimates allow the battery management system to fine-tune charging strategies, manage thermal loads more effectively, and extend the service life of the pack while preserving safety margins.

In summary, the transition region-based SOH method described in the second aspect not only supports but reinforces the per-cell estimation framework outlined in the first aspect, creating a layered diagnostic system that combines real-time sensing with characteristic electrochemical behavior unique to LMFP chemistries.

### THIRD ASPECT OF THE DISCLOSURE

The third aspect of the present disclosure relates to a system and method for estimating the SOC and SOH of an LMFP battery cell using real-time measurements of the battery swelling force generated by the expansion and contraction of the cell electrodes during normal charge and discharge cycles. In examples, the third aspect of this disclosure relates to a method for estimating the SOC and SOH of LMFP battery cells by utilizing swelling force measurements as an in-situ physical indicator during operation. LMFP battery chemistry has emerged as a next-generation solution for applications requiring low cost, high safety, and long cycle life. However, conventional SOC estimation methods, which rely heavily on coulomb counting and OCV monitoring, face significant limitations when applied to LMFP cells due to the inherently flat OCV plateau at the manganese redox phase. Similarly, accurate SOH estimation for LMFP cells is complicated by their unique two-phase voltage profile, aging-related curve shifts, and limited historical performance data.

In this third aspect, the disclosed method addresses these challenges by integrating direct measurement of battery swelling force - the mechanical force generated by electrode expansion and contraction during lithium-ion intercalation and extraction - into the battery management system (BMS). By strategically placing pressure or force sensors on and/or between individual cells or within the cell stack, the system continuously monitors the swelling force as the cell charges and discharges. This real-time mechanical signal provides an independent indicator that correlates with SOC, particularly in the otherwise difficult-to-resolve manganese plateau region, and reveals trends related to cell degradation and gas generation over the cell's lifetime, thus informing SOH estimation.

This swelling force-based approach enhances the reliability and accuracy of conventional electrical or model-based SOC and SOH estimation techniques. It reduces reliance on coulomb counting alone, provides physical cross-validation for model outputs, and helps detect anomalies such as excessive gassing or abnormal mechanical expansion that may signal early failure. By augmenting the BMS with this additional physical sensing pathway, the disclosed method delivers more robust, resilient, and accurate monitoring and control of LMFP battery systems in demanding applications.

Unlike conventional SOC and SOH estimation techniques that rely primarily on coulomb counting and OCV tracking, which can be unreliable for LMFP cells due to the flat voltage plateau characteristic of the manganese redox region, this aspect of the disclosure introduces a complementary measurement signal that directly captures the mechanical response of the cell. By positioning a force or pressure sensor between adjacent cells or within the battery pack structure, the system detects the changes in internal pressure caused by lithium ion intercalation and deintercalation. This swelling force signal reflects both the current electrochemical state of the electrodes and gradual aging effects such as gas generation, SEI layer growth, and electrode material degradation.

The swelling force is monitored continuously or at defined intervals throughout the battery's operational life. During each cycle, the force signal provides an additional dimension of information that can be fused with voltage, current, and temperature data to refine SOC estimates, especially in the regions where voltage alone provides little resolution. Over extended use, the pattern and trend of swelling force variation serve as a physical indicator of capacity fade, structural changes, and other degradation modes, thus offering a robust basis for updating SOH estimates.

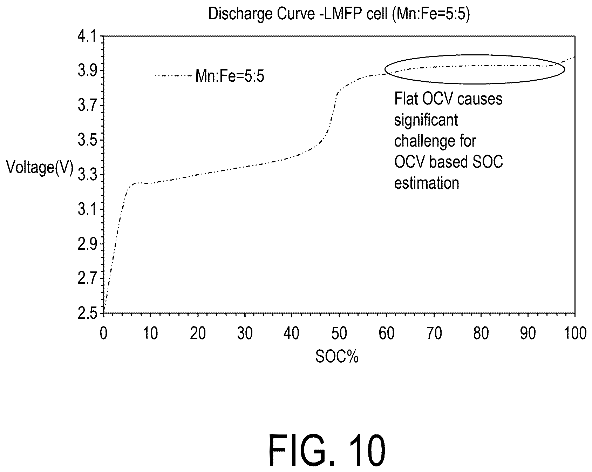

Figures 10 through 14 relate to a third aspect of the disclosure: LMFP SOC monitoring with battery swelling force. This aspect introduces a novel, physically grounded approach for estimating and tracking the state of charge (SOC) in lithium manganese iron phosphate (LMFP) battery cells by leveraging real-time measurements of mechanical expansion-commonly referred to as swelling force. Unlike traditional electrical methods that rely on voltage and current signals, which often lose sensitivity in the flat-voltage manganese plateau region of LMFP chemistries, swelling force provides a continuous, measurable signal that correlates reliably with lithium content in the electrodes.

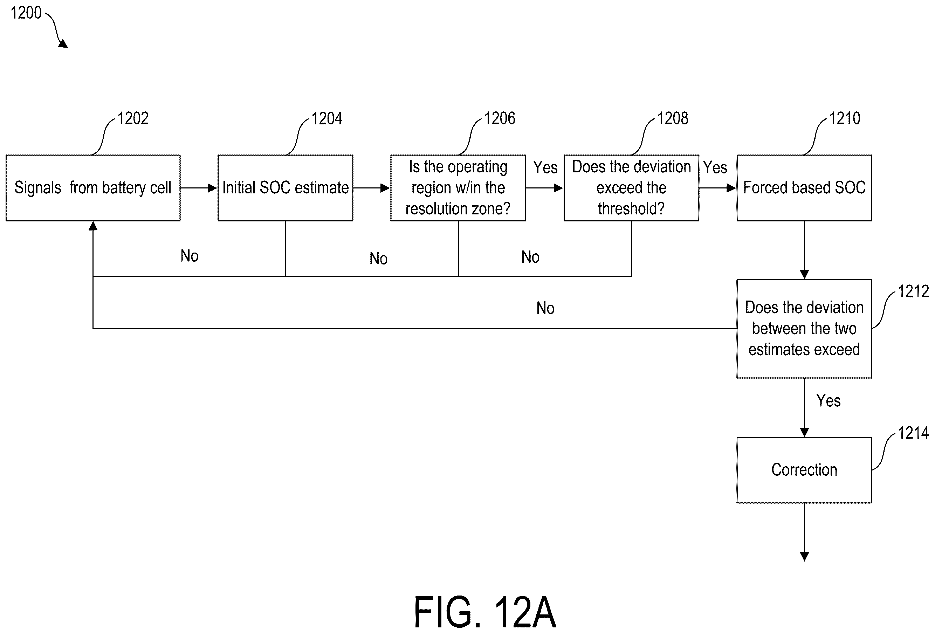

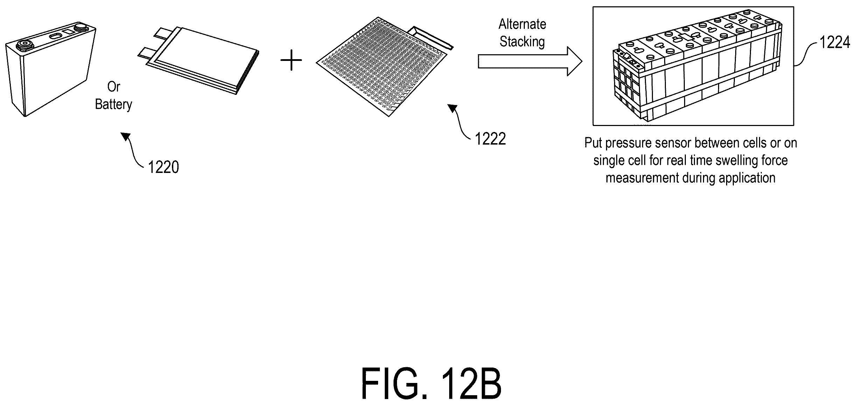

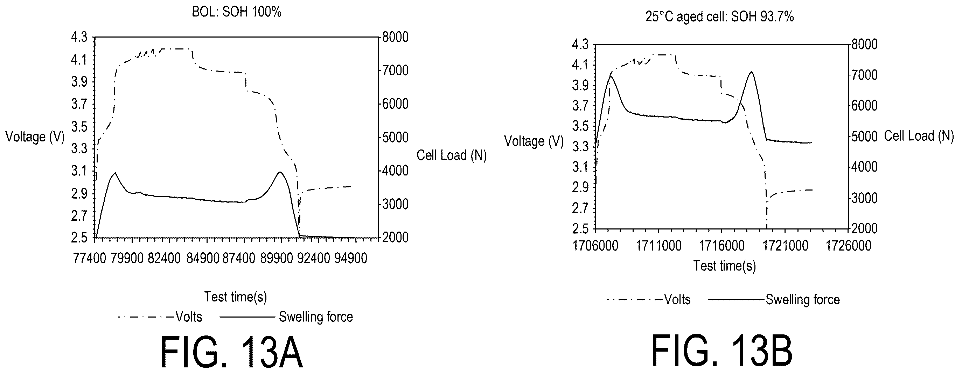

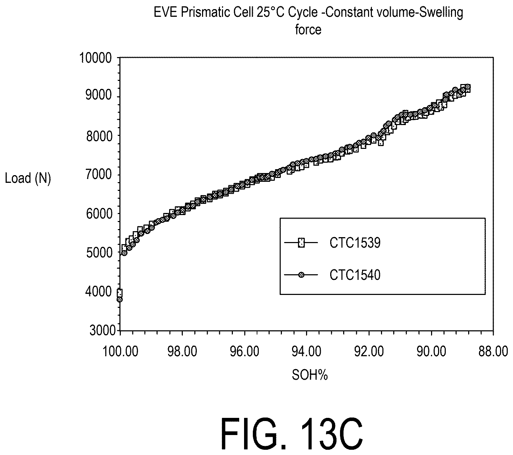

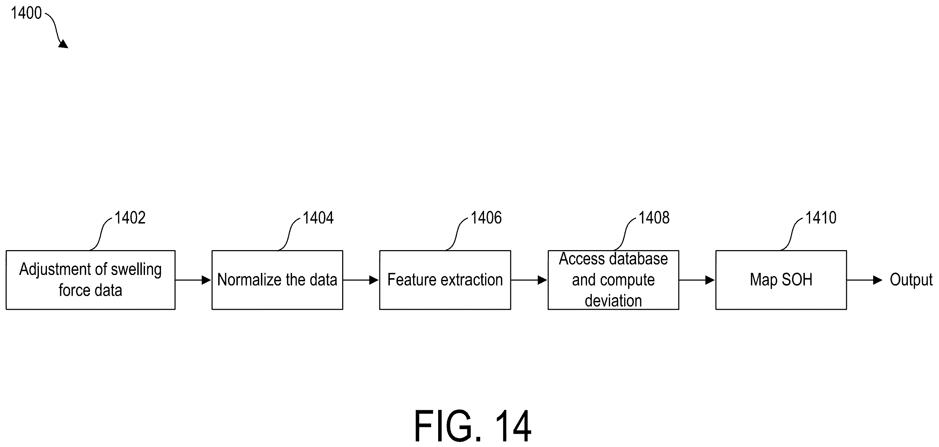

Figure 10 establishes the conceptual foundation for this approach, illustrating how the methods of SOC estimation in the prior art using a combination of coulomb counting and voltage monitoring pose a challenge due to the flat open circuit voltage (OCV) experienced at the manganese redox phase. Figure 11 presents a novel way to calculate SOC by illustrating how the insertion and extraction of lithium ions during cycling causes electrode expansion and contraction, generating a force that can be captured using embedded sensors. Figure 11 additionally shows how swelling force varies not only with SOC, but also with aging, introducing the basis for compensation and calibration. Figure 12 translates these insights into a closed-loop SOC estimation method that fuses swelling force with conventional electrical signals, while Figures 13 and 14 shift focus toward state of health (SOH), demonstrating how long-term changes in swelling force behavior serve as robust indicators of degradation and mechanical fatigue.

Referring back to Figure 10, the figure illustrates the core concept behind using swelling force as a real-time physical indicator of state of charge (SOC) in lithium manganese iron phosphate (LMFP) battery cells. This method addresses the limitations of traditional voltage-based SOC estimation, particularly within LMFP's extended manganese plateau region, where cell voltage remains relatively flat over a broad range of SOC, as shown. The in a graph of the voltage versus SOC %, the manganese region is flat. There are some voltage changing slope in the Fe region, which can be used for the SOC estimation in that region. The flat open circuit voltage (OCV) regions make voltage a poor proxy for lithium content, posing a significant challenge for OCV-based SOC estimation. Figures 11A-C thus establish the physical foundation for a swelling-force-based SOC estimation method by illustrating the shortcomings of OCV-based SOC estimation.

Figures 11A-C are three charts that illustrate how swelling force behavior varies with state of charge (SOC) and aging, and how these relationships can be used to enhance SOC and state of health (SOH) estimation in LMFP battery cells. This multi-factor perspective builds on the conceptual foundation introduced in Figure 10, demonstrating that swelling force is not only a reliable physical proxy for SOC, but also a rich source of diagnostic information when interpreted in context.

At the left of the diagram is an LMFP battery cell undergoing lithium-ion intercalation and deintercalation during charge and discharge cycles. The diagram highlights the electrodes' physical expansion and contraction, which occur as lithium ions are inserted into or extracted from the host electrode materials. Specifically, (i) during charging, lithium intercalates into the electrodes, causing mechanical expansion; and (ii) during discharging, lithium deintercalates, resulting in mechanical contraction.

This volume change, while largely reversible, creates a swelling force within the stacked electrode assembly. This force is exerted outward and can be detected by a force sensor integrated into the mechanical structure of the battery-such as between cells in a module, under compression plates, or embedded within structural supports.

The diagram includes a plot or conceptual curve showing how swelling force increases as SOC increases, even when voltage remains flat-demonstrating that swelling force maintains sensitivity in regions where OCV-based SOC estimation fails. This correlation is especially strong in LMFP systems, where traditional estimation methods suffer from poor resolution across the Mn redox plateau (typically spanning ~30% to ~80% SOC).

An annotation on the diagram illustrates how swelling force measurement may be integrated into a battery management system (BMS) as a supplemental or redundant signal. The force data can be (i) mapped to SOC using a calibrated swelling-force-to-SOC profile; (ii) used in fusion with voltage and current data in model-based or machine learning estimators; or (iii) applied to correct or reset the SOC estimator, especially in ambiguous operating conditions.

Additionally, the diagram hints at other potential applications of the swelling force signal, such as (i) detecting abnormal cell behavior (e.g., gas generation, internal short, or mechanical failure); (ii) monitoring aging trends, as permanent deformation or hysteresis in the swelling profile may indicate degradation; and (iii) enhancing safety diagnostics, by recognizing unexpected force growth under nominal electrical loads.

By integrating this physical sensor channel, the BMS gains access to a real-time, chemistry-specific, and spatially localized indicator of lithium loading in the cell. This is particularly critical in LMFP systems, where flat voltage slopes and aging-induced OCV shifts make electrical signals alone insufficient for high-accuracy SOC estimation.

Figure 11 thus establishes the physical foundation for a swelling-force-based SOC estimation method, enabling robust state tracking through mechanical response sensing and extending observability into regions of the charge curve that are otherwise electrically silent.

Figure 11A (left) presents swelling force (cell load) and voltage as functions of SOC during the charge phase of a separate LMFP cycle. SOC is plotted along the x-axis (in %), with voltage (in volts) on the left y-axis and swelling force (in Newtons) on the right y-axis. The voltage trace exhibits a sharp rise initially (up to ~30% SOC), followed by a plateau spanning ~40% to ~85% SOC due to the Mn redox activity. Meanwhile, the swelling force shows a monotonic and approximately linear increase across the full SOC range, including the plateau region. The green dashed box again isolates the Mn plateau (approximately 50-90% SOC), where voltage is nearly constant but force continues to rise steadily. This divergence reveals that swelling force retains high SOC resolution in precisely the region where voltage-based estimators are least effective. Such behavior allows for enhanced SOC estimation through mechanical sensing, particularly when electrical observables offer insufficient gradient.

Figure 11B (middle) presents swelling force (cell load) as a function of SOC with overlaying curves to define the relationship during different stages of the battery's life. The chart shows a method of estimating SOC using a single-point SOC verification at 30% SOC. In this method, a single-point verification at the maximum swelling force recorded (shown by the dashed vertical line) is implemented at 30% SOC. As shown by the various intersections of this dashed line with the various force curves at different SOHs, the swelling force in Newtons increases drastically as SOH decreases, illustrating how battery aging affects the swelling force. At the beginning of life (BOL), the maximum swelling force recorded is approximately 4500 N, whereas by a SOH of 84%, the maximum swelling force increases to 12000 N. This shows how the SOC-OCV relationship shifts significantly with cell age, as addressed in the method of estimating SOC-OCV curves at lower SOHs in Figures 9A and 9B.

Figure 11C plots the first derivative of swelling force with respect to time (dF/dt) across the charge-discharge cycle, with test time on the x-axis and dF/dt (in Newtons per second) on the y-axis. This rate-of-change signal reveals how rapidly the cell is expanding or contracting mechanically. In the early stages of charging (before ~56,000 seconds), the derivative fluctuates significantly as force begins to build. As the cycle progresses into the Mn plateau region (highlighted by the green box from ~60,000 to ~64,500 seconds), the fluctuations or oscillations in the upward trend of the dF/dt flatten, and the changes in dF/dt exhibit lower-magnitude positive values, reflecting slower but sustained expansion even while voltage is constant. This behavior further reinforces the diagnostic value of swelling force signals: not only does the absolute force provide an indicator of SOC, but the derivative of force (dF/dt) offers insight into cell dynamics and intercalation kinetics that would otherwise be obscured.

Collectively, these plots demonstrate that swelling force is a valuable, chemistry-sensitive indicator that directly reflects lithium ion intercalation into LMFP electrodes. Unlike voltage, which loses resolution in plateau regions, swelling force evolves continuously with SOC, including during the Mn redox phase. By capturing both the absolute force and its rate of change, the system described in this disclosure can enhance SOC tracking accuracy, especially in regions where voltage-based estimators are unreliable. Figure 11 thus supports the third aspect of the invention by validating the use of real-time swelling force measurements as a primary or supplemental signal for estimating the SOC of LMFP cells. These aging-induced changes demonstrate that swelling force can also serve as a mechanical indicator of SOH, providing complementary information to electrical health metrics like DCIR or capacity fade. By tracking how the swelling force profile evolves over time, the system can identify degradation modes such as loss of active material, SEI growth, or binder breakdown-phenomena that may not significantly alter voltage response but clearly affect mechanical dynamics.

Together, the Figures 11A-C illustrate the multi-dimensional diagnostic potential of swelling force: (i) as a high-resolution SOC estimator in flat-voltage regions; (ii) as an indicator for the single point SOC estimation-30%; and (iii) as a mechanical degradation monitor capable of detecting subtle SOH trends.

These insights support the integration of swelling force into advanced BMS strategies, particularly in LMFP chemistries where traditional electrical observables fall short. The diagram thereby advances the case for using force-based sensing as a primary or supplemental channel in real-time battery state estimation.

Figures 11A-C present experimental data that demonstrates how swelling force can be used to estimate SOC for an LMFP battery cell over its cycle life. This figure combines measured force profiles from multiple cycles to show how force behavior changes as the cell ages.

Figures 12A-B present a flowchart detailing a method for estimating the state of charge (SOC) of an LMFP battery cell 1200 using real-time measurements of swelling force. This process formalizes the conceptual and empirical groundwork shown in Figures 10 and 11A-C by embedding swelling force into a continuous estimation and recalibration loop that complements conventional electrical sensing. The method is specifically adapted to the electrochemical and mechanical characteristics of LMFP cells, particularly the manganese plateau region, where voltage-based SOC estimation lacks resolution.

The flow begins with the acquisition of physical signals from the battery cell 1202, most notably the swelling force, measured using force sensors placed within the mechanical structure of the battery module. Figure 12B is an illustration of the battery cells/pack 1220 with pressure sensor sheets 1222. These sensors 1222 may be piezoelectric, strain-gauge-based, capacitive, or resistive types integrated within compression plates, structural walls, or intercell supports. The sensors 1222 may be placed between battery cells 1220 or on a single cell 1220 to form a alternating stack 1224 for real time swelling force measurements during application. Alongside swelling force, the system also acquires conventional electrical measurements such as cell voltage, current, and temperature to allow for multi-parameter estimation.

The initial SOC is estimated 1204 using a baseline method, which could be coulomb counting, a model-based observer, or a Kalman filter. This estimate is flagged for confidence assessment, especially in regions where OCV is known to be flat or nonlinear-most critically between approximately 30% and 70% SOC for LMFP, where voltage offers limited diagnostic sensitivity.

In step 1206, the method 1200 determine if the operating region falls within this low-resolution zone, or if estimator uncertainty is high, the system activates the swelling force-based SOC correction module. This module 1208 receives the real-time swelling force signal and compares it against one or more of the following: (i) a calibrated lookup table that maps swelling force to SOC across multiple temperature and aging conditions; (ii) a parametric curve fit or model based on lab-measured swelling profiles for the specific cell type; or (iii) a machine learning model trained to infer SOC from force, current, temperature, and historical cell behavior.

The force-based SOC is then derived from this mapping and compared to the electrically estimated SOC 1210. If the deviation between the two estimates exceeds a confidence threshold 1212, the swelling-force-based estimate is used to correct the primary SOC value 1214. Correction may be applied (i) directly (hard reset), (ii) incrementally (blending or filtering), or (iii) selectively based on a region-dependent weighting scheme.

The process then feeds this corrected SOC back into the main estimation loop, updating any associated model states, such as the initial condition of a Kalman filter or the state vector of a particle filter. This corrected SOC is used for downstream decisions, including charge/discharge control, thermal regulation, and SOH monitoring.

In parallel, the system may log swelling force behavior for diagnostic purposes using two different methods: single-point SOC verification at 30% SOC (as discussed in Figure 11B) and SOC estimation using dF/dt. Trends in (i) force magnitude, (ii) rate of change (dF/dt), and (iii) hysteresis over cycles may be used to flag mechanical fatigue, gas generation, separator swelling, or degradation of electrode adhesion-phenomena not detectable from voltage and current alone.

The method is designed to operate in real time, with force updates processed synchronously or asynchronously with electrical measurements, depending on sensor latency and sampling rate. It may also be configured to trigger recalibration events or alarms if measured swelling behavior deviates from known aging or operating profiles.

In summary, the flowchart of Figure 12 integrates swelling force into a robust, closed-loop SOC estimation framework that enhances estimation accuracy in the most challenging operating regions of LMFP cells. By embedding a mechanical signal directly into the estimation path, the method achieves redundancy, improves fault tolerance, and unlocks new diagnostic capability unavailable through purely electrical sensing.

Figures 13A-C are charts that collectively illustrate how multiple features of swelling force-measured over time and across cycles-can be used to estimate and monitor the state of health (SOH) of LMFP battery cells with high granularity and temporal resolution. This approach breaks down the swelling force signal into discrete, trackable components that correlate with progressive mechanical and electrochemical degradation.

Figure 13A(left) shows the full-cycle swelling force profile of a fresh LMFP cell, plotted against time. In other words, the cell in Figure 13A has an SOH of 100%. The force increases during charging and decreases during discharging in a nearly symmetric and reversible pattern. The key features determined from the chart include (i) F_min, the baseline force at the beginning of the charge cycle; (ii) F_max, the peak force at full charge; (iii) ΔF, the total dynamic range of force (F_max - F_min); and (iv) dF/dSOC, the slope or gradient of the force curve, particularly in flat-voltage regions.

Figure 13B (middle) presents the same swelling force profile recorded after the cell has undergone substantial aging, such as 1000 charge-discharge cycles. While the overall shape is preserved, key deviations are evident: (i) F_min has increased, indicating residual mechanical strain, gas generation, or permanent electrode swelling; (ii) F_max may have shifted higher or lower, depending on changes in active material utilization or internal pressure; (iii) the slope dF/dSOC is reduced or nonlinear, suggesting altered lithium diffusion or structural fatigue; and (iv) the force profile may exhibit hysteresis or lag during dynamic cycling, signaling loss of elastic response in cell components.

Figure 13C(right) synthesizes these observations by plotting extracted swelling force features-such as ΔF, F_min, or dF/dSOC-against SOH (expressed as a percentage of nominal capacity). This chart shows a clear monotonic relationship between the force-derived metrics and cell health. For instance, a decreasing ΔF or increasing F_min may correlate linearly or exponentially with declining SOH. The plotted trend can be used to derive a mapping function or train a regression model that predicts SOH from real-time swelling force data.

The system implementing this methodology would continuously monitor swelling force over many cycles, extract relevant features during each charge/discharge event, and feed them into a data processing pipeline. Depending on system design, the mapping from swelling features to SOH can be (i) analytical (e.g., curve fitting or polynomial regression); (ii) statistical (e.g., multivariate linear regression or principal component analysis); or (iii) data-driven (e.g., neural networks or ensemble models trained on a labeled dataset).

This force-based SOH estimation strategy complements electrical methods such as coulombic efficiency or impedance spectroscopy, and may detect aging mechanisms-such as gas evolution, mechanical deformation, or electrode delamination-that are not evident in voltage or current data. It provides particular value in LMFP systems, where aging often progresses with limited electrical signature until late stages.

Figures 13A-C thus demonstrates a multi-feature approach to SOH estimation based on swelling force, transforming mechanical measurements into a high-value diagnostic signal for long-term battery health tracking.

Figure 14 presents a flowchart outlining a process 1400 for estimating the state of health (SOH) of an LMFP battery cell using swelling force deviations from baseline profiles. Unlike

Figures 13A-C, which focuse on extracting absolute or trend-based features from force data, the method illustrated in this flowchart is designed to perform active comparison between real-time swelling force measurements and previously established reference behavior under controlled conditions. The process 1400 may use data from the alternating stacks 1224 illustrated in Figure 12B.

The process begins with the initial acquisition of swelling force data 1402 during a normal charge-discharge cycle. The force sensor continuously records mechanical expansion and contraction as the cell is cycled, and this data is synchronized with SOC estimates derived from conventional means (e.g., coulomb counting or model-based observers).

Next, the system normalizes the real-time force data based on contextual parameters 1404 such as ambient and internal temperature, charging current rate (C-rate), and cell orientation, all of which may influence mechanical response. This normalization ensures that comparisons across different operating conditions are valid and consistent.

The system then proceeds to feature extraction 1406, isolating key swelling force characteristics over the cycle, including (i) F_min and F_max (minimum and maximum swelling force during the cycle); (ii) ΔF (total swelling force amplitude); (iii) dF/dSOC (slope or curvature of force vs. SOC); (iv) force hysteresis between charge and discharge; and (v) cycle-to-cycle drift or shift in the force baseline.

Once features are extracted, the system accesses a reference database or embedded model containing baseline swelling force profiles corresponding to known SOH levels and compute the deviation between the measured force features and the corresponding values from the reference 1408. This reference dataset may be derived from lab testing, in-field monitoring of new cells, or manufacturer-specified nominal behavior.

The nature and magnitude of these deviations-such as increased baseline force, diminished ΔF, or altered slope-are then mapped to SOH 1410 using a predefined relationship or learned model. The mapping function may be (i) linear, (ii) nonlinear, or (iii) probabilistic depending on the implementation. For example, a 10% increase in F_min combined with a 20% reduction in ΔF may correspond to a 15% drop in SOH.

The estimated SOH is passed forward as a system output and may be logged for future trend analysis, fused with other SOH metrics (e.g., capacity fade or DCIR rise), or used to trigger alerts or pre-emptive maintenance actions. The system may also apply a feedback mechanism, updating the reference profiles based on recent operating history to account for evolving behavior in specific cells or packs.

The flowchart concludes by returning to the acquisition phase, enabling the process to operate in a continuous loop. This real-time SOH estimation strategy provides a highly sensitive, non-invasive diagnostic path by capitalizing on the mechanical behavior of LMFP cells-particularly in areas where conventional electrical health indicators offer delayed or noisy response.

Figure 14, therefore, establishes a structured method for using swelling force deviations as a reliable, model-informed indicator of SOH, enabling predictive diagnostics and smarter lifecycle management of LMFP battery systems.

In various implementations, the swelling force measurement described in the third aspect of the present disclosure can be realized using a wide range of sensor configurations and mechanical integration approaches to ensure robust, accurate, and cost-effective operation within a battery pack. One effective approach includes the use of a compliant force transfer structure, such as a flexible mesh or lattice, positioned between individual cells or between modules within a multi-module pack.

For example, in a stacked cell assembly, a mechanically responsive mesh can be inserted between each cell and its neighboring cell. This mesh serves two functions: first, it uniformly distributes the normal force generated by electrode expansion across the sensing surface, and second, it allows local pressure changes to be averaged or resolved over a desired area. The mesh can be constructed from a resilient metallic or polymer material with sufficient flexibility to deform under low mechanical loads while retaining shape memory to recover during electrode contraction.

In one configuration, a dedicated force or pressure sensor is mechanically coupled to the mesh, either embedded within the mesh layers or mounted adjacent to the mesh so that the swelling force is transmitted through the mesh to the sensor element. This arrangement enables precise measurement of the force exerted as the cell electrodes expand during charging and contract during discharging.

The mesh can be deployed with different coverage patterns depending on the design goals and available space. In some implementations, the mesh spans the entire major face of each cell or module, capturing the full force profile across the active area. In other implementations, the mesh covers only a portion of the surface - such as a central region or an edge region known to exhibit the highest expansion - to localize measurement and reduce hardware cost or complexity. Multiple smaller meshes can also be distributed at discrete points across the cell or module face to provide spatial resolution of swelling force distribution if desired.

In module-level designs, a single mesh layer may be shared by a plurality of cells within a module, with force transfer to a common sensor or array of sensors. Alternatively, the mesh can be arranged to span multiple modules, such that each mesh element bridges two or more modules stacked or aligned in series. This arrangement allows a single sensor assembly to detect aggregate force changes representative of the combined swelling behavior of several modules.

The mesh and sensor system can be oriented to detect force in any desired direction relative to the cell stack: perpendicular to the cell face (normal expansion), along an edge (radial or lateral expansion), or even tangentially if needed for specialized designs. The mechanical mounting of the mesh can include compliant spacers, elastomeric damping pads, or rigid stops to ensure that only the desired expansion force is transmitted to the sensing element while minimizing interference from pack-level mechanical shocks or vibrations.

In a practical implementation, the mesh-sensor assemblies can be integrated into the structural frame of the battery module or pack casing. For example, the mesh can be bonded to the inner surface of a pack cover plate, with the sensor mounted in a protective cavity on the outer side of the cover. As the cells expand during normal operation, the mesh flexes slightly, transferring force to the sensor without imposing excessive stress on the cell housing.

Functionally, the swelling force signals collected from the mesh-coupled sensors are routed to the battery management system (BMS), where they are conditioned, digitized, and fused with electrical measurements such as voltage, current, and temperature. The BMS applies an estimation algorithm that dynamically adjusts the weighting of the swelling force signal based on the region of the charge curve, operational temperature, and historical data trends.

This mesh-based force sensing configuration provides a robust, scalable solution for both single-cell packs and large multi-module arrays. It enables accurate, physics-based SOC and SOH estimation with minimal impact on the existing mechanical design of the pack, and it can be manufactured using standard assembly processes with modest additional cost.

By providing multiple deployment options - per-cell meshes, per-module meshes, shared meshes spanning multiple modules, and selective partial coverage meshes - the described system accommodates various packaging constraints, cost targets, and performance requirements while preserving the core benefit: a direct, in-situ measurement of electrode expansion that enhances the accuracy and reliability of battery health and charge estimation for LMFP and other similar chemistries.

In addition to the mesh-based force transfer arrangement described above, other conventional force and pressure sensing techniques known in the field can be employed to implement the swelling force measurement method described in this disclosure. For example, in one practical implementation, a thin film pressure sensor or piezoresistive sheet can be laminated directly between adjacent cells or between a cell stack and the structural compression plate of a battery module. Such thin film sensors are commercially available and can detect small changes in compressive force with high sensitivity.

In a stacked prismatic cell module, a conventional compressive force sensor may be positioned beneath the end plate or compression bar that holds the cell stack together. As the cells expand during lithium intercalation, they exert additional force against the end plate, which is transmitted to the underlying force sensor. This arrangement leverages the mechanical preload structure already present in most battery packs to maintain stack integrity, adding minimal hardware complexity.

Alternatively, a series of discrete pressure sensors or load cells can be embedded at multiple points along the edges or corners of the module casing. These sensors detect localized swelling or overall stack expansion and feed individual force readings to the battery management system. Using multiple sensors provides spatial resolution, enabling the system to distinguish between uniform swelling due to normal intercalation and localized swelling that could indicate gas generation or structural damage.

Another common approach adaptable for this method is the use of strain gauges bonded to the inner or outer surfaces of the cell housing or module enclosure. As the cell swells during charging, the slight expansion causes micro-strain in the housing or clamping components. The strain gauges convert this deformation into an electrical signal that correlates with the internal swelling force. This technique is cost-effective and well-established in industrial measurement applications.

In any of these conventional hardware configurations, the physical measurement signal - whether it is pressure, force, or strain - is processed in the same functional manner described for the mesh configuration: it is continuously monitored alongside voltage, current, and temperature, and it feeds into an estimation algorithm that enhances SOC determination in the manganese plateau region and improves SOH tracking by revealing long-term mechanical changes indicative of cell aging.

Regardless of whether the swelling force is measured using a flexible mesh sensor interface, a conventional piezoresistive film, a compression plate force transducer, or bonded strain gauges, the novel aspect of the disclosure lies in how this mechanical signal is interpreted as a real-time electrochemical state estimator, integrated into the control logic, and adaptively weighted against electrical signals for accurate SOC and SOH management in LMFP battery systems.

These implementation variations demonstrate that the system is versatile and compatible with established sensor technologies, enabling practical deployment in different pack designs and manufacturing processes without fundamentally altering the underlying benefit of improved charge state resolution and lifetime diagnostics for LMFP chemistries.

### Integration of the Third Aspect with the First and Second Aspects

The system and methods described in the third aspect of the present disclosure can be used in combination with either or both estimation techniques described in the first and second aspects, providing a flexible and layered framework for determining the SOC and SOH of an LMFP battery cell or pack.

In the first aspect, each cell's SOC and SOH are estimated primarily using electrical signals - including voltage, current, and temperature - processed through a model-based estimator that performs coulomb counting, voltage cross-checking, and thermal corrections. This approach forms the baseline cell-level estimation and control structure in modern battery management systems.

The second aspect introduces an independent, physics-based check on SOH by exploiting the predictable shift of the charge curve's transition region during cell aging. By measuring the SOC at a selected transition voltage, the system derives an empirical estimate of capacity fade that complements the first aspect's electrical model.

The third aspect adds a mechanical dimension by monitoring swelling force, which directly reflects electrode expansion and contraction during lithium intercalation and deintercalation. This force signal is especially valuable for improving SOC estimation accuracy in the manganese plateau region where the open circuit voltage is flat and less sensitive to SOC changes. Over time, the force signal also provides insight into

### Conventional Techniques and Their Technical Limitations

In the field of lithium-based battery management, and specifically for lithium manganese iron phosphate (LMFP) battery systems, conventional techniques for estimating key state parameters such as state of charge (SOC) and state of health (SOH) face persistent technical challenges. Traditional estimation strategies typically rely on coulomb counting in combination with open circuit voltage (OCV) correlation to determine SOC. While effective for certain cell chemistries, these methods become less accurate when applied to LMFP cells due to the presence of a flat OCV plateau near the manganese redox region. In this region, significant lithium intercalation or deintercalation may result in minimal changes in terminal voltage, thereby obscuring real-time SOC estimation and introducing uncertainty that can impair pack-level control and balancing.

Some prior approaches have sought to address this challenge by incorporating displacement sensors, such as strain gauges or extensometers, mounted directly to the cell casing to detect micrometer-scale geometric deformations caused by electrode expansion and contraction during cycling. While theoretically sound, this technique requires extremely high measurement precision and can be prone to mechanical noise and environmental disturbances, which limit its robustness in practical, pack-level deployments. Other conventional designs propose using pressure or force measurements in conjunction with fuel gauge processors or load cells. However, these configurations are generally restricted to laboratory-scale experiments or are implemented with bulky load cells at module end plates, which limits their feasibility for high-density battery packs where space and weight are tightly constrained.

Moreover, certain conventional methods embed pressure-sensitive film sensors directly within the electrode winding of the cell, which introduces concerns about manufacturing complexity, increased cost, and potential interference with electrochemical processes due to direct exposure to the internal cell environment. Experimental studies described in non-patent literature have demonstrated the feasibility of stack pressure measurement for SOC prediction under controlled conditions, but they stop short of providing a robust, real-world solution that can be integrated with a comprehensive battery management system (BMS) to deliver continuous, closed-loop SOC and SOH monitoring throughout the service life of a high-capacity LMFP pack.

The present disclosure overcomes these longstanding technical limitations through an innovative architecture that integrates direct swelling force measurement into a robust, closed-loop BMS specifically optimized for LMFP chemistry. Rather than relying on micrometer-scale displacement detection or embedding sensors within the cell's internal structure, the disclosed system deploys thin, flexible pressure sensors positioned externally between individual battery cells within the pack structure. This non-intrusive configuration captures the absolute swelling force generated by electrode expansion and contraction during charge and discharge cycles, providing a clean and robust physical signal that correlates directly with the electrochemical state of the cell. Empirical data, as shown by way of non-limiting example in Figures 10 through 13, confirms that this swelling force can reach magnitudes in the kilonewton range for LMFP cells, offering a substantially higher signal-to-noise ratio compared to displacement-based measurements.

By incorporating this real-time force signal into the estimation logic, the system effectively resolves the SOC estimation challenge in the flat OCV plateau region of LMFP cells. The swelling force behaves as a dynamic, physical indicator of lithium ion intercalation and deintercalation, complementing traditional voltage and current measurements and thereby enabling precise SOC estimation across the entire operating range. Additionally, the system continuously monitors the swelling force profile over the battery's operational lifetime, providing meaningful insights into cell aging processes such as gas generation, irreversible expansion, and structural degradation. Through derivative analysis of the force signal (dF/dt) and comparative trend evaluation, the BMS detects early signs of capacity fade or abnormal degradation, which enhances SOH estimation accuracy and supports timely predictive maintenance.

This force-based monitoring approach is inherently scalable and practical for real-world deployment. Unlike conventional load cells or embedded sensors, the pressure sensor sheets used in the present system are thin, flexible, and can be seamlessly integrated into existing module designs without necessitating changes to internal cell architecture or adversely impacting thermal management. This makes the system highly compatible with heavy-duty LMFP battery packs designed for electric vehicles and large-scale stationary storage, where robust estimation and long cycle life are critical.

Furthermore, the disclosed system does not rely solely on swelling force. It enhances estimation performance by combining this physical signal with standard electrical measurements and advanced computational techniques, including an adaptive bar-delta Kalman filter and multipath recalibration strategies. As illustrated by non-limiting examples in Figures 1 through 8, this hybrid architecture mitigates drift, adjusts dynamically for measurement noise and model uncertainties, and provides high-fidelity SOC and SOH estimates under diverse operating conditions.

In summary, the disclosed system provides a novel, robust, and commercially viable solution that substantially improves conventional techniques for LMFP battery state estimation. By leveraging swelling force as an in-situ physical signal, the invention resolves the inherent limitations of flat OCV regions that challenge voltage-based estimation methods. It eliminates the need for intrusive internal sensors or micrometer-level displacement measurements, reduces manufacturing complexity, and delivers a practical, pack-level monitoring solution that can be readily integrated into modern battery packs without compromising safety or design constraints.

Combined with a closed-loop estimation framework and advanced recalibration algorithms, this approach enhances estimation accuracy, prolongs usable pack life, supports predictive maintenance, and enables safer, more efficient operation in heavy-duty applications. Collectively, these technical improvements address longstanding gaps in the state of the art and advance the field of battery management for next-generation LMFP systems.

### First, Second, and Third Aspects of the Disclosure

The third aspect can be employed in various configurations. When combined with the first aspect, the swelling force measurement complements the model-based state-of-charge (SOC) and state-of-health (SOH) estimation by providing an additional physical signal. This signal enhances resolution in plateau regions and helps validate the output of the electrical model. Alternatively, the third aspect can be used with the second aspect alone; in systems that do not use a complete electrical estimation model, the swelling force measurement can work in tandem with the transition region shift method. In this setup, both techniques offer independent physical indicators - one derived from electrochemical plateau behavior and the other from mechanical expansion - ensuring robust SOC and SOH estimation without depending solely on coulomb counting. Finally, when all three aspects are implemented together, the system leverages multiple independent signals - electrical, electrochemical plateau shift, and swelling force - to cross-check SOC and SOH in real time. This multi-layered approach significantly enhances reliability and enables early detection of anomalies, providing the highest level of diagnostic resilience for demanding applications.

Regardless of the chosen configuration, the battery management system dynamically weights the swelling force data in its estimation logic based on operating conditions. When the cell operates in a voltage region with high measurement uncertainty, the system gives greater priority to the swelling force input to resolve SOC accurately. For long-term SOH tracking, the force trend is compared with transition region shifts and electrical model predictions, improving confidence and enabling corrective actions if discrepancies arise.

This flexible integration ensures that the third aspect can be tailored to a wide range of system architectures, cost targets, and performance requirements, while consistently delivering the core benefit: enhanced SOC and SOH estimation for LMFP chemistries using a reliable, physics-based swelling force measurement in connection with one or both of the other estimation techniques.

### FOURTH ASPECT OF THE DISCLOSURE

The fourth aspect of the present disclosure provides an additional system and method for enhancing the accuracy of state-of-charge (SOC) estimation in lithium manganese iron phosphate (LMFP) battery cells, specifically addressing the known challenge posed by the manganese (Mn) redox plateau. In this region, the open-circuit voltage (OCV) profile is substantially flat, which severely limits the sensitivity of voltage-based SOC estimation. To overcome this, the fourth aspect introduces an impedance-based approach that utilizes direct current internal resistance (DCIR) measurements obtained through the application of multiple diagnostic current pulses with different intensities and durations.

In operation, this system is integrated within a battery management system (BMS) that is configured to opportunistically or deliberately apply a sequence of current pulses while the battery is in an appropriate operating state, such as a rest period or under low-load conditions. The BMS measures the voltage response for each pulse in real time and calculates the DCIR by dividing the instantaneous voltage change by the applied current step. It has been observed through extensive testing that the resulting DCIR is not constant but varies systematically based on both the magnitude and the duration of the applied current pulse, even when the SOC remains fixed. By capturing these dependencies, the BMS gains access to a richer electrochemical signature that provides additional resolution in SOC estimation where traditional signals lack discrimination power.

This method is particularly suited for the high-SOC manganese plateau region where SOC can fluctuate meaningfully without noticeable voltage change. The BMS maintains a pre-characterized look-up table or an embedded parametric model that relates DCIR values to SOC for a range of pulse magnitudes and durations, as well as temperature and cell-specific conditions. By matching the observed DCIR pattern to this stored calibration, the system determines an updated SOC estimate with significantly improved fidelity, even in regions of low voltage slope.

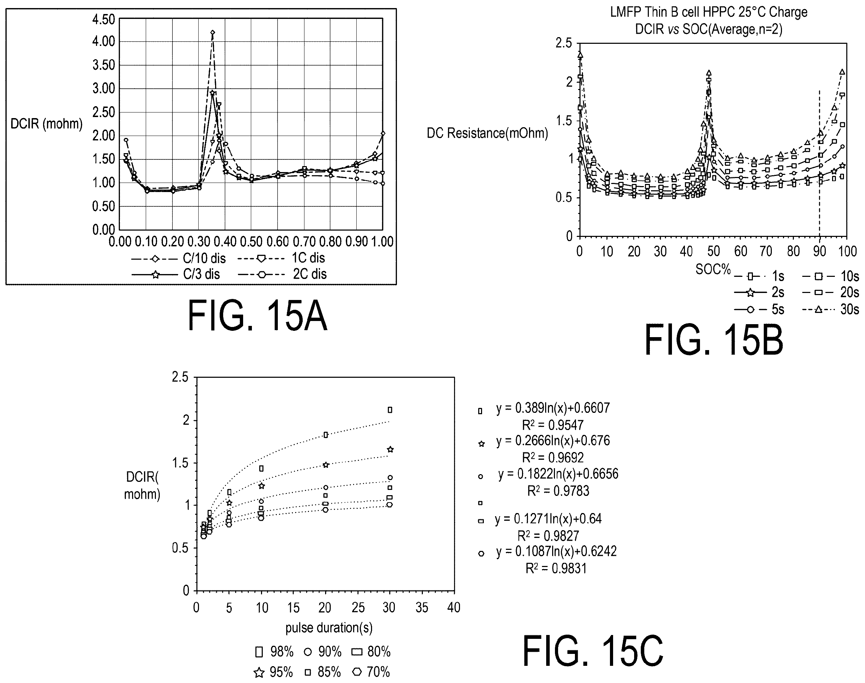

Figures 15 through 17B relate to the fourth aspect of the present disclosure, which introduces an impedance-based method for enhancing state of charge (SOC) estimation in LMFP battery cells, with a particular focus on overcoming the challenges posed by the flat open-circuit voltage (OCV) profile in the manganese (Mn) plateau region. In this region-typically spanning 70% to 100% SOC-the OCV remains nearly constant, making traditional voltage-based estimation unreliable and insensitive to meaningful changes in lithium content.

To address this limitation, the fourth aspect proposes using direct current internal resistance (DCIR) as a dynamic, SOC-sensitive signal. This approach involves applying diagnostic current pulses of varying intensities and durations, and then calculating DCIR from the measured voltage response. Unlike OCV, DCIR has been observed to vary systematically with SOC under controlled conditions, even when the voltage remains flat-providing a new, high-resolution pathway for estimating cell state.

Figures 15A-C establishe the experimental foundation for this method by showing that DCIR varies significantly with both pulse intensity and pulse duration, especially in the high-SOC Mn plateau. These variations are repeatable and distinct, revealing latent electrochemical behavior that is not captured by voltage alone. The flat OCV in the Mn region of the LMFP cell poses a significant challenge for state-of-charge (SOC) estimation based on open-circuit voltage (OCV). The DCIR measurements show that at the same SOC, DCIR values vary with pulse intensity or duration, indicating that the DCIR results with multiple pulse intensities or duration could be used as a SOC indicator in the high SOC range (70-100%).

Figures 16A-B operationalizes the insights of Figures 15A-C by outlining a real-time flowchart for calculating SOC from measured DCIR values using pre-characterized resistance profiles. This system integrates into a battery management system (BMS), enabling in-field, pulse-based recalibration that complements or corrects conventional estimators. Figure 16A is a graph illustrating the change in current (DCIR) with different pulse intensities over time. This DCIR separation may be used as an indicator of SOC. Figure 16B exemplifies a method 1600 of estimating SOC based on the relation between DCIR and SOC. In block 1602 the system detects if BMS is switched to driving or charging mode after a long relaxation. In block 1604 the system monitors current and detects if current can be held at a certain value for a desired duration. At black 1606, the system detects voltage at the end of the desired duration. Next, at block 1608, the system calculates DCIR for the duration of time. Using all this information, the system estimates SOC based on the pre-determined relationship between DCIR and SOC at block 1610.

Figures 17A and 17B build on this by detailing how DCIR measurements collected during live operation can be matched to a reference database of pulse-duration profiles to yield accurate SOC estimates in practical scenarios. The system may measure cell DCIR with different pulse durations in real applications to obtain the relationship between DCIR and pulse duration. This testing may allow the system to pre-determine the relation between DCIR and pulse duration at different SOCs. As shown in Figure 17B, a method 1700 of using the DCIR measurements to yield accurate SOC estimates is shown. In block 1702, the system detects if BMS is switched to driving or charging mode after a long relaxation period. Then, the system monitors current and detcts if current can be held at a certain value for a desired duration at block 1704. At black 1706, the method 1700 includes calculating DCIR every certain seconds. The method 1700 then uses the calculated DCIR to estimate SOC estimates in block 1708.

Together, Figures 15A-C, 16, and 17A-B define a robust, non-invasive, and chemistry-specific solution for SOC estimation in LMFP systems. By leveraging the dynamic impedance response of the cell to structured current pulses, this fourth aspect extends the observability of battery state into regions where traditional techniques are insufficient-thereby enhancing estimation fidelity, enabling smarter control, and supporting more reliable operation across the full charge range.

Figures 15A-C present a multi-panel experimental diagram demonstrating how direct current internal resistance (DCIR) in lithium manganese iron phosphate (LMFP) battery cells varies with both pulse intensity and pulse duration, even at fixed states of charge (SOC). This figure supports the use of DCIR as a high-resolution, non-invasive SOC estimation tool in the manganese (Mn) redox plateau region, where voltage-based estimation methods suffer from low sensitivity due to a characteristically flat open-circuit voltage (OCV) profile. The data shown in this figure were generated under controlled laboratory conditions using calibrated test protocols and reflect repeated measurements on thermally stabilized LMFP cells.

At the top of the figure, the title explicitly frames the innovation: DCIR with multiple pulse intensities or durations as an SOC indicator in the Mn region of LMFP cells. Beneath it, a contextual annotation explains the problem: in the Mn plateau region (typically covering ~70% to 100% SOC), the OCV of LMFP cells exhibits minimal slope. This voltage flatness severely limits the ability of conventional voltage-based estimation to resolve incremental SOC changes. However, internal resistance-specifically DCIR-has been observed to vary under different load conditions in a manner that depends not only on SOC but also on pulse parameters, thus offering an additional, exploitable degree of freedom for estimating cell state.

Figure 15A: DCIR as a Function of SOC at Varying Pulse Intensities

The left chart (Figure 15A) plots the measured DCIR of an LMFP cell during charging across a full SOC window (horizontal axis), under a set of predefined current pulse intensities (distinguished by color). The vertical axis shows resistance in ohms or milliohms, derived from ΔV/ΔI during each applied pulse. Each pulse was applied following a rest period to ensure stabilization of voltage and surface reactions prior to measurement. The pulse currents range from relatively mild (e.g., 0.5C) to more aggressive (e.g., 3C or above), simulating typical variations encountered during different usage profiles in electric vehicle or stationary storage applications.

At lower SOC levels (e.g., below 30%), the resistance curves across all intensities tend to cluster closely, indicating that the response is dominated by bulk conductivity and charge transfer resistance, which are not strongly dependent on current density in that region. However, as the SOC increases into the Mn plateau (~70-100%), the curves begin to diverge sharply. For example, at ~85% SOC, a high-current pulse may yield a peak resistance that is 2-3× greater than that measured at the same SOC using a lower pulse current. This nonlinear behavior is consistent with diffusion-limited processes, surface saturation effects, or stress accumulation in the electrode material under higher currents-each of which may be influenced by SOC in a way that does not manifest in the voltage signal alone.

The sharp peaks and inflection points in the high-SOC portion of the chart indicate that DCIR contains embedded structural or kinetic information that correlates with lithium occupancy in the Mn sites, electrolyte accessibility, or possibly dynamic contact resistance changes due to mechanical expansion. These features are both repeatable and differentiable across pulse intensities, confirming that a single SOC value can yield distinct DCIR fingerprints depending on the pulse strategy used-thus enabling richer state estimation when multiple pulses are employed in sequence or adaptively.

The right-hand chart (Diagram 15B) explores the pulse duration dimension, plotting DCIR at different SOC levels for pulses of varying time lengths (e.g., 1s, 3s, 5s, 10s). The methodology again involves stabilizing the cell, applying a current pulse of fixed magnitude but varying length, and calculating DCIR from the initial voltage drop. The curves show how resistance evolves as a function of SOC under different temporal load conditions.

In the mid-SOC range (~40-70%), resistance changes with duration are modest and largely monotonic. However, in the Mn plateau region (>70%), a clear separation emerges among the duration-dependent curves. Longer pulses tend to result in slightly lower resistance values at low SOC but higher and more variable resistance peaks at high SOC. This implies that under longer load durations, additional resistive mechanisms are activated-such as ionic diffusion limitations, interfacial polarization, or electrode saturation-which are time-dependent and sensitive to lithium occupancy.

Moreover, some curves exhibit a "double-hump" or inflection shape-most visible between ~80% and 95% SOC-which suggests the presence of multiple overlapping kinetic regimes. These effects are not visible in standard OCV-SOC or voltage-time curves and only become apparent through impedance-based probing with time-varying stimuli.

Together, Diagrams 15A and 15B demonstrate that DCIR is not a static scalar quantity, but a multi-dimensional response surface influenced by SOC, current magnitude, and time. The LMFP cell's internal resistance profile becomes richer and more distinguishable when these variables are modulated systematically. From a diagnostic standpoint, this means that SOC can be more accurately inferred in voltage-insensitive regions (such as the Mn plateau) by referencing a library of DCIR signatures obtained through controlled pulse testing.

This insight enables the construction of a calibrated SOC-DCIR lookup table or parametric model that maps observed resistance responses to SOC, accounting for both pulse conditions and ambient factors like temperature. Implemented within a battery management system (BMS), this method would allow for opportunistic or scheduled pulse injections-during low-load periods or rest phases-followed by instantaneous SOC recalibration based on the measured DCIR signature.

Figures 15A-C provide empirical validation of the core hypothesis in the fourth aspect of the disclosure: that DCIR variation with pulse intensity and duration can serve as a non-invasive, high-resolution SOC indicator, particularly in the manganese plateau region where conventional methods are inadequate. The figure demonstrates that even at constant SOC, LMFP cells produce unique and repeatable resistance profiles under different excitation conditions. By exploiting these profiles, the system can overcome limitations of flat-voltage chemistries and achieve more accurate and robust SOC estimation across the full operating range.

Figure 16 presents a flowchart that outlines a method for estimating the state of charge (SOC) in lithium manganese iron phosphate (LMFP) battery cells by leveraging direct current internal resistance (DCIR) measurements obtained from controlled current pulses of varying durations. This process translates time-resolved resistance responses into accurate SOC estimates, offering a solution for improved state tracking in LMFP chemistries, particularly within the manganese plateau region where voltage-based estimation becomes unreliable due to minimal OCV slope.

The method begins with the initiation of a controlled diagnostic current pulse, typically applied when the cell is at rest or operating under stable load conditions. The pulse duration may vary from milliseconds to several seconds, and its amplitude is selected based on the desired probing depth into the cell's electrochemical and transport response. After initiating the pulse, the system records the voltage response of the cell across three intervals: before, during, and after the current injection. The voltage drop (ΔV) is then divided by the applied current (I) to compute the DCIR, capturing contributions from both instantaneous ohmic resistance and time-dependent electrochemical processes such as interfacial and diffusion-related impedance.

Following the resistance calculation, the system evaluates the full context of the pulse-its duration, magnitude, ambient and cell temperature, and any preceding rest period-to ensure accurate interpretation of the impedance signature. DCIR measurements are categorized according to pulse length: (i) short pulses primarily reflect ohmic resistance, (ii) medium pulses begin to capture solid-electrolyte interphase (SEI) and interfacial effects, and (iii) long pulses include contributions from lithium diffusion and bulk transport limitations.

Once categorized, the measured DCIR is matched to pre-characterized SOC-resistance profiles specific to the LMFP cell design and its typical operating conditions. This mapping can be performed using one of several strategies: (i) a multidimensional lookup table indexed by pulse duration, temperature, and SOC; (ii) a regression model, such as a polynomial or exponential fit developed from empirical testing; or (iii) a machine learning model trained to predict SOC based on DCIR input along with relevant contextual features such as pulse type, temperature, and resting time.

Based on the selected mapping technique, the system computes an SOC estimate corresponding to the measured DCIR. If more than one pulse duration is used during the diagnostic sequence, the resulting SOC estimates may be fused using a weighted averaging method or a confidence-driven fusion algorithm. This improves robustness by mitigating the effects of transient disturbances, thermal noise, or cell-to-cell variation.

The final SOC estimate is then passed to the main battery management system (BMS) control loop and can be used directly or integrated into a model-based estimator-such as a Kalman filter or particle filter-to update or correct the system's internal state. The associated pulse-response data are logged for future reference, enabling trend tracking, model calibration, or adaptive refinement of the mapping models. If the system determines that conditions are unsuitable for pulse-based estimation-such as high load current, unstable temperature, or active safety overrides-it defers the process and maintains baseline SOC estimation through conventional means.

This impedance-based SOC estimation approach enhances visibility into the state of LMFP cells within voltage-insensitive operating regions and provides an independent estimation pathway that complements existing techniques. Moreover, the DCIR data collected over time can also support aging diagnostics, as gradual resistance evolution is often correlated with capacity loss, interfacial degradation, or heat generation.

Figure 16 thus defines a real-time, pulse-driven SOC estimation methodology tailored for LMFP battery systems. By incorporating DCIR measurements as an additional sensing dimension, the system achieves more accurate and resilient state estimation, especially in chemistries with complex or flat voltage behavior.

Figure 17 presents a detailed visual workflow for a real-time state of charge (SOC) estimation method in LMFP cells, based on the observed relationship between direct current internal resistance (DCIR) and pulse duration. The diagram integrates experimental insights and implementation logic, showing how resistance behavior-measured through carefully timed current pulses-can be mapped to SOC in practical applications, particularly in the voltage-insensitive manganese plateau region. The figure is structured into three interconnected segments: the left side illustrates the measurement process in real-world conditions; the center details the SOC estimation process via reference matching; and the bottom-right outlines the system control logic within the battery management system (BMS).

The left portion of the figure begins with a depiction of the core data acquisition process. A controlled current pulse, labeled as "+3C" and lasting 30 seconds, is applied to the LMFP cell. This duration is chosen to probe beyond the immediate ohmic resistance and into slower electrochemical phenomena such as interfacial or diffusion-based resistance. The voltage response during the pulse is recorded, and DCIR is calculated as the ratio of voltage drop to applied current (ΔV/ΔI). This measurement is taken during actual system operation, underscoring that the approach is designed for field application rather than lab-only analysis. The measured DCIR value is contextualized within a chart that resembles the experimental profiles seen in Figures 15A-C, where DCIR curves vary with pulse duration across different SOC levels.

In the center of the figure, the system uses the measured DCIR value to determine SOC by comparing it with a pre-characterized reference database. This database contains DCIR versus pulse duration profiles across multiple SOC points, typically in the 70-100% range where voltage is flat and conventional methods are ineffective. The system extracts a "real application coefficient" from the live measurement and matches it to the closest corresponding curve in the database. This enables estimation of the current SOC, which is visually represented with battery icons labeled "70%" and "100%," indicating the range over which the method is effective. The matching step may involve direct lookup, interpolation, or model-based estimation techniques depending on the implementation.

The bottom-right section of the figure provides a simplified flowchart that outlines the BMS implementation strategy. The system first monitors whether the current has stabilized at a level suitable for pulse-based estimation. If so, it calculates DCIR at defined intervals-typically every few seconds. Once the resistance data is collected, the system invokes an estimation or fitting routine (indicated by a yellow box labeled "Fitting and estimation?") to determine SOC from the observed DCIR and pulse duration. This estimate can then be passed into the BMS control logic for immediate use or integrated with other estimators, such as a Kalman filter or particle filter, to refine the overall state estimate.

A caption beneath the figure notes that the correlation between DCIR and pulse duration is pre-characterized through lab testing across SOC levels, and that it may be further extended to include temperature, C-rate, or SOH as additional dimensions. This pre-calibration enables robust field deployment by allowing the BMS to track SOC with high accuracy even in operating regions where voltage and current provide limited insight.

In summary, Figure 17 illustrates a complete end-to-end implementation of SOC estimation based on DCIR changes with pulse duration. It shows how controlled current injections, when combined with a calibrated database and contextual filtering, can yield accurate SOC predictions in real time. This method is especially beneficial for LMFP chemistries, where flat OCV profiles limit the effectiveness of traditional approaches.

### Integration with the First, Second, and Third Aspects

This fourth aspect is designed to be flexibly combined with any or all of the first three aspects of the present disclosure, enabling robust multi-signal SOC and state-of-health (SOH) estimation. When deployed alongside the first aspect, which estimates SOC and SOH primarily from electrical measurements and model-based observers such as an adaptive Kalman filter, the multi-pulse DCIR signal provides a valuable cross-check. In regions where the OCV curve has a good slope, the system may rely more on conventional voltage and current integration. However, as the cell transitions into the manganese plateau, the estimation logic dynamically assigns greater weight to the DCIR-derived SOC to mitigate the limitations of voltage flatness and coulomb counting drift.

In conjunction with the second aspect, which monitors the predictable shift in the voltage transition region between the manganese and iron redox plateaus as an indicator of aging and SOH, the fourth aspect ensures that the SOC estimate feeding into the transition point measurement is accurate. This synchronization improves the reliability of the transition region-based SOH diagnostic by verifying that the system correctly identifies the charge state at the fixed transition voltage, preventing errors that might arise from SOC drift in the flat region.

Integration with the third aspect, which leverages swelling force measurements as a physical indicator of electrode expansion and contraction, offers yet another layer of complementary insight. While swelling force provides a mechanical signal that tracks lithium-ion intercalation dynamics, especially useful in the plateau region, the multi-pulse DCIR method supplies an independent electrochemical impedance signature. By fusing these signals, the BMS obtains a multi-physics perspective: mechanical deformation, electrical impedance, and electrochemical voltage all work together to cross-validate the SOC estimate, detect anomalies, and enhance fault tolerance.

When all four aspects are deployed together, the system achieves the highest degree of diagnostic resilience and estimation robustness. The BMS intelligently prioritizes different signals depending on the cell's current SOC region, operating conditions, and known aging profile. For example, when the cell operates in the transition region, the system leverages voltage slope and transition shift data; in the flat manganese plateau, it gives greater weight to the DCIR multi-pulse pattern and swelling force trends; across the full cycle, it continuously refines the SOC and SOH using coulomb counting and model-based estimation. This integrated, adaptive signal fusion minimizes estimation uncertainty, enhances safety, optimizes charge/discharge management, and extends battery service life.

### METHODS

The following section describes methods associated with the implementation, integration, and maintenance of the disclosed SOC and SOH estimation framework for LMFP battery systems. These methods encompass operational procedures for real-time estimation during battery use, assembly techniques for incorporating the framework into battery management systems (BMS), and servicing strategies to ensure continued accuracy and reliability over the battery's lifetime. Each method is designed to be compatible with existing battery hardware architectures and to support high-fidelity diagnostics across a wide range of operating conditions and states of degradation.

### Methods of Operation

During regular use, the system estimates the state-of-charge (SOC) and state-of-health (SOH) of lithium manganese iron phosphate (LMFP) battery cells using a multi-faceted framework that combines Coulomb counting, voltage response, and impedance-based diagnostics. The battery management system (BMS) continuously samples voltage, current, and temperature data during operation, typically at one-second or sub-second intervals, ensuring the system has accurate, high-resolution input for real-time estimation.

Coulomb counting is performed by integrating current over time to estimate net charge flow in and out of the battery. This approach provides high accuracy during active usage but is corrected periodically to compensate for drift or integration errors, particularly during rest periods when other estimation methods can be employed.

Voltage-based SOC estimation relies on mapping the cell voltage to a predefined voltage-SOC curve, which is chemistry-specific and includes adjustments for temperature and hysteresis. This mapping is reliable in regions of the voltage curve that exhibit a strong correlation with SOC, such as the lower and middle sections of the LMFP discharge profile.

In the manganese plateau region, where voltage varies little with SOC, the system supplements voltage-based estimation using either pseudo-open-circuit voltage (pseudo-OCP) reconstruction or a DCIR-based method. These secondary methods enhance resolution in high SOC ranges where traditional methods are unreliable.

The DCIR-based approach applies a series of controlled current pulses during defined operating windows, and the resulting voltage response is analyzed to determine dynamic resistance characteristics that correlate with SOC. This impedance-based information can serve as a primary or corroborative signal, particularly useful under partial rest conditions or during low current load events.

All available SOC signals are combined using a filtering strategy, such as a Kalman filter or complementary filter, to produce a final SOC estimate with improved robustness and confidence. Over time, the system also tracks trends in internal resistance, voltage recovery, and capacity throughput to estimate SOH and detect potential degradation, enabling both real-time control and long-term prognostics.

### Methods of Assembly

The estimation framework is integrated into the battery management system (BMS) during either the manufacturing stage or through a firmware/software update. Physically, the BMS must include current sensing components, such as a shunt resistor or Hall-effect sensor, voltage monitoring circuitry, and a processing unit capable of executing real-time estimation algorithms.

Software for the BMS includes embedded modules for Coulomb counting, voltage-to-SOC mapping, hysteresis correction, temperature compensation, and optionally, impedance analysis routines. These modules are programmed to operate cohesively, sharing common sensor inputs and contributing to a central SOC estimator.

Chemistry-specific characterization data such as voltage-SOC lookup tables, temperature compensation curves, and DCIR-SOC profiles are loaded into memory during assembly. These reference data sets are typically derived from empirical cell testing and tailored to the specific LMFP cell model and application use case.

In some cases, calibration routines may be performed during or after assembly to correct sensor offsets and ensure alignment between measured parameters and expected system response. This may involve placing the pack under known loads or rest conditions and recording baseline performance for future reference.

A verification procedure is then executed to confirm proper function of all sensing channels, estimation algorithms, and communication protocols. This ensures that the SOC estimation system is ready for deployment, with full integration into the vehicle or device's energy management architecture.

### Methods of Servicing

The system supports multiple servicing pathways to maintain or restore estimation accuracy over the lifetime of the battery pack. One key method involves executing diagnostic current pulses-either during scheduled maintenance or remotely triggered by software-under controlled conditions to analyze the DCIR behavior and assess battery state.

Battery data, including voltage, current, temperature histories, and SOC/SOH trends, can be retrieved from the BMS for offline diagnostics or warranty evaluation. This data may be downloaded via a diagnostic port, telematics link, or wireless interface, enabling remote fleet-wide monitoring.

Software or calibration updates may be applied to the BMS to refine estimation algorithms as the battery ages or as new characterization data becomes available. For example, updated voltage-SOC curves or resistance aging profiles may be uploaded to improve performance under evolving operating conditions.

The system also performs internal consistency checks, detecting anomalies such as unexpected shifts in voltage behavior or resistance trends. These deviations may indicate sensor drift, internal short circuits, or accelerated aging, prompting alerts for inspection or service.

If the battery exhibits significant degradation, a recalibration procedure may be initiated to reset internal estimation baselines. This might include redefining the reference capacity, adjusting resistance thresholds, or resetting learned parameters to better reflect current battery condition.

Over the long term, SOH indicators are used to assess whether the battery is approaching end-of-life criteria. This facilitates decisions regarding battery replacement, refurbishment, or second-life applications based on quantifiable degradation metrics.

### Advanced LMFP Battery Architecture and System-Level Design Considerations

LMFP battery devices, systems, and methods disclosed herein leverage advanced materials and manufacturing techniques to optimize performance and reliability. At its core, the cathode and anode form the essential components of the battery. The cathode is the positive electrode and serves as the source of lithium ions during discharge. It is designed to host manganese, iron, and phosphate in a uniform distribution to maximize capacity and cycle life. Nanostructuring the cathode increases its surface area, facilitating faster ion transport and reduced charge transfer resistance, which makes it suitable for high-rate applications. The cathode material is synthesized through a co-precipitation method, ensuring a consistent composition that enhances stability and longevity.

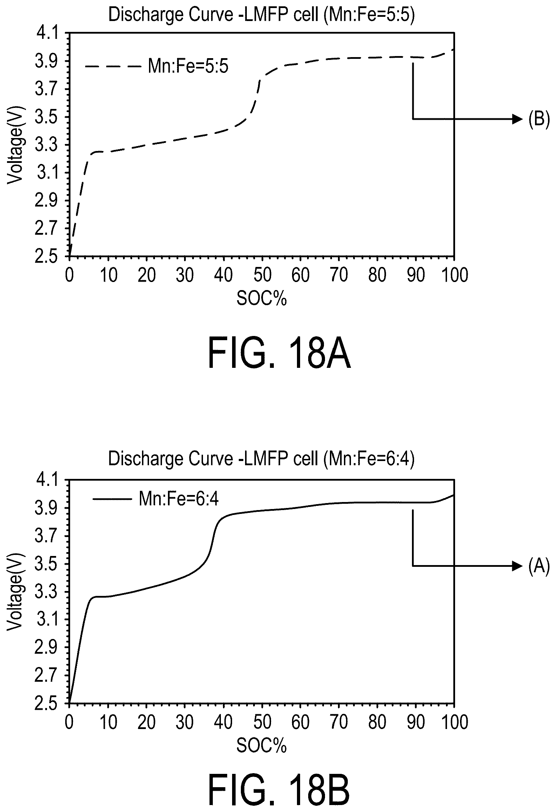

The anode, on the other hand, is the negative electrode of the battery and acts as the recipient of lithium ions during discharge. Principles of this disclosure are applicable for a lithium ion battery with different anode materials such as graphite, silicon, lithium metal, etc. (For example, the results in Figures 18A-D were collected with graphite as the anode.) This composition enables the battery to achieve a balance between energy density and cycle life. The electrolyte in the system, infused with stabilizing additives, forms a solid electrolyte interphase (SEI) on the anode to protect it from degradation and to improve thermal properties.

The cathode material undergoes high-temperature solid-state reactions for synthesis, where precursors are calcined in controlled environments to achieve the desired crystalline structure. The particles are coated with conductive carbon to improve electron transport and durability. Additionally, doping with elements such as magnesium or zirconium enhances the structural integrity of the material, enabling it to withstand repeated charge and discharge cycles without significant degradation.

Electrode fabrication integrates these materials into a cohesive system. The active material is mixed with conductive additives and binders to form a slurry, which is uniformly applied to a current collector. This ensures consistent thickness and minimal defects. After drying and calendaring, the electrodes are assembled into cells that can be cylindrical, prismatic, or pouch-shaped, depending on the application requirements.

Thermal management in the battery system is vital to maintaining operational safety and efficiency. The thermal management system (TMS) incorporates phase change materials to absorb excess heat during high-demand scenarios, and a liquid cooling system ensures even heat distribution throughout the battery pack. Embedded thermal sensors provide real-time data to the battery management system (BMS), which dynamically adjusts operations to optimize thermal performance.

The BMS is a sophisticated control system that monitors and manages the battery's state of charge (SOC) and state of health (SOH). Using advanced algorithms, the BMS can predict performance trends and detect potential issues, ensuring the battery remains within safe operating conditions. Active cell balancing within the BMS extends the overall lifespan of the system by equalizing the charge across all cells, preventing overcharging and undercharging.

To ensure compatibility with various electric vehicle platforms, the battery pack is modular in design. Each module is self-contained with its own control systems, allowing scalability to meet different energy and power requirements. This modular approach simplifies maintenance and recycling, enhancing the sustainability of the overall system.

The electrolyte formulation is a crucial aspect of the battery's performance. High-voltage electrolytes, augmented with advanced additives, stabilize the cathode interface and prevent decomposition at elevated voltages. This extends the battery's operational range and improves energy density without compromising safety. The separator, chosen for its thermal stability and low resistance, enhances safety by preventing internal short circuits while promoting efficient ion transport.

Integrating LMFP batteries into electric vehicles requires standardizing interfaces and ensuring compatibility with existing charging infrastructure. The battery supports fast-charging capabilities, reducing downtime for vehicle owners. Furthermore, the system's inherent resistance to thermal runaway, due to its stable crystal structure and high decomposition temperature, provides an additional layer of safety.

Rigorous quality control during manufacturing ensures high reliability. Each cell undergoes comprehensive testing for capacity, impedance, and thermal stability. Automated inspection systems identify and address potential defects, ensuring consistent performance across all manufactured units.

Sustainability is a cornerstone of the LMFP battery system. By minimizing the use of cobalt and nickel, the environmental and ethical concerns associated with their extraction are reduced. The relatively straightforward composition of the LMFP material facilitates recycling, enabling efficient recovery of key components such as lithium, manganese, and iron.

The LMFP battery system represents a transformative advancement in energy storage technology for electric vehicles. By addressing the limitations of existing lithium-ion batteries, it offers a pathway to safer, more efficient, and sustainable transportation solutions. Each component, from the cathode and anode to the electrolyte and thermal management system, has been meticulously engineered to meet the demanding requirements of modern electric vehicles, setting a new benchmark in performance and reliability.

LMFP battery chemistry is desirable for next-generation solutions, owing to its exceptional attributes such as cost-effectiveness, robust safety profile, and outstanding long-life performance. These qualities make LMFP a promising candidate for addressing the growing demands of advanced energy storage systems.

The present disclosure relates to smoothing a stair-like voltage in LMFP technology with a blended cathode material. More particularly, the present disclosure relates to smooth steep voltage transitions of LMFP batteries through blending different LMFP cathode materials with various ratios. Voltage transitions in LMFP batteries are a defining characteristic that enhances their operational stability and efficiency. During charge and discharge cycles, the lithium ions transition between the anode and cathode through a series of voltage plateaus, which are governed by the redox reactions of manganese and iron within the cathode material. These transitions occur at distinct voltage levels due to the multi-electron processes involved, offering a stable energy delivery profile. The presence of manganese increases the operational voltage range, while iron ensures cost-effectiveness and structural durability. This balance allows LMFP batteries to achieve higher energy densities without compromising cycle life. Additionally, the stable voltage transitions reduce the stress on the electrolyte, minimizing degradation and extending the battery's lifespan.

However, the stair-step nature of the voltage profile presents a significant challenge in practical applications. This distinct voltage behavior complicates the precise monitoring of the SOC and the accurate control of power output. For battery engineers, a smoother, slope-like voltage curve is highly desirable, as it facilitates more efficient BMS development, enabling improved operational control and reliability.

To address this issue, the concept of blending LMFP with Nickel Manganese Cobalt (NMC) has been proposed to smooth out the sharp voltage transitions. Despite these efforts, the characteristic stair-like voltage profile remains evident. Moreover, incorporating NMC into the blend introduces additional trade-offs, including reduced safety performance, a shorter cycle life, and increased production costs. These challenges highlight the need for further innovation and optimization to fully harness the potential of LMFP batteries while mitigating these limitations.

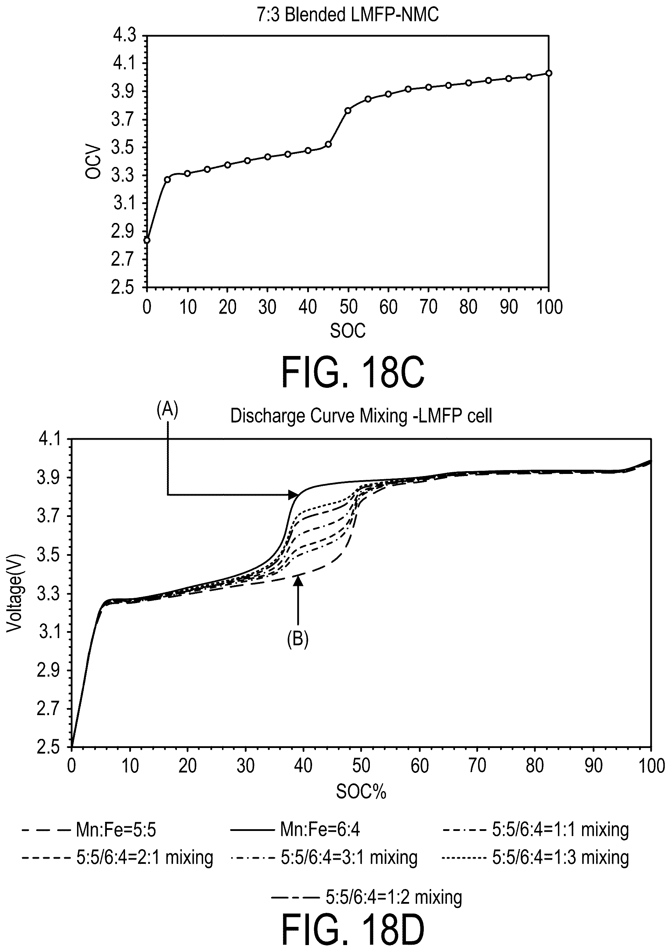

Figures 18-D diagram several discharge curves for an LMFP cell for different chemistries, including Mn-Fe ratios of 5:5 (FIG. 18A), 6:4 (FIG. 18B), 7:3 (FIG. 18C) and mixed variations of these materials (FIG. 18D), such as mixing at 1:1, 1:2, 2:1, 3:1, and 1:3. Although the discharge curves of 6:4 and 5:5 are shown, LMFP cells with Mn-Fe ratio of 7:3 and 6:4 are contemplated and are candidates for evaluation. The voltage curves of blended LMFP cathode are based on the simulation of the voltage of single phase LMFP and for illustration purposes only.

In this light, the present disclosure relates to using blended LMFP with different Mn-Fe ratio to smooth the voltage curve. This will counteract a problem of the two-phase voltage profile with steep transition, which brings challenges in SOC estimation and power control associated with this technology. The blended LMFP includes at least two materials with different Mn-Fe ratios. For instance, these materials can be selected from a group consisting of Mn-Fe ratios of 5:5, 6:4, 7:3, or other similar ratios. By tuning the ratio of different LMFP cathode materials with different Mn-Fe ratios, the LMFP voltage curve can be significantly smoothed, which will benefit the battery control in real application. Advantageously, the blended LMFP will still maintain the advantages of LMFP cathode material, such as low cost, high safety and long cycle life.

The voltage curves of blended LMFP cathode are based on the simulation of the voltage of single phase LMFP and just for illustration purposes. Real voltage profile is expected to be more slope-like. It is contemplated that blending triple, quadruple or even more LMFP phases will further smooth the voltage profile and benefit the battery control.

LMFP batteries are particularly useful in heavy-duty applications due to their excellent thermal stability, long cycle life, and high energy density. These characteristics make them well-suited for demanding environments such as commercial vehicles, industrial machinery, and grid-scale energy storage systems. LMFP batteries can handle high discharge rates and maintain performance under heavy loads, ensuring reliable power delivery for extended periods. Additionally, their inherent safety features, such as resistance to thermal runaway, provide an extra layer of protection in rugged and high-stress operational conditions, making them a dependable choice for heavy-duty use cases.

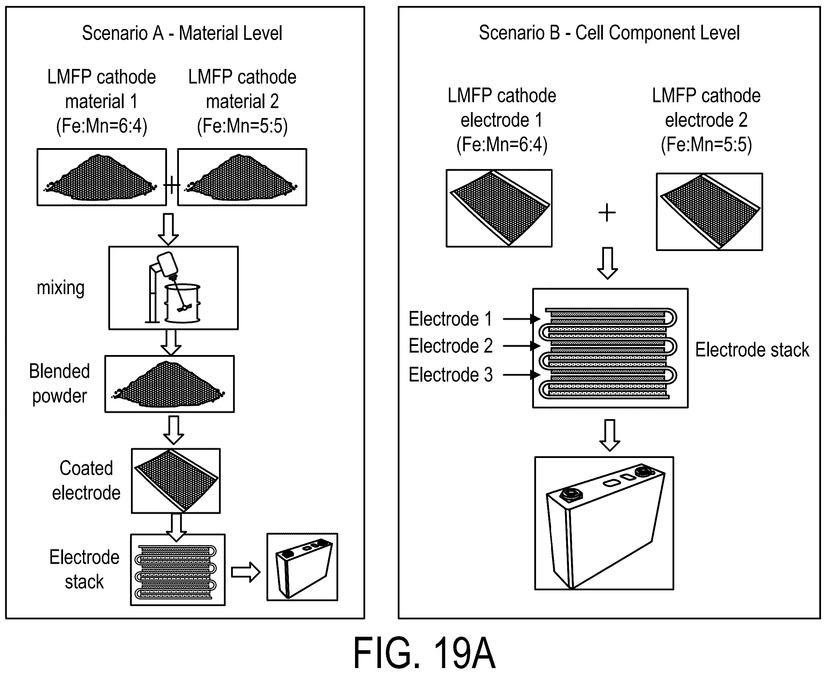

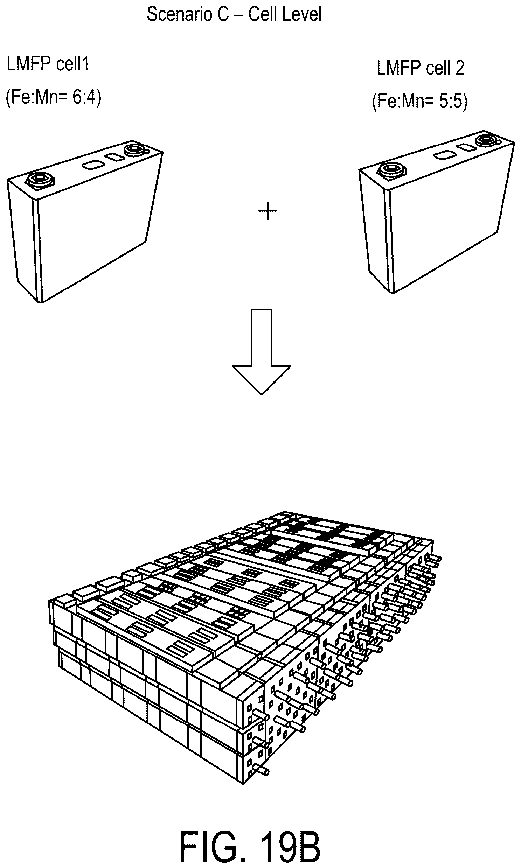

FIGS. 2A and 3B show various scenarios under which principles of the present disclosure may be carried out. In particular, Figure 19A shows Scenarios A and B, which correspond to a material level and cell component level respectively. Figure 19B shows Scenario C, which corresponds to a cell level. Each of these Scenarios is discussed in more detail hereinafter. Note that although these figures illustrate first and second cathode materials having Fe-Mn ratios of 6:4 and 5:5 respectively, it is contemplated that these Scenarios can be employed using any of the Fe-Mn ratios discussed elsewhere herein.

### Scenario A -Material Level

The process of forming a material for a battery involves several useful steps, each contributing to the overall performance, durability, and safety of the final battery cell. The illustrated materials are as follows: LMFP cathode material 1 (Fe:Mn= 6:4) and LMFP cathode material 2 (Fe:Mn= 5:5). For example, the cathode material 6:4 and 7:3 can be used and verified in a lab. The steps include mixing the materials to form a blended material, coating an electrode with the blended material, forming an electrode stack with the electrode, and integrating the electrode stack into a battery cell.

The initial step involves mixing the active materials, such as cathode or anode components, with conductive additives and binders to create a uniform blended powder. This step ensures homogeneity in the distribution of materials, which is essential for consistent electrochemical performance. High-precision equipment, such as ball mills or high-shear mixers, is often employed to achieve the desired particle size and distribution. The blended powder is then subjected to performance assessments to verify its composition and verify it meets predefined specifications.

In the next step, the blended powder is processed into a slurry by adding a suitable solvent. The slurry is then applied to a current collector, typically aluminum for the cathode or copper for the anode, using techniques such as doctor blade coating or slot-die coating. The coated electrode is subsequently dried to remove the solvent and then calendared to achieve the desired thickness and density. This step is useful for ensuring good contact between the active materials and the current collector, which enhances electron transfer and overall efficiency.

The coated electrodes are then cut into specific shapes and layered to form an electrode stack. Depending on the design of the battery, this can involve stacking individual layers of anode, separator, and cathode in a specific sequence or winding them into a cylindrical or prismatic configuration. The separator plays a vital role in preventing short circuits by electrically isolating the anode and cathode while allowing ionic movement between them. Precision in alignment and stacking is useful to verify uniform electrochemical reactions during operation.

Finally, the electrode stack is enclosed within a cell casing, which can be cylindrical, prismatic, or pouch-shaped. Electrolyte is introduced into the cell to facilitate ionic conductivity, and the cell is sealed using techniques such as heat sealing, crimping, or laser welding. The formed cell undergoes an initial charging process, often referred to as formation cycling, to activate the electrochemical materials and stabilize the solid electrolyte interphase (SEI) layer. Once formed, the cell is subjected to comprehensive evaluation to ensure it meets performance, safety, and quality standards before integration into larger battery packs.

These steps collectively ensure the production of high-performance battery cells with the desired energy density, cycle life, and safety characteristics.

### Scenario B - Cell Component Level

The process of mixing at the cell component level for battery manufacturing focuses on precise assembly techniques that ensure optimal performance and safety of the final product. Key steps include forming an electrode stack and constructing the complete battery cell. The illustrated materials and components are as follows: LMFP cathode material 1 (Fe:Mn= 6:4) and LMFP cathode material 2 (Fe:Mn= 5:5) where the cell component is an electrode. For example, verification tests can be performed with 6:4 and 7:3. The steps include forming an electrode stack with two or more cathode electrode and integrating the electrode stack into a battery cell.

The method of constructing a battery cell begins with the selection and preparation of two distinct cathode electrodes, each featuring a different chemistry to optimize performance across various operating conditions. These cathode electrodes are engineered to complement each other, leveraging the advantages of multiple active materials to enhance energy density, cycle life, and overall stability.

Each cathode electrode is fabricated using an independent composition of active materials, chosen to support different electrochemical characteristics. The first cathode electrode may comprise a high-energy-density material such as lithium nickel manganese cobalt oxide (NMC) to provide strong voltage stability and prolonged discharge capacity. The second cathode electrode can be composed of lithium manganese iron phosphate (LMFP), known for its superior thermal stability and long cycle life.

The cathode electrodes are coated onto aluminum current collectors, ensuring uniform material distribution. The electrodes are then calendared to achieve precise thickness and density for optimal ion transport and structural integrity.

The prepared cathode electrodes are incorporated into an electrode stack alongside corresponding anode electrodes, which are typically composed of graphite, silicon-carbon composites, or other high-capacity materials. A separator is placed between each cathode and anode layer to prevent electrical short circuits while allowing for efficient ionic movement during charge and discharge cycles.

The electrode stack is assembled in a repeating sequence to ensure consistent electrochemical interactions. The stacking process can be achieved through automated precision layering techniques, ensuring accurate alignment of all components. The structured electrode stack is then subjected to compression to enhance contact between layers, improving conductivity and mechanical stability.

Once the electrode stack is formed, it is integrated into a battery housing designed for optimal safety and performance. The housing can be cylindrical, prismatic, or pouch-style, depending on the intended application. Electrolyte is then introduced into the cell, carefully chosen to support both cathode chemistries and facilitate stable ion transport.

The cell is sealed using heat or laser welding techniques to prevent contamination and ensure long-term reliability. A formation process is then applied, which includes controlled charge and discharge cycles to activate the electrochemical reactions, stabilize the solid electrolyte interphase (SEI) layer, and ensure the proper interaction between the dual-chemistry cathodes.

Finally, the battery cell undergoes rigorous testing for capacity retention, thermal stability, and cycling efficiency before being prepared for integration into battery modules and packs for commercial applications. This method allows for a balanced approach to energy storage, leveraging the strengths of multiple cathode chemistries to create a high-performance lithium-ion battery cell.

### Scenario C - Cell Level

The process of mixing at the cell level involves assembling individual battery cells into a cohesive battery pack that meets specific energy and power requirements. This stage focuses on integrating the cells while ensuring optimal performance, safety, and compatibility with the intended application. The illustrated materials are as follows: LMFP cathode material 1 (Fe:Mn= 6:4) and LMFP cathode material 2 (Fe:Mn= 5:5). The steps include integrating both a battery cell with a first cathode material and a battery cell with a second cathode material into a battery pack.

Forming a Battery Pack from the Cells: Battery pack formation begins by arranging the individual cells in a specific configuration, such as series, parallel, or a combination of both, depending on the desired voltage and capacity requirements. Cells are connected using conductive interconnects, such as busbars or welded tabs, to create an electrical pathway that enables efficient energy transfer across the pack. The arrangement is carefully designed to minimize resistance and ensure balanced performance among all cells.

To maintain mechanical stability and thermal management, the cells are housed within a robust enclosure. The enclosure is often constructed from materials such as aluminum or high-strength polymers to provide durability while minimizing weight. Thermal management systems, such as liquid cooling plates or heat sinks, are integrated into the pack to regulate temperatures during operation and prevent overheating.

The BMS is installed as a component of the battery pack. The BMS monitors the SOC, SOH, and temperature of each cell to ensure balanced operation and prevent overcharging or deep discharging. Advanced algorithms within the BMS enable dynamic adjustments to optimize the performance and lifespan of the battery pack.

The final step involves sealing the battery pack to protect it from external environmental factors, such as moisture, dust, and mechanical shocks. The assembled pack undergoes a series of rigorous tests, including electrical performance assessments, thermal evaluations, and safety verifications, to ensure it meets all quality and regulatory standards. Once approved, the battery pack is ready for integration into electric vehicles, energy storage systems, or other applications, delivering reliable and efficient power for a wide range of uses.

By following these steps, manufacturers can produce battery packs that are highly efficient, durable, and tailored to meet the demands of modern energy applications.

While these steps have been discussed in the context of LMFP batteries, similar approaches can be applied to other battery chemistries. For instance, lithium nickel manganese cobalt oxide (NMC) or lithium iron phosphate (LFP) batteries can benefit from the same principles of precise cell arrangement, robust thermal management, and advanced battery management systems. Regardless of the chemistry, the foundational processes of ensuring uniformity in cell performance, protecting the pack from environmental stressors, and integrating effective monitoring and control systems remain universal.

These methodologies not only enhance the performance and safety of the battery pack but also offer flexibility in adapting to the unique properties and challenges of different chemistries. By leveraging these shared techniques, manufacturers can develop customized solutions that meet the specific requirements of various applications, from electric vehicles to renewable energy storage.

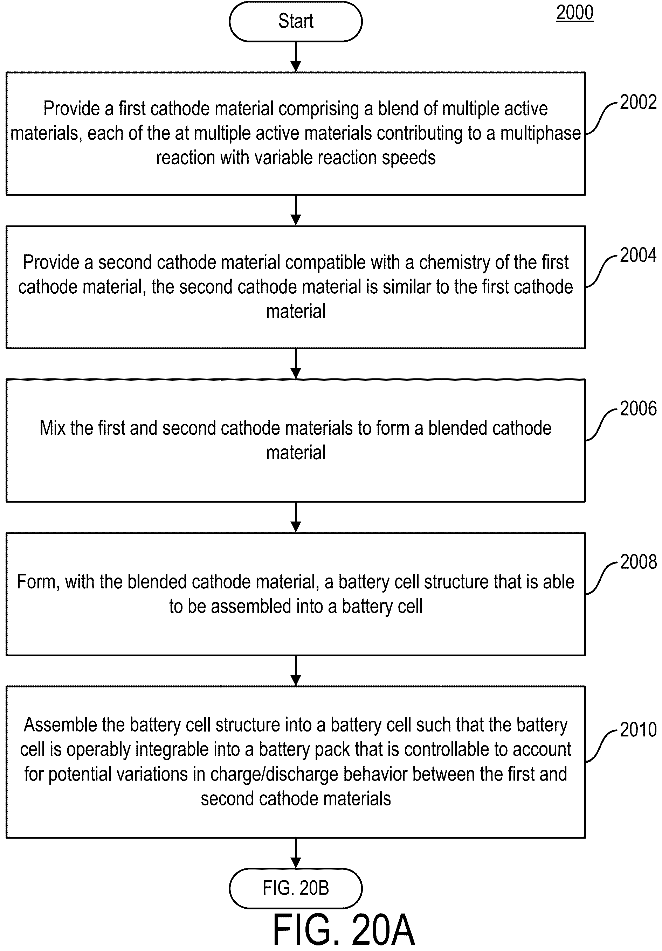

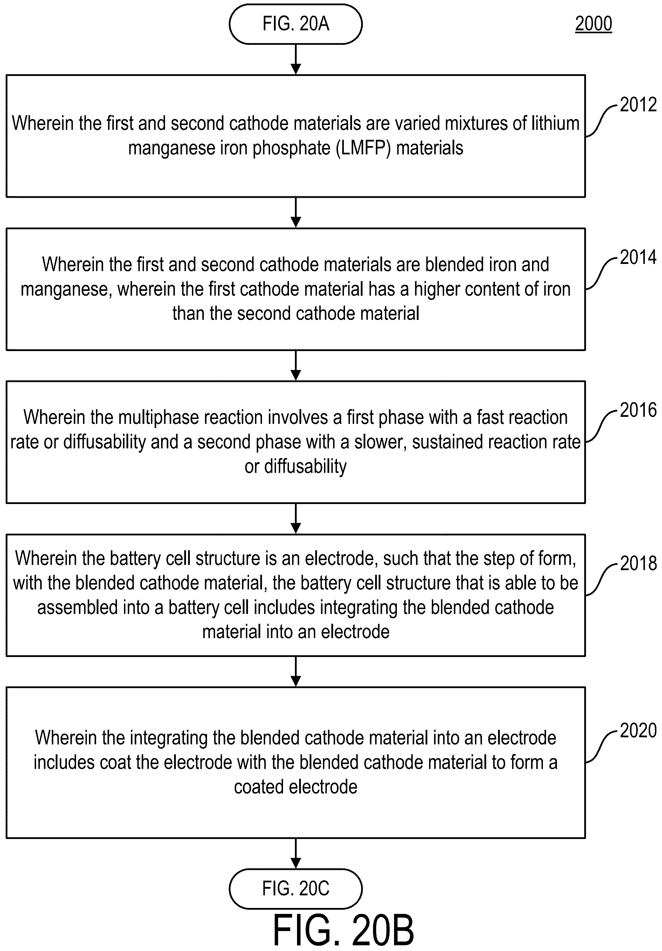

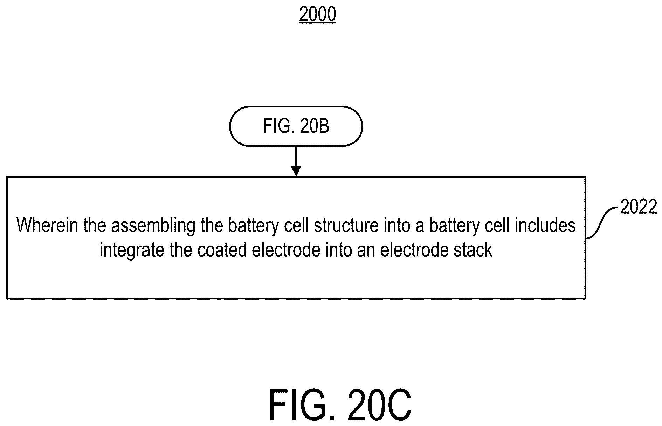

Figures 20A through 20C show a flowchart of an example process 2000. These figures includes a first section of the flowchart shown in Figure 20A, a second section of the flowchart shown in Figure 20B, and a third section of the flowchart in Figure 20C. In some implementations, one or more process blocks of Figure 20 may be performed by a battery cell.

As shown in Figures 20A through 20C, process 2000 may include providing a first cathode material having a blend of multiple active materials, each of the at multiple active materials contributing to a multiphase reaction with variable reaction speeds (block 2002). For example, battery cell may provide a first cathode material having a blend of multiple active materials, each of the at multiple active materials contributing to a multiphase reaction with variable reaction speeds, as described above. Process 2000 may include providing a second cathode material compatible with a chemistry of the first cathode material, the second cathode material is similar to the first cathode material (block 2004). For example, battery cell may provide a second cathode material compatible with a chemistry of the first cathode material, the second cathode material is similar to the first cathode material, as described above.

As further shown in Figures 20A through 20C, process 2000 may include mixing the first and second cathode materials to form a blended cathode material (block 2006). For example, battery cell may mix the first and second cathode materials to form a blended cathode material, as described above. Next, the process 2000 may include forming, with the blended cathode material, a battery cell structure that is able to be assembled into a battery cell (block 2008). For example, battery cell may form, with the blended cathode material, a battery cell structure that is able to be assembled into a battery cell, as described above.

Following block 2008, at block 2010, process 2000 may include assembling the battery cell structure into a battery cell such that the battery cell is operably integrable into a battery pack that is controllable to account for potential variations in charge/discharge behavior between the first and second cathode materials (block 2010). For example, battery cell may assemble the battery cell structure into a battery cell such that the battery cell is operably integrable into a battery pack that is controllable to account for potential variations in charge/discharge behavior between the first and second cathode materials, as described above.

Process 2000 may include additional implementations (FIGS. 20B-C), such as any single implementation or any combination of implementations described below and/or in connection with one or more other processes described elsewhere herein. In a first implementation, the first and second cathode materials are varied mixtures of lithium manganese iron phosphate (LMFP) materials (block 2012).

In a second implementation, alone or in combination with the first implementation, the first and second cathode materials are blended iron and manganese (block 2014), where the first cathode material has a higher content of iron than the second cathode material.

In a third implementation, alone or in combination with the first and second implementation, the multiphase reaction involves a first phase with a fast reaction rate or diffusability and a second phase with a slower, sustained reaction rate or diffusability (block 2016).

In a fourth implementation, alone or in combination with one or more of the first through third implementations, the battery cell structure is an electrode, such that the step of forming, with the blended cathode material, the battery cell structure that is able to be assembled into a battery cell includes integrating the blended cathode material into an electrode (block 2018).

In a fifth implementation, alone or in combination with one or more of the first through fourth implementations, the integrating the blended cathode material into an electrode includes coating the electrode with the blended cathode material to form a coated electrode (block 2020).

In a sixth implementation, alone or in combination with one or more of the first through fifth implementations, the assembling the battery cell structure into a battery cell includes integrating the coated electrode into an electrode stack (block 2022).

Although Figures 20A through 20C show example blocks of process 2000, in some implementations, process 2000 may include additional blocks, fewer blocks, different blocks, or differently arranged blocks than those depicted in Figures 20A through 20C. Additionally, or alternatively, two or more of the blocks of process 2000 may be performed in parallel.

In practice, this disclosure is applicable to EV manufacturers seeking cost-effective, safe, and sustainable battery solutions. The LMFP battery system supports increased adoption of EVs by addressing current limitations of LIB technologies. Thus, the present disclosure provides an advanced LMFP battery system that balances energy density, safety, and cost for EV applications. By overcoming existing challenges, it paves the way for broader adoption and enhanced performance in sustainable transportation. The following are several practical examples drawing upon some of the many principles discussed in this disclosure.

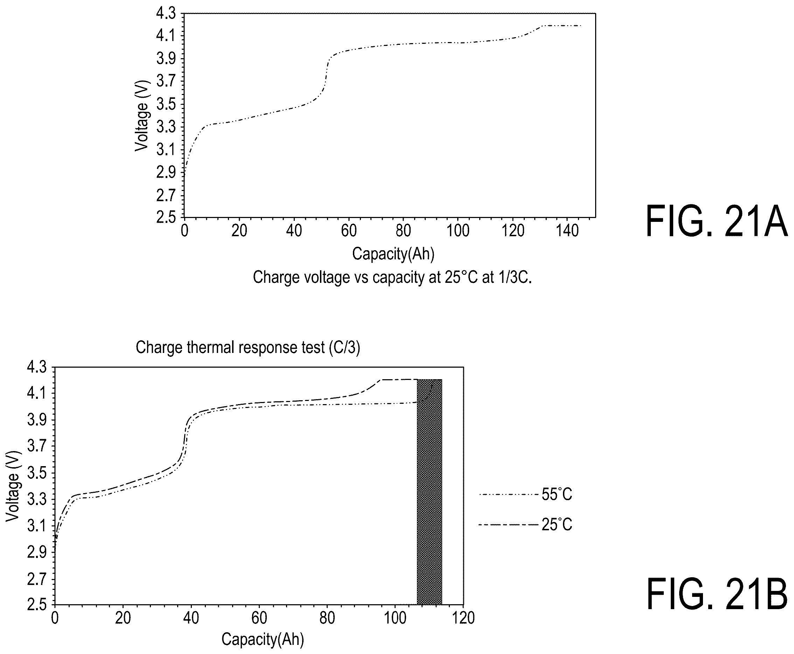

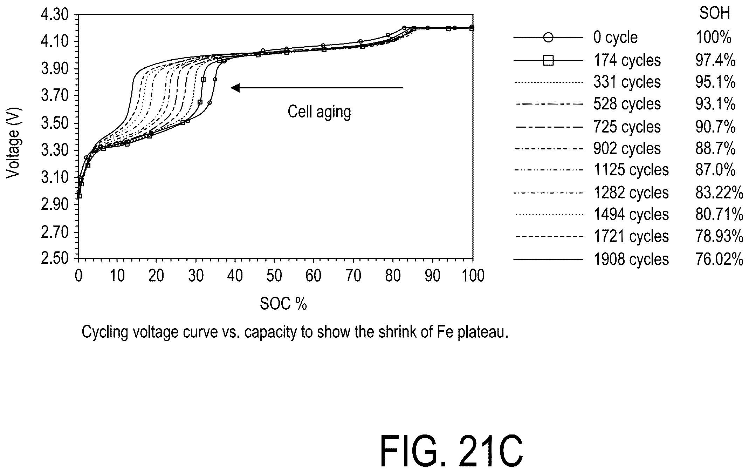

Figures 21A-C are graphs showing several discharge curves for an aged LMFP battery. Such batteries can include batteries cell for different chemistries, including Mn-Fe ratios. The results in Figures 21A-C relate to soothing voltage during transition area by mixing the cathode materials with different Mn:Fe ratio. All lithium-ion batteries experience capacity degradation over prolonged cycling. This decline is primarily attributed to the loss of lithium-ion inventory, which accounts for approximately 95% of the capacity decay in LMFP cells. In the LMFP chemistry, two distinct voltage plateaus are observed: 3.9 V and 3.3 V, corresponding to the lithium reactions with manganese (Mn) and iron (Fe), respectively. However, due to intrinsic differences between Mn and Fe, the reactivity of lithium with these elements varies significantly. Specifically, the diffusivity of lithium ions in the Mn phase is 2-3 orders of magnitude slower than in the Fe phase.

In examples, as is the case with Figures 21A-C, principles of the present disclosure relate to smoothing a stair-like voltage in LMFP technology with a blended cathode material. More particularly, the present disclosure relates to smooth steep voltage transitions of LMFP batteries through blending different LMFP cathode materials with various ratios. Voltage transitions in LMFP batteries are a defining characteristic that enhances their operational stability and efficiency. During charge and discharge cycles, the lithium ions transition between the anode and cathode through a series of voltage plateaus, which are governed by the redox reactions of manganese and iron within the cathode material. These transitions occur at distinct voltage levels due to the multi-electron processes involved, offering a stable energy delivery profile. The presence of manganese increases the operational voltage range, while iron ensures cost-effectiveness and structural durability. This balance allows LMFP batteries to achieve higher energy densities without compromising cycle life. Additionally, the stable voltage transitions reduce the stress on the electrolyte, minimizing degradation and extending the battery's lifespan. In examples, the cathode materials can be blended cathode materials formed from first and second similar cathode materials.

However, the stair-step nature of the voltage profile presents a significant challenge in practical applications. This distinct voltage behavior complicates the precise monitoring of the SOC and the accurate control of power output. For battery engineers, a smoother, slope-like voltage curve is highly desirable, as it facilitates more efficient BMS development, enabling improved operational control and reliability.

To address this issue, the concept of blending LMFP with Nickel Manganese Cobalt (NMC) has been proposed to smooth out the sharp voltage transitions. Despite these efforts, the characteristic stair-like voltage profile remains evident. Moreover, incorporating NMC into the blend introduces additional trade-offs, including reduced safety performance, a shorter cycle life, and increased production costs. These challenges highlight the need for further innovation and optimization to fully harness the potential of LMFP batteries while mitigating these limitations.

However, the stair-step nature of the voltage profile presents a significant challenge in practical applications. This distinct voltage behavior complicates the precise monitoring of the SOC and the accurate control of power output. For battery engineers, a smoother, slope-like voltage curve is highly desirable, as it facilitates more efficient BMS development, enabling improved operational control and reliability.

This disparity in lithium-ion mobility leads to two noteworthy challenges during the operation of LMFP batteries. At room or low temperatures, a substantial portion of lithium ions becomes inaccessible at the high-voltage plateau, as the sluggish diffusivity in the Mn phase restricts their mobility. These immobilized lithium ions are often regarded as either a lithium reservoir or inactive, contributing to the effective loss of active lithium.

Conversely, the Fe phase, characterized by its rapid lithium-ion diffusivity and high reactivity, experiences a more accelerated degradation. As a result, the voltage plateau associated with the Fe phase undergoes a pronounced decline over time, further compounding the capacity fade observed in LMFP batteries.

According to principles of the present disclosure, the lithium reservoir at high voltage Mn phase is accessible through one-time high temperature, low C rate charging. It follows that when discharging the battery at normal operation temperature, the activated Lithium ions from the lithium reservoir will compensate the lithium inventory loss at the Fe phase because Lithium ions have much higher diffusivity at Fe phase than that at Mn phase. In this way, extra energy from aged LMFP batteries can be gained to extend its operation life. Extra capacity can be gained through high temperature charge from Mn phase, then compensate the fast Li loss at Fe phase during cycling.

Validation of these principles can be carried out using the following multistep process:
1. Use an aged LMFP cell (with 90% state of charge (SOH))
2. Run 3 cycle at 25°C to measure the initial capacity: charge (atC/3 to 4.2V till C/20)/discharge at C/3 till 2.5V.
3. Charge the battery at 45°C with C/10 to 4.2V, CV cut off at C/20
4. Discharge with C/3 to 2.5V at 25 °C. Battery capacity is completed.
5. Resume the normal operation.

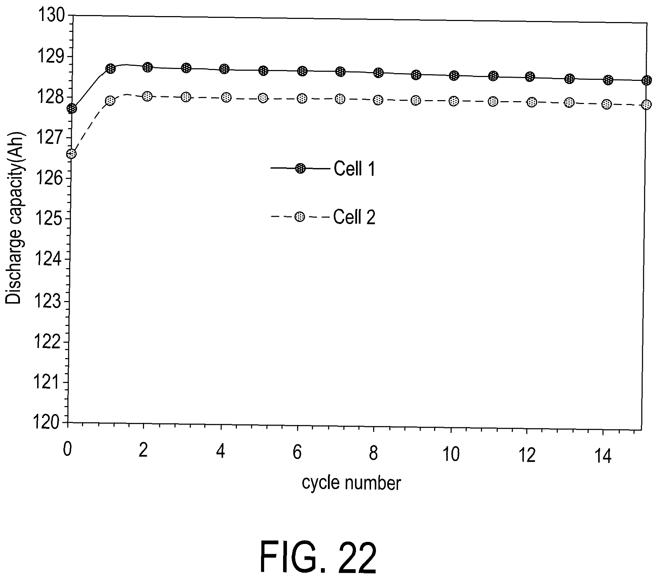

Figure 22 shows a diagram of discharge capacity relative to cycle number with a heat treatment, which corresponds to Tables 1 and 2 (below) with cycling results with 1CCV/1C:

**TABLE 1: First set of results for effects of thermal treatment on the cell capacity recovery**

| Discharge-Cell 1 | Discharge capacity (Ah) | SOH% |
|---|---|---|
| Before heat treatment | 127.4 | 87.76 |
| After heat treatment | 128.8 | 88.72 |
| Δ | 1.4 | 1.0 % |

**TABLE 2: Second set of results for effects of thermal treatment on the cell capacity recovery**

| Discharge-Cell 2 | Discharge capacity (Ah) | SOH% |
|---|---|---|
| Before heat treatment | 126.6 | 87.57 |
| After heat treatment | 128.0 | 88.54 |
| Δ | 1.4 | 1.0% |

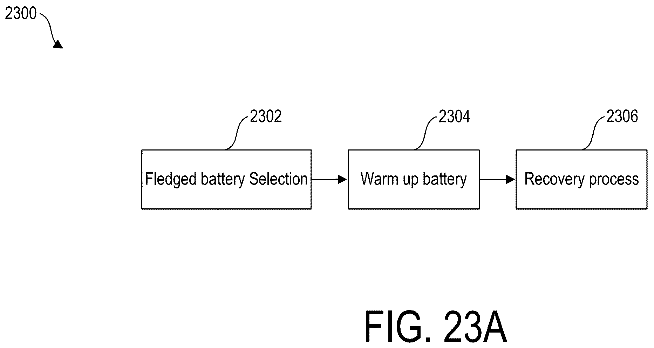

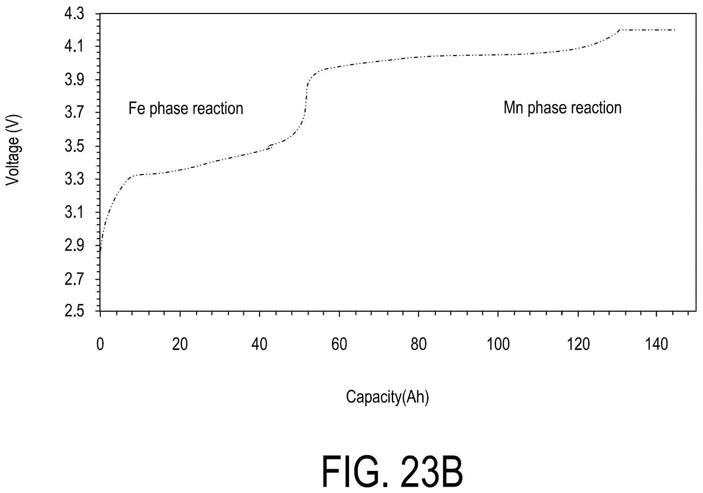

Figure 23A is a flow chart showing a Li-ion recovery process for aged batteries according to principles of the present disclosure. To begin, an aged battery is selected 2302. Then the aged battery is warmed up 2304. Next, a recovery process is performed at high temperature 2306. Notably, this process can include a one-time slow charge (e.g., at C/20 or similar) and a one-time normal rate discharge (e.g., at C/3 or similar). The results of process 2300 are shown in Figure 23B in a graph that shows the battery voltage as a function of capacity (Ah). The warm-up procedures can be defined in different scenarios: where the aged battery is warmed for an entirety of the charging process or where the battery is only warmed at Mn phase charging.

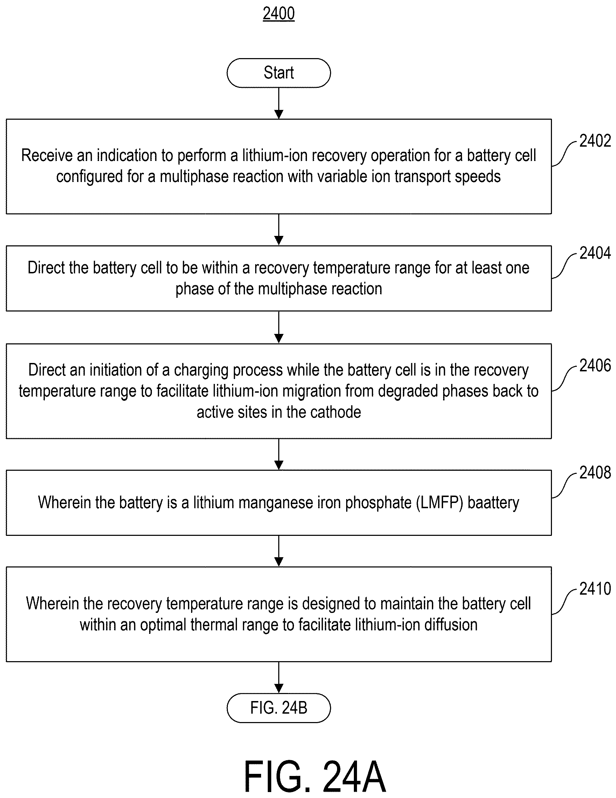

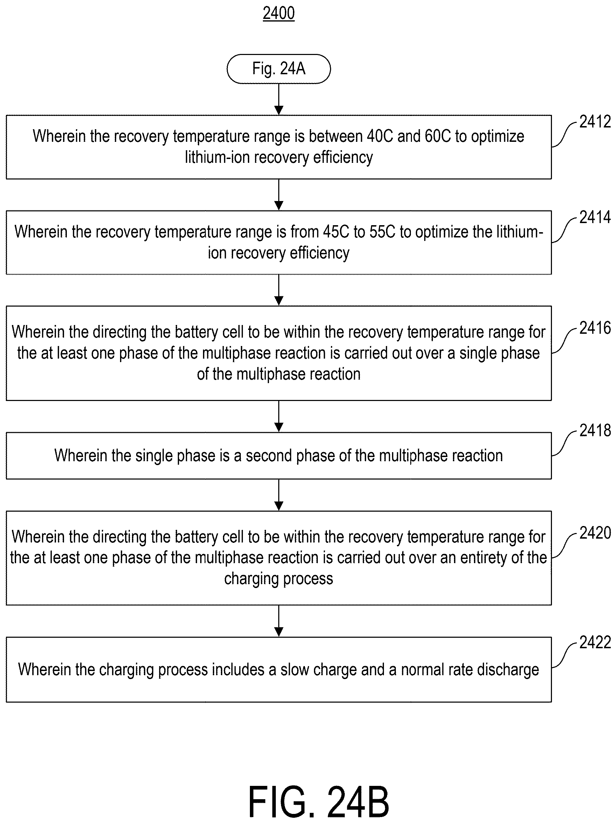

Figures 24A and 24B illustrate a flowchart of an example process 2400. These figures includes a first section of the flowchart shown in Figure 24A and the second section of the flowchart shown in Figure 24B. In some implementations, one or more process blocks of Figures 24A and 24B illustrate may be performed by a battery management system.

As shown in Figures 24A and 24B illustrate, process 2400 may include receiving an indication to perform a lithium-ion recovery operation for a battery cell having blended cathode materials configured for a multiphase reaction with variable ion transport speeds, the blended cathode materials are formed from first and second similar cathode materials (block 2402). For example, battery management system may receive an indication to perform a lithium-ion recovery operation for a battery cell having blended cathode materials configured for a multiphase reaction with variable ion transport speeds, the blended cathode materials are formed from first and second similar cathode materials, as described above. As also shown in Figures 24A and 24B illustrate, process 2400 may include directing the battery cell to be within a recovery temperature range for at least one phase of the multiphase reaction (block 2404). For example, battery management system may direct the battery cell to be within a recovery temperature range for at least one phase of the multiphase reaction, as described above. As further shown in Figures 24A and 24B illustrate, process 2400 may include directing an initiation of a charging process while the battery cell is in the recovery temperature range to facilitate lithium-ion migration from degraded phases back to active sites in the cathode (block 2406). For example, battery management system may direct an initiation of a charging process while the battery cell is in the recovery temperature range to facilitate lithium-ion migration from degraded phases back to active sites in the cathode, as described above.

Process 2400 may include additional implementations, such as any single implementation or any combination of implementations described below and/or in connection with one or more other processes described elsewhere herein. In a first implementation, the battery is a lithium manganese iron phosphate (LMFP) battery (block 2408).

In a second implementation, alone or in combination with the first implementation, therecovery temperature range is designed to maintain the battery cell within an optimal thermal range to facilitate lithium-ion diffusion (block 2410).

In a third implementation, alone or in combination with the first and second implementation, the recovery temperature range is between 40 degrees Celsius and 60 degrees Celsius to optimize lithium-ion recovery efficiency (block 2412). In examples, the capacity recovery method may be applicable in cases where the temperature during the heat treatment step is higher than that in the cycle life testing.

In a fourth implementation, alone or in combination with one or more of the first through third implementations, the recovery temperature range is from 45 degrees Celsius to 55 degrees Celsius to optimize the lithium-ion recovery efficiency (block 2414).

In a fifth implementation, alone or in combination with one or more of the first through fourth implementations, the directing the battery cell to be within the recovery temperature range for the at least one phase of the multiphase reaction is carried out over a single phase of the multiphase reaction (2416).

In a sixth implementation, alone or in combination with one or more of the first through fifth implementations, the single phase is a second phase of the multiphase reaction (block 2418).

In a seventh implementation, alone or in combination with one or more of the first through sixth implementations, the directing the battery cell to be within the recovery temperature range for the at least one phase of the multiphase reaction is carried out over an entirety of the charging process (block 2420).

In an eighth implementation, alone or in combination with one or more of the first through seventh implementations, the charging process includes a slow charge and a normal rate discharge (block 2422).

Although Figures 24A and 24B illustrate shows example blocks of process 400, in some implementations, process 2400 may include additional blocks, fewer blocks, different blocks, or differently arranged blocks than those depicted in Figures 24A and 24B illustrate. Additionally, or alternatively, two or more of the blocks of process 2400 may be performed in parallel.

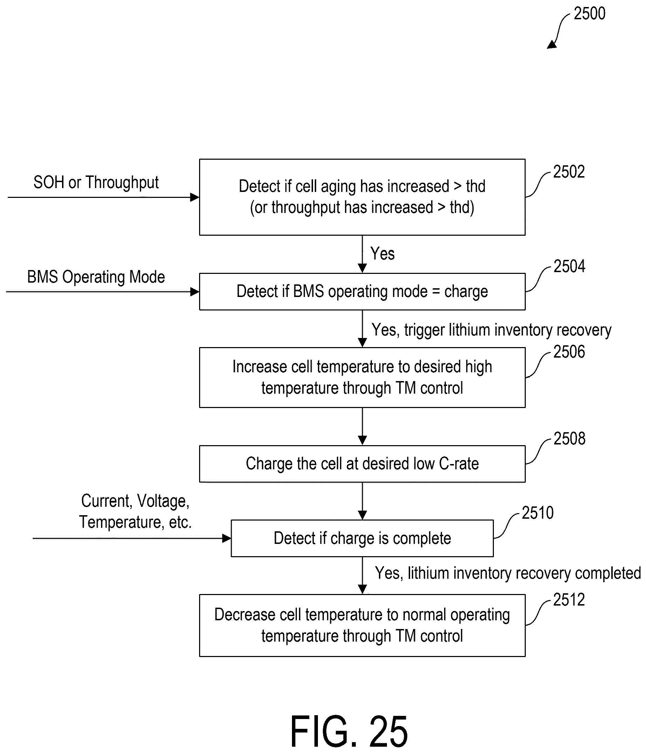

Figure 25 is a flowchart of a method for effective battery recovery 2500. Effective battery recovery requires careful regulation of key parameters to optimize lithium-ion redistribution, minimize degradation, and restore battery performance. The recovery process involves a sequence of controlled steps designed to enhance lithium mobility, reduce internal resistance, and improve overall energy retention. Method 2500 starts with collecting SOH or throughput information and detecting if cell aging has increased above a predetermined threshold or if throughput has increased above a predetermined threshold, in block 2502. If the threshold has been exceeded, method 2500 proceeds to step 2504 where it detects if BMS operating mode is equal to the charge. If the BMS operating mode is equal to the charge, in block 2506, the cell temperature is increased to a desired high temperature through TM control. At block 2508, the charge of the cell is set at a desired low C-rate. Method 2500 then detects if the charge is complete based on information from sensors, such as current, voltage, and temperature, at block 2510. Finally, if the charge is complete, method 2500 concludes with a decrease in cell temperature to normal operating temperature through TM control at block 2512.

Aged lithium-ion batteries should be warmed to a temperature of at least 35°C before initiating the recovery process. This controlled heating reduces electrolyte viscosity, enhances ion mobility, and accelerates lithium-ion diffusion within the electrode materials. At lower temperatures, lithium transport within the anode and cathode becomes sluggish, increasing the risk of incomplete lithium reintegration and further capacity loss. By maintaining the battery within an optimal thermal range, recovery efficiency can be significantly improved.

During the recovery phase, a lower current charging rate, typically at or below C/10, should be applied. This gentle charging strategy reduces stress on aged electrode materials, preventing excessive lithium plating on the anode surface. High charging currents in degraded batteries can lead to lithium metal deposition, increasing impedance and reducing cycle life. By maintaining a reduced current, the lithium ions are given sufficient time to redistribute evenly across active sites, improving the cell's overall stability and recoverable capacity.

Once the battery has undergone controlled low-current charging, it should be fully charged to ensure maximum lithium-ion reintegration into the cathode structure. Achieving a full state of charge allows the electrode materials to reach equilibrium, stabilizing their electrochemical properties. This step is essential to reestablish the proper balance of active lithium ions within the cell, thereby extending battery lifespan and restoring lost capacity.

By implementing these parameters-temperature regulation, low-current charging, and complete charge cycles-battery recovery operations can be optimized to improve energy retention, enhance cycle stability, and prolong the usable life of lithium-ion cells.

The flowchart outlines a structured process for lithium inventory recovery within a battery management system (BMS). The process begins by monitoring the state of health (SOH) or throughput of the battery. If cell aging has increased beyond a predefined threshold ("thd") or if throughput surpasses a set limit, the system proceeds with the recovery process. Otherwise, no further action is taken. Once triggered, the system checks whether the BMS operating mode is set to "charge." If charging mode is detected, lithium inventory recovery is initiated.

To optimize lithium-ion mobility, the system increases the battery cell temperature to a predefined high level using thermal management (TM) control. Following this, the battery undergoes a controlled charging process at a low C-rate to facilitate lithium-ion reintegration while minimizing stress on electrode materials. Throughout the charging process, the system continuously monitors whether the charge cycle has been fully completed. If charging is incomplete, the process continues; however, if the charge is complete, lithium inventory recovery is considered successful. Finally, the system restores the battery cell to its normal operating temperature using thermal management control, ensuring that it returns to stable conditions for regular operation. This method enables efficient lithium inventory recovery while optimizing temperature and charge rate to extend battery life.

### Electrified Vehicle Overview

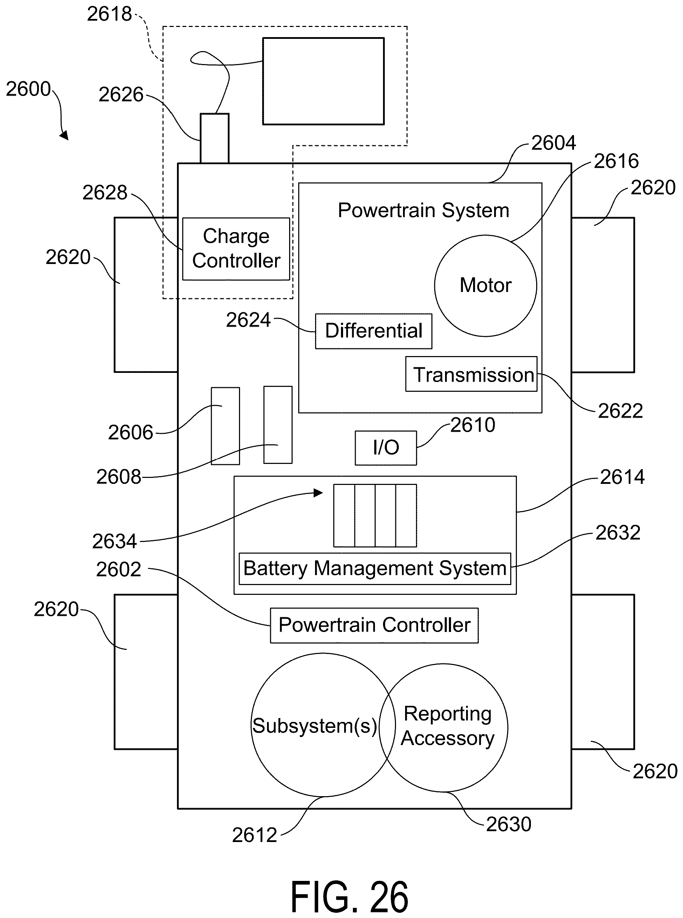

Referring initially to Figure 26, a schematic diagram of a battery electric vehicle 2600 is provided. While the vehicle is referred to as a battery electric vehicle, it is understood that the vehicle may alternatively be a hybrid vehicle, such as a plug-in hybrid vehicle, powered or otherwise operable via a battery and, optionally, one or more of a generator (e.g., power generator, generator plant, electric power strip, on-board rechargeable electricity storage system, etc.) and a motor (e.g., electric motor, traction motor, etc.). Battery electric vehicle 2600 may be operable in at least one of a reverse direction (e.g., backward relative to the front end of the vehicle) and a non-reverse direction (e.g., forward or angular direction relative to the front end). Battery electric vehicle 2600 may be an on-road or off-road vehicle, including but not limited to cars, trucks, ships, boats, vans, airplanes, spacecraft, or any other type of vehicle.

Battery electric vehicle 2600 comprises a powertrain controller 2602 communicably and operatively coupled to a powertrain system 2604, a brake mechanism 2606, an accelerator pedal 2608, one or more sensors (not shown), an operator input/output (I/O) device 2610, and one or more additional vehicle subsystems 2612. Battery electric vehicle 2600 may include additional, fewer, or different system components than those depicted in Figure 26, such that the principles, methods, and apparatuses of the present disclosure are applicable to any suitable vehicle configuration. It should also be understood that the disclosed principles are not limited to on-highway vehicles; rather, they may be applied to other applications including, but not limited to, off-highway construction equipment, mining equipment, marine equipment, and locomotive equipment.

Powertrain system 2604 facilitates power transfer from a battery 2614 and/or a motor 2616 to propel vehicle 2600. In one embodiment, powertrain system 2604 includes motor 2616 operably coupled to battery 2614 and charge system 2618, where motor 2616 transfers power to a final drive (e.g., wheels 2620) to propel the vehicle 2600. As shown, powertrain system 2604 may further include a transmission 2622 and/or differential 2624, where differential 2624 transfers power output from transmission 2622 to final drive 2620. Powertrain controller 2602 supplies electrical power to motor 2616 in response to inputs from accelerator 2608, sensors, subsystems 2612, and charge system 2618 (e.g., a battery charging system or rechargeable battery). In some embodiments, electricity supplied to power motor 2616 may alternatively or additionally be provided by an on-board gasoline-engine generator or a hydrogen fuel cell.

In certain embodiments, vehicle 2600 includes transmission 2622, which may be configured as any transmission type compatible with an electrified powertrain, including a continuously variable transmission, manual transmission, automatic transmission, automated-manual transmission, or dual-clutch transmission. Transmission 2622 may provide multiple gear ratios or continuously variable settings that determine output speed based on engine or motor speed. Motor 2616, differential 2624, and final drive 2620 may likewise take any configuration suitable for the vehicle type. In some examples, transmission 2622 is omitted and motor 2616 is directly coupled to differential 2624; in others, motor 2616 directly couples to final drive 2620 in a direct-drive configuration. Vehicle 2600 may also include multiple instances of motor 2616-for example, one per driven wheel, one per driven axle, or other suitable arrangements.

Brake mechanism 2606 may be implemented as any system or device configured to prevent or reduce motion by slowing or stopping a component of vehicle 2600 (e.g., a wheel, axle, crankshaft, or driveshaft). Brake mechanism 2606 is generally configured to receive an indication of a desired change in vehicle speed. In some embodiments, brake mechanism 2606 comprises a brake pedal operable between a released state and an applied state by an operator of vehicle 2600. The brake pedal may operate as a pressure-based system responsive to applied pressure or as a travel-based system responsive to a pedal travel distance, where the force applied to brake mechanism 2606 is proportional to that pressure or distance. In certain embodiments, all or a portion of brake mechanism 2606 is incorporated into motor 2616 as a regenerative braking mechanism.

The released state of brake mechanism 2606 corresponds to a brake pedal in a default position where braking is not applied-for example, when the operator's foot is not on the pedal or resting lightly below a minimum actuation force. In some embodiments, the brake pedal is combined with accelerator pedal 2608 in a one-pedal driving configuration. The applied state corresponds to the pedal being pressed with a force or travel distance that meets or exceeds a minimum threshold to achieve braking. These thresholds prevent unintended actuation and may vary depending on implementation, such as higher force for a foot-actuated brake pedal and lower force for a hand-actuated lever.

A reduction in actuation force or travel distance may correspond to a desired increase in vehicle speed, while an increase corresponds to a reduction in vehicle speed.

Accelerator pedal 2608 may be any torque- or speed-request device, such as a floor-based pedal, lever, or joystick. Sensors associated with accelerator 2608 and/or brake mechanism 2606 may include a vehicle-speed sensor, accelerator-position sensor (e.g., potentiometer), brake-position or pressure sensor, coolant-temperature sensor, pressure sensor, ambient-air-temperature sensor, or other suitable sensors.

Vehicle 2600 may include an operator I/O device 2610 that enables communication between the operator and powertrain controller 2602. For example, device 2610 may include an interactive display (e.g., touchscreen) with buttons, haptic feedback, and controls for acceleration, braking, shifting, cruise control, or navigation. Via device 2610, powertrain controller 2602 may transmit instructions, commands, or status information to the operator.

Vehicle 2600 further includes one or more vehicle subsystems 2612, which may include sensors (e.g., speed, pressure, or temperature sensors) and additional systems such as torque sensors for motor 2616, transmission 2622, differential 2624, and/or final drive 2620. Other subsystems 2612 may include a steering subsystem, electrical subsystem, and a thermal management system comprising radiators, pumps, fans, heat exchangers, and controllers. Additional sensors may include cameras, LIDAR, RADAR, temperature sensors, smoke detectors, or virtual sensors.

Powertrain controller 2602 is communicably coupled to powertrain system 2604, brake mechanism 2606, accelerator 2608, I/O device 2610, and subsystems 2612 via wired or wireless connections (e.g., CAN bus, fiber optics, Wi-Fi, Bluetooth, or cellular). Controller 2602 receives and processes data and may interface with an additional or alternative controller as needed.

In embodiments including charge system 2618, such as a plug-in charging system, powertrain controller 2602 manages charging of battery 2614 when a charger 2626 is connected to vehicle 2600. A charge controller 2628 establishes communication between controller 2602 and charger 2626, receiving charge commands, monitoring sensor signals, and performing safety and performance checks. Charge controller 2628 may detect faults such as connection failures or unsafe boundaries and functions as a communication interface between charger 2626 and controller 2602.

Powertrain controller 2602 may also communicate with charger 2626, battery 2614, and a reporting accessory 2630 (e.g., subsystem 2612 or another component) via a CAN bus or other communication scheme. Reporting accessory 2630 may communicate identification information, current demand, voltage draw, and other operational parameters. Dynamic loads (e.g., an air-conditioning system) can report variable current demand to optimize charge commands and avoid under-delivery of current that extends charging time.

Battery 2614 includes one or more battery packs, each having a battery management system 2632 and one or more battery modules 2634. Sensors monitor temperature, voltage, and current to allow system 2632 to manage charging, detect faults, and report conditions such as power limits and temperatures to controller 2602. The current sensor may reside within or outside battery 2614 and may include multiple sensors whose readings are summed to yield total current.

Powertrain controller 2602 may include charge logic operable to determine a command for charger 2628 to supply target current to battery 2614. This logic may reside within controller 2602, within battery-management controller 2632, or in a standalone controller. The term "logic," as used herein, encompasses hardware, firmware, or software executing on one or more processors or integrated circuits. A non-transitory machine-readable medium may store such logic and instructions.

A transport-control system and charging-management system may coordinate multiple chargers in a depot or fleet environment, managing vehicle arrival times, charging schedules, and grid load distribution to optimize cost and availability.

Although Figure 26 is described in connection with a battery electric vehicle, the disclosed architecture may also apply to plug-in hybrid vehicles or other electrified powertrains incorporating an internal-combustion engine, transmission, and differential in combination with battery propulsion.

For purposes of this disclosure, the term "electrified vehicle" is used in an inclusive sense to refer to any vehicle employing an electrical energy storage and propulsion system, whether in full or partial form. Thus, although battery electric vehicle 100 is described in connection with the embodiment of Figure 26, it should be understood that the same general systems and control principles are equally applicable to hybrid electric vehicles, plug-in hybrid electric vehicles, fuel-cell vehicles, or other architectures that integrate electrical propulsion or energy storage with mechanical power sources. The term also encompasses configurations in which electrical components are used for auxiliary or regenerative functions in vehicles that are otherwise mechanically driven. Accordingly, references to a "battery electric vehicle" in the following description should not be construed as limiting; rather, they are exemplary of a class of electrified vehicles to which the disclosed control systems, charging architectures, and subsystem integrations may be applied. One skilled in the art will appreciate that comparable functionality may be achieved in non-electrified or partially electrified systems where similar subsystems-such as powertrain controllers, charge controllers, or reporting accessories-are present.

In practice, this disclosure is applicable to EV manufacturers seeking cost-effective, safe, and sustainable battery solutions. The LMFP battery system supports increased adoption of EVs by addressing current limitations of LIB technologies. Thus, the present disclosure provides an advanced LMFP battery system that balances energy density, safety, and cost for EV applications. By overcoming existing challenges, it paves the way for broader adoption and enhanced performance in sustainable transportation. The following are several practical examples drawing upon some of the many principles discussed in this disclosure.

### PRACTICAL EXAMPLES

The systems and methods described in this disclosure may be implemented in a variety of configurations using commercially available sensors, well-understood battery management system (BMS) architectures, and structural integration techniques that would be apparent to a person having ordinary skill in the art. The following examples illustrate practical arrangements for deploying the claimed estimation approaches, either individually or in combination, consistent with the first, second, and third aspects of the disclosure.

### Example 1: Single-Cell Estimation Using Electrical Measurements (First Aspect)

In a typical LMFP battery module, each individual cell is equipped with voltage taps, current monitoring via a pack-level shunt or per-cell current sensors, and a temperature sensor placed on the cell casing. The BMS collects these signals continuously during operation. Using a state estimator implemented in the BMS microcontroller or dedicated estimation IC, the system performs coulomb counting to integrate current over time, cross-validates this with measured voltage against a known OCV curve (where applicable), and adjusts for temperature effects to determine the cell's SOC. Over repeated cycles, capacity fade is tracked by comparing expected charge throughput with actual delivered capacity, enabling an updated SOH estimate.

### Example 2: Transition Region Shift SOH Estimation (Second Aspect)

In another practical implementation, the BMS identifies a voltage transition region on the LMFP charge curve where the voltage transitions between the iron and manganese redox plateaus. A fixed transition voltage is selected based on initial cell characterization (e.g., 3.70 V). During each controlled charge cycle, the system records the SOC when the cell voltage crosses this fixed transition value. A pre-stored correlation, typically an inverse linear relationship, is applied to convert this SOC at the transition point to an updated SOH estimate. This method provides a fast, physically grounded SOH diagnostic without needing to analyze the entire charge curve.

### Example 3: Swelling Force-Based SOC/SOH Estimation (Third Aspect)

In a further arrangement, a pressure sensor or force sensor is integrated within the cell stack. For example, a thin film piezoresistive sheet can be placed between each cell and its neighbor or between cell groups in a module. Alternatively, a flexible mesh structure can be inserted between modules, across the entire module face, or covering only select regions to concentrate measurement where expansion is greatest. As each cell charges and discharges, the sensor detects the mechanical force caused by electrode swelling and contraction. The BMS uses this force signal to refine SOC estimation in the manganese plateau region where voltage signals provide low resolution. Over time, the trend in peak force, baseline force, and rate of force change is analyzed to infer mechanical and structural degradation, providing an updated SOH estimate.

### Example 4: Combined Multi-Signal Estimation (Aspects One, Two, and Three)

A more robust implementation combines all three aspects for maximum diagnostic reliability. Each cell's SOC is determined using coulomb counting, voltage matching, and swelling force measurement with adaptive signal weighting based on the operating region. When the voltage signal is flat (manganese plateau), the system automatically gives higher priority to the swelling force input. Simultaneously, the BMS monitors the SOC at the fixed transition voltage during each cycle and updates the SOH using the empirical correlation, cross-checking this with the force-based SOH trend and the electrical model's prediction. If inconsistencies appear between methods, the system triggers recalibration or diagnostic routines, improving pack safety and extending useful life.

### Example 5: Mesh-Based Distributed Sensing

For large-format modules or packs containing multiple LMFP cells, a compliant mesh sensor may be positioned between every cell or between groups of cells. In one variant, a single mesh spans the entire face of a module and transfers force to a few strategically placed force sensors mounted at the module corners. In another variant, smaller localized mesh pads cover only critical regions of each cell face, detecting regional expansion patterns that can be compared to detect hot spots or localized gas generation. These arrangements allow the system to measure expansion along multiple surfaces and in multiple directions, as described in the broad method claims (including dimensional changes across coordinate axes and surfaces). The BMS aggregates these measurements for both SOC and SOH estimation in line with the claimed method for detecting and correlating dimensional changes to battery state parameters.

### Example 6: Integration into Pack Compression Structures

Alternatively, for prismatic or pouch cell packs that use mechanical compression to maintain cell alignment, conventional load cells can be installed beneath the pack's end plates. This arrangement leverages the existing pack structure: as cells swell due to intercalation, the compression force changes slightly, which is detected by the load cell. This measurement can be used directly by the BMS as a swelling force signal for SOC estimation in the plateau region and to monitor long-term cell swelling trends as an indicator of aging, consistent with the third aspect.

### Example 7: Anticipatory and Predictive Dimension Monitoring

For advanced systems, the swelling force or dimension change data can be logged over time and correlated with cell surface coordinates to build a predictive model of future swelling behavior. This supports proactive state estimation by anticipating how the swelling force trend will evolve as the cell ages, in accordance with the claims specifying past, present, and anticipated dimension changes across multiple surfaces and dimensions.

### CONCLUSION

The present disclosure describes a comprehensive system and methodology for accurately estimating the state of charge and state of health of LMFP battery cells and packs, addressing the specific challenges posed by the flat voltage profile of this chemistry and the limitations of conventional estimation techniques. Through the first aspect, the system uses established electrical signals - voltage, current, and temperature - combined with proven estimation models to provide reliable cell-level SOC and SOH monitoring.

The second aspect adds a physically grounded enhancement by using the measurable shift in the voltage transition region between the manganese and iron plateaus as an indicator of aging. By fixing a transition voltage and determining the corresponding SOC during charging, the system produces an empirical SOH estimate that supplements model-based outputs.

The third aspect introduces a complementary signal by monitoring swelling force as a direct reflection of electrode expansion during lithium intercalation and deintercalation. This parameter improves SOC resolution in the manganese plateau region, where voltage alone provides limited sensitivity, and offers a robust trend for detecting capacity loss and structural changes over time.

The fourth aspect further strengthens this estimation framework by introducing a diagnostic method that estimates SOC based on multi-pulse direct current internal resistance (DCIR) measurements. By applying controlled current pulses of varying magnitudes and durations and analyzing the corresponding voltage responses, the system extracts impedance signatures that offer enhanced SOC resolution-particularly in the manganese plateau region where voltage-based methods are unreliable. This approach requires minimal hardware overhead and can be implemented using existing BMS sensing infrastructure, making it both practical and scalable. When combined with the first three aspects, the DCIR-based method adds a valuable electrochemical dimension to the estimation strategy, enabling multi-signal cross-validation and improving the robustness, accuracy, and adaptability of SOC and SOH tracking across the full operating range and lifetime of LMFP battery systems.

These aspects may be deployed independently or in combination to suit various system architectures, cost targets, and performance goals. They are compatible with a wide range of conventional sensing approaches, including voltage taps, current sensors, temperature sensors, force sensors, thin-film pressure sheets, mesh-based force distribution layers, strain gauges, and pack-level compression plates. Practical examples include per-cell integration, shared mesh layers for groups of cells or modules, localized force detection zones, and combined force and transition region monitoring for maximum diagnostic coverage.

By combining electrical, electrochemical, and mechanical signals in a unified estimation framework, the disclosed system provides more accurate, reliable, and interpretable SOC and SOH data. This supports improved energy management, safer operation, longer service life, and enhanced predictive maintenance for LMFP-based batteries used in electric vehicles, stationary storage systems, and other high-demand applications.

The features described herein may be implemented in various ways and combined with other techniques known to those skilled in the art. Modifications, equivalents, and variations may be made without departing from the scope defined by the appended claims.

### INCORPORATION BY REFERENCE FOR SECOND-USE APPLICATION

Further information regarding systems, methods, and criteria for evaluating, selecting, repurposing, and integrating second-use lithium-ion battery cells and packs may be found in U.S. Patent No. 11,881,735B2, titled "Integration of Second-Use of Li-ion Batteries in Power Generation" and assigned to Cummins Inc. The teachings of this patent complement the present disclosure by providing example techniques and operational considerations for determining the suitability of LMFP cells and modules-particularly those characterized using the SOC and SOH estimation techniques described herein-for second-life applications, including stationary storage and grid support. To the extent any inconsistencies exist between the incorporated patent and the present disclosure, the present disclosure shall control.

### GUIDANCE

The following section provides interpretive guidance for understanding and applying the principles described in this disclosure. It outlines key concepts related to embodiment flexibility, parameter variation, structural adaptability, and claim interpretation for lithium manganese iron phosphate (LMFP) battery systems and methods. While this section sets forth representative principles by which one skilled in the art may interpret the scope and implementation of the disclosed systems, it is not exhaustive and should not be construed as limiting. Instead, it serves to ensure clear, adaptable, and contextually accurate understanding of the embodiments described herein, including their potential equivalents and extensions under applicable patent law.

The description provided is intended to accompany and clarify the figures and flow diagrams included in this disclosure, with the goal of instructing one skilled in the art in representative implementations of LMFP battery devices, materials, estimation methods, and control strategies. Where terms such as "is," "are," or similar definitive language are used to describe elements in the figures, such usage should not be interpreted as limiting or exclusive. Instead, such terms reflect how features may be implemented or depicted in example embodiments. As will be apparent to those skilled in the art, the described configurations are illustrative only and do not preclude alternative structures, materials, or arrangements that accomplish comparable functions. The figures and description are thus to be understood as nonlimiting examples among many possible implementations consistent with the broader principles disclosed herein.

Although the systems, methods, and materials described herein are tailored primarily for LMFP battery cells and battery packs intended for electric vehicles and stationary storage, the disclosed principles and structures may also be applied to other lithium-based chemistries, energy storage formats, and power system configurations, including but not limited to blended cathode materials, hybrid battery modules, and advanced battery management systems (BMS). The structures and functionalities described are suitable for any application involving rechargeable lithium-based energy storage where precise state estimation and robust thermal, mechanical, and electrical management are required.

The embodiments and examples presented in the detailed description are intended to be illustrative and not exhaustive. Specific configurations are described for clarity, but they represent only a subset of possible implementations that may be developed based on the disclosure herein. Features of one embodiment may be combined with features of another, whether or not such combinations are explicitly described. Similarly, individual features may be omitted from certain implementations without departing from the scope of the claims. All such variations, substitutions, and adaptations apparent to a person of ordinary skill in the art are considered within the scope of this disclosure and its claims.

For clarity and to focus on key inventive aspects, certain supporting features commonly present in battery systems-such as recalibration procedures, asynchronous time steps, impedance analysis routines, additional physical signals to measure, or other safeguards -may be simplified or omitted in the figures and description. Their design and integration are well understood by skilled practitioners and do not need to be shown in exhaustive detail to convey the core principles of the present disclosure. Detailed specifications of such ancillary components may be provided in production engineering documentation as appropriate.

Ranges provided in this disclosure should be interpreted to include both their stated endpoints and any intermediate values, unless explicitly indicated otherwise. Unless otherwise stated, a range or single value should be understood to include values that one of ordinary skill in the art would deem generally equivalent or sufficiently close for the intended function, including values that vary by plus or minus a reasonable percentage appropriate for the technical field. Phrases such as "generally within a range," "approximately," "about," "substantially," "roughly," "sufficiently," or similar qualifiers, when used with ranges or values, are intended to allow for practical engineering and manufacturing tolerances, measurement uncertainty, and performance margins without limiting the claims to absolute numerical boundaries. Where a single value or limit is disclosed without an explicit range, it should be interpreted as encompassing that value and all functionally equivalent values within such reasonable variation, consistent with the doctrine of equivalents.

Use of modifiers such as "approximately," "generally," "substantially," "sufficiently," and similar terms is intended to capture acceptable variation that does not materially affect the intended operation or performance of the described system. These terms do not narrow the scope of the claims to exact figures unless expressly stated otherwise.

Use of "or" in lists should be understood as inclusive unless the context clearly indicates otherwise, meaning that any one, any combination, or all listed elements may be encompassed. Phrases such as "at least one of A, B, and C" should be interpreted to mean any of A, B, or C individually, any combination thereof, or all of them together. The term "a portion" may refer to part or all of a given element, unless clearly indicated otherwise.

Terms such as "coupled," "connected," or "joined" encompass both direct and indirect relationships between elements, including mechanical, electrical, thermal, or fluidic connections, whether fixed, flexible, integrated, or modular. For example, components described as "thermally coupled" or "electrically connected" include arrangements with or without intervening interfaces, conductive paths, or insulating structures.

Where steps in a method are presented in a specific order, that order should not be construed as required unless explicitly stated. Method steps may be performed in different sequences, in parallel, combined, or omitted, depending on the desired implementation. Descriptions of method operations are provided for illustrative guidance and do not limit procedural flexibility except where explicitly recited in the claims.

Systems and methods are described herein for estimating state parameters of lithium manganese iron phosphate (LMFP) battery cells with improved accuracy and robustness. Per-cell estimation of state of charge (SOC) and state of health (SOH) is performed using electrical measurements including voltage, current, and temperature. In example implementations, shifts in characteristic voltage transition regions associated with manganese- and iron-based redox reactions are monitored to infer degradation during normal operation. Mechanical swelling force of the battery cell is measured using one or more pressure sensors, providing a physical indicator correlated with SOC and long-term lithium inventory loss, particularly in voltage-flat operating regions. Direct current internal resistance values obtained from controlled current pulses may further enhance estimation accuracy. These complementary estimation techniques may be implemented individually or in combination within a battery management system to improve diagnostics, adaptive control, and lifecycle management of LMFP battery cells in electrified vehicle and energy storage applications.

The structures, materials, methods, and configurations described herein are intended to illustrate, not limit, the scope of the invention. All modifications, substitutions, equivalents, and functional alternatives that achieve the described objectives using different arrangements-whether now known or later developed-are intended to fall within the scope of the appended claims and are protected under applicable doctrines of patent law, including the doctrine of equivalents.

## Claims

1. A battery management apparatus for a lithium manganese iron phosphate (LMFP) battery, the battery management apparatus comprising:
a processor; and
a non-transitory memory storing instructions that, when executed by the processor, cause the processor to estimate at least one battery state parameter for a battery cell based on at least one of voltage data, current data, temperature data, a swelling force of the battery cell, a voltage shift at a transition region of the battery cell, or a direct current internal resistance value of the battery cell.

2. The battery management apparatus of claim 1, wherein the instructions cause the processor to estimate a state of charge of the battery cell based on the voltage data, the current data, and the temperature data.

3. The battery management apparatus of claim 2, wherein the instructions cause the processor to recalibrate the estimated state of charge using updated operating data for the battery cell.

4. The battery management apparatus of any of the preceding claims, wherein the instructions cause the processor to estimate a state of health of the battery cell by monitoring the voltage shift at the transition region of the battery cell.

5. The battery management apparatus of claim 4, wherein the instructions cause the processor to determine the voltage shift by fixing a predetermined voltage within the transition region and identifying a state of charge value at the predetermined voltage.

6. The battery management apparatus of claim 5, wherein the instructions cause the processor to estimate the state of health based on a predetermined relationship between the state of charge value at the predetermined voltage and the state of health.

7. The battery management apparatus of any of the preceding claims, wherein the instructions cause the processor to estimate at least one of a state of charge or a state of health of the battery cell using the swelling force measured by one or more pressure sensors.

8. The battery management apparatus of claim 7, wherein the one or more pressure sensors comprise a sensor sheet positioned in mechanical contact with the battery cell.

9. The battery management apparatus of claim 7 or 8, wherein the instructions cause the processor to estimate the state of charge based on the swelling force in a region of relatively constant open-circuit voltage.

10. The battery management apparatus of any of the preceding claims, wherein the instructions cause the processor to estimate a state of charge of the battery cell using the direct current internal resistance value.

11. A non-transitory computer-readable medium storing instructions that, when executed by a processor, cause the processor to estimate at least one battery state parameter for a lithium manganese iron phosphate (LMFP) battery cell by applying multiple current pulses having different magnitudes or durations to the battery cell and determining a direct current internal resistance value for the battery cell.

12. The non-transitory computer-readable medium of claim 11, wherein the instructions cause the processor to measure a terminal voltage response for each current pulse and to calculate the direct current internal resistance value based on the terminal voltage response and an applied current, and optionally wherein the instructions cause the processor to determine a state of charge by comparing the direct current internal resistance value to a calibration map relating direct current internal resistance to state of charge.

13. The non-transitory computer-readable medium of claim 11 or 12, wherein the instructions cause the processor to verify that the battery cell is in a diagnostic condition before applying the multiple current pulses, and/or wherein the instructions cause the processor to combine a state of charge estimate derived from the direct current internal resistance value with a state of charge estimate derived from at least one other estimation technique.

14. A battery pack comprising:
a plurality of lithium manganese iron phosphate (LMFP) battery cells arranged in a cell-to-pack configuration;
one or more pressure sensors positioned to detect swelling forces of the plurality of battery cells; and
a battery management apparatus configured to estimate at least one battery state parameter for each battery cell based on at least one of electrical data, swelling force data, voltage transition data, or internal resistance data.

15. The battery pack of claim 14, wherein:
the cell-to-pack configuration omits intermediate battery modules between the plurality of battery cells and an outer enclosure of the battery pack; and/or
the battery management apparatus is configured to estimate a state of charge for each battery cell and to determine a pack-level state of charge based on the estimated state of charge for each battery cell; and/or
the battery management apparatus is configured to estimate a state of health for each battery cell based on a voltage shift at a transition region of the respective battery cell; and/or
the battery management apparatus is configured to integrate swelling force data and electrical data to improve accuracy of battery state estimation during operation.
